# EUROPEAN PATENT APPLICATION

(11) **EP 4 297 108 A1**
(43) Date of publication of application: **27.12.2023**
(21) Application number: 23180170.5
(22) Date of filing: 19.06.2023
(51) Int. Cl.: H01L 33/62, H01L 25/075, G09G 3/00, G02F 1/13, H01L 25/16

(54) **DISPLAY DEVICE AND METHOD OF REPAIRING THE SAME**

(30) Priority: 23.06.2022 KR 20220077036
(71) Applicant: Samsung Display Co., Ltd., Yongin-si, Gyeonggi-do 17113 (KR)
(72) Inventor: PARK, Do Yeong, Yongin-si (KR); KIM, Kyung Bae, 17113 Yongin-si (KR); LEE, Won Jun, 17113 Yongin-si (KR); CHANG, Jong Woong, Yongin-si (KR)
(74) Representative: Taor, Simon Edward William

(57) **Abstract**

A display device including: a first sub-pixel, a second sub-pixel, and a third sub-pixel adjacent to each other, each of the first, second, and third sub-pixels including an emission area and a non-emission area, where each of the first, second, and third sub-pixels includes: a first alignment electrode and a second alignment electrode spaced from each other; a first insulating layer on the first alignment electrode and the second alignment electrode; light emitting elements on the first insulating layer on the first alignment electrode and the second alignment electrode in the emission area; a second insulating layer on the first insulating layer and the light emitting elements; and a third insulating layer on the second insulating layer, wherein the second and the third insulating layers are not on at least one area of the first alignment electrode in at least the non-emission area.

## Description

### CROSS-REFERENCE TO RELATED APPLICATION

This application claims priority to and the benefit of Korean patent application number 10-2022-0077036 filed with the Korean Intellectual Property Office (KIPO) on June 23, 2022.

### BACKGROUND

### 1. Field

Various embodiments of the present disclosure relate to a display device and a method of repairing the display device.

### 2. Description of Related Art

Recently, as interest in information display increases, research and development on display devices have been continuously conducted.

### SUMMARY

Various embodiments of the present disclosure are directed to a display device capable of preventing a bright spot defect so that the reliability of the display device may be improved, and a method of repairing the display device.

One or more embodiments of the present disclosure may provide a display device including a first sub-pixel, a second sub-pixel, and a third sub-pixel adjacent to each other, each of the first, second, and third sub-pixels including an emission area and a non-emission area. Each of the first, second, and third sub-pixels may include: a first alignment electrode and a second alignment electrode spaced from each other; a first insulating layer on the first alignment electrode and the second alignment electrode; light emitting elements on the first insulating layer on the first alignment electrode and the second alignment electrode in the emission area; a second insulating layer on the first insulating layer and the light emitting elements; and a third insulating layer on the second insulating layer. The second and the third insulating layers may not be on at least one area of the first alignment electrode in at least the non-emission area.

In one or more embodiments, the first insulating layer may include, in at least the non-emission area, a plurality of openings, each of the plurality of openings exposes one area of the first alignment electrode. The second insulating layer may include a through hole corresponding to each of the plurality of openings in at least the non-emission area. The third insulating layer may include a contact hole corresponding to the through hole in at least the non-emission area.

In one or more embodiments, the first alignment electrode may be configured to receive a voltage of a first power supply. The second alignment electrode may be configured to receive a voltage of a second power supply. The first power supply may be a high-potential driving power supply, and the second power supply may be a low-potential driving power supply.

In one or more embodiments, each of the first, second, and third sub-pixels may further include: a contact electrode on a substrate; an interlayer insulating layer on the contact electrode, and including a contactor to expose the contact electrode; a passivation layer on the interlayer insulating layer and partially open to correspond to the contactor; the first and the second alignment electrodes on the passivation layer; and electrodes on the second insulating layer and electrically connected to the light emitting elements. At least one of the electrodes may be electrically connected to the contact electrode through the contactor.

In one or more embodiments, the electrodes may include a first electrode, a second electrode, a third electrode, a fourth electrode, and a fifth electrode that are spaced from each other. The first electrode may be electrically connected to the contact electrode through the contactor, and the fifth electrode may be electrically connected to the second alignment electrode.

In one or more embodiments, each of the first, second, and third sub-pixels may include: a first sub-electrode at a layer identical to the second electrode and electrically connected to the second electrode; a second sub-electrode at a layer identical to the third electrode and electrically connected to the third electrode; a third sub-electrode at a layer identical to the fourth electrode and electrically connected to the fourth electrode; and a fourth sub-electrode at a layer identical to the fifth electrode and electrically connected to the fifth electrode. One of the first, second, third, and fourth sub-electrodes of the first sub-pixel may be electrically connected to one of the first, second, third, and fourth sub-electrodes of the second sub-pixel.

In one or more embodiments, the display device may further include a bridge line in the non-emission area, and electrically connected to the fifth electrode of each of the first, second, and third sub-pixels. The bridge line may be at a layer identical to the first, third, and fifth electrodes of each of the first, second, and third sub-pixels. The second and the fourth electrodes of each of the first, second, and third sub-pixels may be on the bridge line.

In one or more embodiments, a portion of the bridge line may be directly on one area of the first alignment electrode that is exposed through at least one opening from among the plurality of openings.

In one or more embodiments, a dummy pattern may be on a portion of the bridge line.

In one or more embodiments, the dummy pattern may be at a layer that is identical to the second and fourth electrodes of each of the first, second, and the third sub-pixels.

In one or more embodiments, the display device may include a bank in the non-emission area of each of the first, second, and third sub-pixels. The first, second, third, and fourth sub-electrodes may overlap the bank.

In one or more embodiments, the display device may further include an intermediate electrode electrically connecting the fourth sub-electrode of the first sub-pixel with the fourth sub-electrode of the second sub-pixel. The intermediate electrode may be integrally formed with the fourth sub-electrode of the first sub-pixel and the fourth sub-electrode of the second sub-pixel.

In one or more embodiments, each of the first, second, and third sub-pixels may further include: an interlayer insulating layer on the substrate; a contact electrode on the interlayer insulating layer; a passivation layer on the contact electrode, and including a contactor to expose the contact electrode; the first and the second alignment electrodes on the passivation layer; and electrodes on the second insulating layer and electrically connected to the light emitting elements. At least one of the electrodes may be electrically connected to the contact electrode through the contactor.

In one or more embodiments, the display device may further include: a first color conversion layer in the first sub-pixel, and a first color filter on the first color conversion layer; a second color conversion layer in the second sub-pixel, and a second color filter on the second color conversion layer; and a light scattering layer in the third sub-pixel and a third color filter on the light scattering layer.

One or more embodiments of the present disclosure may provide a display device including: a first sub-pixel, a second sub-pixel, and a third sub-pixel adjacent to each other, each of the first, second, and third sub-pixels including an emission area and a non-emission area; light emitting elements in the emission area of each of the first to the third sub-pixels; a first insulating layer under the light emitting elements; a bank on the first insulating layer in the non-emission area; a second insulating layer on the light emitting elements in at least the emission area, and including, in at least the non-emission area, through holes to expose one area of the bank; electrodes on the second insulating layer and electrically connected to the light emitting elements; sub-electrodes spaced from the electrodes; an intermediate electrode electrically connecting at least one of the sub-electrodes of the first sub-pixel with at least one of the sub-electrodes of the second sub-pixel; and a third insulating layer on the second insulating layer, and including, in at least the non-emission area, a first contact hole to expose one area of the intermediate electrode, and a second contact hole to expose at least one of the electrodes.

In one or more embodiments, the through holes of the second insulating layer includes a first through hole corresponding to the first contact hole, and a second through hole corresponding to the second contact hole. One area of the intermediate electrode may be exposed to an outside through the first contact hole and the first through hole, and at least one of the electrodes may be exposed to the outside through the second contact hole and the second through hole.

In one or more embodiments, the display device may further include: a first dummy pattern directly on the one area of the intermediate electrode that is exposed to the outside, and covering the one area of the intermediate electrode; and a second dummy pattern directly on the at least one of the electrodes that is exposed to the outside, and covering the at least one of the electrodes.

In one or more embodiments, the electrodes may include a first electrode, a second electrode, a third electrode, a fourth electrode, and a fifth electrode that are spaced from each other. The first electrode may include an anode electrode of each of the first, second, and third sub-pixels, and the fifth electrode may include a cathode electrode of each of the first, second, and third sub-pixels. The at least one electrode may include the fifth electrode.

In one or more embodiments, the second and fourth electrodes may be on the first, third, and fifth electrodes with the third insulating layer interposed between the second and fourth electrodes. The intermediate electrode may be at a layer identical to the first, third, and fifth electrodes. The first and second dummy patterns may be at a layer identical to the second and fourth electrodes.

One or more embodiments of the present disclosure may provide a method of repairing a display device. The display device may include a first sub-pixel, a second sub-pixel, and a third sub-pixel adjacent to each other, and each of the first to third sub-pixels including an emission area and a non-emission area. Each of the first, second, and third sub-pixels may include: a first alignment electrode and a second alignment electrode spaced from each other; a first insulating layer on the first and second alignment electrodes in at least the emission area, and including, in at least the non-emission area, a plurality of openings to expose one area of the first alignment electrode; light emitting elements on the first insulating layer on the first alignment electrode and the second alignment electrode in the emission area; a second insulating layer on the first insulating layer and the light emitting elements, and including a through hole corresponding to each of the openings in at least the non-emission area; and a third insulating layer on the second insulating layer, and including a contact hole corresponding to the through hole in the at least non-emission area. One area of the first alignment electrode may be exposed to an outside in at least the non-emission area. The method may include separating one area of the first alignment electrode that is exposed to the outside into parts.

According to an aspect, there is provided a display device as set out in claim 1. Additional features are set out in claims 2 to 11. According to an aspect, there is provided a display device as set out in claim 12. Additional features are set out in claims 13 and 14. According to an aspect, there is provided a method as set out in claim 15.

### BRIEF DESCRIPTION OF THE DRAWINGS

FIG. 1 is a schematic perspective view illustrating a light emitting element in accordance with one or more embodiments.
FIG. 2 is a schematic cross-sectional view illustrating the light emitting element of FIG. 1.
FIG. 3 is a schematic plan view illustrating a display device in accordance with one or more embodiments.
FIG. 4 is a schematic cross-sectional view illustrating a pixel of FIG. 3.
FIG. 5 is a schematic circuit diagram illustrating an electrical connection relationship of components included in each of the pixels illustrated in FIG. 3.
FIG. 6 is a schematic plan view illustrating a pixel circuit layer of a pixel in accordance with one or more embodiments.
FIG. 7 is a schematic cross-sectional view taken along the line I-I' of FIG. 6.
FIG. 8 is a schematic plan view illustrating a display element layer of a pixel in accordance with one or more embodiments.
FIG. 9 is a schematic plan view illustrating only some components included in a first sub-pixel of FIG. 8.
FIG. 10 is a schematic cross-sectional view taken along the line II-II' of FIG. 8.
FIG. 11 is a cross-sectional view illustrating first to third sub-pixels in accordance with one or more embodiments.
FIG. 12 is a schematic plan view illustrating a first pixel and a second pixel in accordance with one or more embodiments.
FIG. 13 is a schematic plan view illustrating only a bank and first and second alignment electrodes that are provided in common in the first and second pixels of FIG. 12.
FIGS. 14 and 15 are schematic cross-sectional views taken along the line III-III' of FIG. 12.
FIG. 16 is a schematic cross-sectional view taken along the line IV-IV' of FIG. 12.
FIG. 17 is a schematic plan view illustrating the forms of the first and second pixels of FIG. 12 after a repair operation has been performed.
FIG. 18 is a schematic plan view illustrating a first pixel and a second pixel in accordance with one or more embodiments.
FIG. 19 is a schematic cross-sectional view taken along the line V-V' of FIG. 18.
FIG. 20 is a schematic cross-sectional view taken along the line VI-VI' of FIG. 18.
FIG. 21 is a schematic plan view illustrating the forms of the first and second pixels of FIG. 18 after a repair operation has been performed.
FIG. 22 is a schematic plan view illustrating a pixel circuit layer of a pixel in accordance with one or more embodiments.
FIG. 23 is a schematic cross-sectional view taken along the line VII-VII' of FIG. 22.

### DETAILED DESCRIPTION

As the present disclosure allows for various changes and numerous embodiments, particular embodiments will be illustrated in the drawings and described in detail in the written description. However, this is not intended to limit the present disclosure to particular modes of practice, and it is to be appreciated that all changes, equivalents, and substitutes that do not depart from the technical scope of the present disclosure are encompassed in the present disclosure.

Throughout the present disclosure, like reference numerals refer to like parts throughout the various figures and embodiments of the present disclosure. The sizes of elements in the accompanying drawings may be exaggerated for clarity of illustration. It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure. Similarly, the second element could also be termed the first element.

It will be further understood that the terms "comprise", "include", "have", etc. when used in this specification, specify the presence of stated features, integers, steps, operations, elements, components, and/or combinations of them but do not preclude the presence or addition of one or more other features, integers, steps, operations, elements, components, and/or combinations thereof. Furthermore, in case that a first part such as a layer, a film, a region, or a plate is disposed on a second part, the first part may be not only directly on the second part but a third part may intervene between them. In addition, in case that it is expressed that a first part such as a layer, a film, a region, or a plate is formed on a second part, the surface of the second part on which the first part is formed is not limited to an upper surface of the second part but may include other surfaces such as a side surface or a lower surface of the second part. To the contrary, in case that a first part such as a layer, a film, a region, or a plate is under a second part, the first part may be not only directly under the second part but a third part may intervene between them.

It will be understood that when an element (e.g., a first element) is referred to as being (operatively or communicatively) "coupled with/to," or "connected with/to" another element (e.g., a second element), the first element may be coupled or connected with/to the second element directly or via another element (e.g., a third element). In contrast, it will be understood that when an element (e.g., a first element) is referred to as being "directly coupled with/to" or "directly connected with/to" another element (e.g., a second element), no other element (e.g., a third element) intervenes between the element and the other element.

Embodiments and required details of the present disclosure are described with reference to the accompanying drawings in order to describe the present disclosure in detail so that those having ordinary knowledge in the technical field to which the present disclosure pertains may easily practice the present disclosure. Furthermore, a singular form may include a plural form as long as it is not specifically mentioned in a sentence.

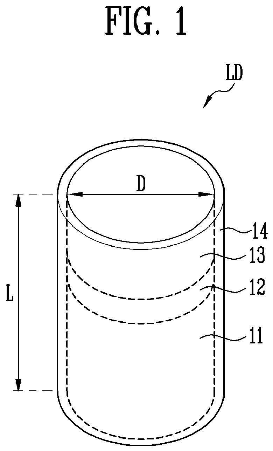

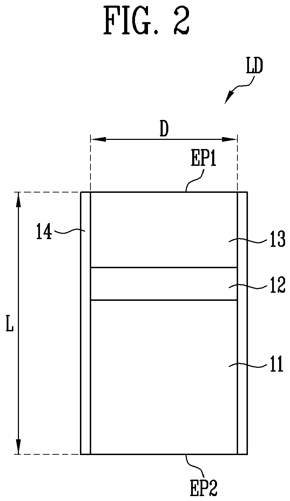

FIG. 1 is a schematic perspective view illustrating a light emitting element LD in accordance with one or more embodiments. FIG. 2 is a schematic cross-sectional view illustrating the light emitting element LD of FIG. 1.

Referring to FIGS. 1 and 2, the light emitting element LD may include a first semiconductor layer 11, a second semiconductor layer 13, and an active layer 12 interposed between the first and second semiconductor layers 11 and 13. For example, the light emitting element LD may be implemented as an emission stack (or referred to as "stack pattern") formed by successively stacking the first semiconductor layer 11, the active layer 12, and the second semiconductor layer 13. In one or more embodiments, the type and/or shape of the light emitting element LD is not limited to that of the embodiments illustrated in FIG. 1.

The light emitting element LD may be formed in a shape extending in one direction. If the direction in which the light emitting element LD extends is defined as a longitudinal direction, the light emitting element LD may have a first end EP1 and a second end EP2 that are opposite to each other in the longitudinal direction. One semiconductor layer of the first semiconductor layer 11 and the second semiconductor layer 13 may be disposed at the first end EP1 of the light emitting element LD, and the other semiconductor layer of the first semiconductor layer 11 and the second semiconductor layer 13 may be disposed at the second end EP2 of the light emitting element LD. For example, the second semiconductor layer 13 may be disposed at the first end EP1 of the light emitting element LD, and the first semiconductor layer 11 may be disposed at the second end EP2 of the light emitting element LD.

The light emitting element LD may be provided in various shapes. For example, as illustrated in FIG. 1, the light emitting element LD may have a rod-like shape, a bar-like shape, or a pillar-like shape that is long in the longitudinal direction (i.e., to have an aspect ratio greater than 1). Alternatively, the light emitting element LD may have a rod-like shape, a bar-like shape, or a pillar-like shape that is short in the longitudinal direction (or has an aspect ratio less than 1). As a further alternative, the light emitting element LD may have a rod-like shape, a bar-like shape, or a pillar-like shape having an aspect ratio of 1.

The light emitting element LD may include a light emitting diode (LED) fabricated to have a subminiature size, e.g., with a diameter D and/or a length L corresponding to a range from the nano scale (or the nanometer scale) to the micro scale (or the micrometer scale).

In case that the light emitting element LD is long (i.e., to have an aspect ratio greater than 1) in the longitudinal direction, the diameter D of the light emitting element LD may approximately range from 0.5 µm to 6 µm, and the length L thereof may approximately range from 1 µm to 10 µm. However, the diameter D and the length L of the light emitting element LD of embodiments are not limited thereto. The size of the light emitting element LD may be changed to meet requirements (or design conditions) of a lighting device or a self-emissive display device to which the light emitting element LD is applied.

The first semiconductor layer 11 may include, for example, at least one n-type semiconductor layer. For instance, the first semiconductor layer 11 may include an n-type semiconductor layer that includes any one semiconductor material of InAlGaN, GaN, AlGaN, InGaN, AIN, and InN and is doped with a first conductive dopant (or an n-type dopant) such as Si, Ge, or Sn. However, the constituent material of the first semiconductor layer 11 of embodiments is not limited to thereto, and various other materials may be used to form the first semiconductor layer 11.

The active layer 12 (or an emission layer) may be located on the first semiconductor layer 11, and may have a single or multiple quantum well structure. For example, in case that the active layer 12 has a multi-quantum well structure, the active layer 12 may be formed by periodically and repeatedly stacking a barrier layer, a strain reinforcing layer, and a well layer which are provided as one unit. The stain reinforcing layer may have a lattice constant that is less than that of the barrier layer so that strain, e.g., compressive strain, to be applied to the well layer may be further reinforced. However, the structure of the active layer 12 of embodiments is not limited to that of the foregoing embodiment.

The active layer 12 may emit light having a wavelength ranging from 400 nm to 900 nm, and have a double hetero structure. In one or more embodiments, a clad layer doped with a conductive dopant may be formed over and/or under the active layer 12 in the longitudinal direction of the light emitting element LD. For example, the clad layer may be formed of an AlGaN layer or an InAlGaN layer. In one or more embodiments, material such as AlGaN or InAlGaN may be used to form the active layer 12, and various other materials may be used to form the active layer 12. The active layer 12 may include a first surface that contacts the first semiconductor layer 11, and a second surface that contacts the second semiconductor layer 13.

If an electric field having a certain voltage or more is applied between the opposite ends of the light emitting element LD, the light emitting element LD may emit light by coupling of electron-hole pairs in the active layer 12. Because light emission of the light emitting element LD may be controlled based on the foregoing principle, the light emitting element LD may be used as a light source (a light emitting source) of various light emitting devices as well as a pixel of a display device.

The second semiconductor layer 13 may be located on the second surface of the active layer 12, and may include a semiconductor layer of a type that is different from that of the first semiconductor layer 11. For example, the second semiconductor layer 13 may include at least one p-type semiconductor layer. For instance, the second semiconductor layer 13 may include a p-type semiconductor layer that includes any one semiconductor material of InAlGaN, GaN, AlGaN, InGaN, AIN, and InN, and may be doped with a second conductive dopant (or a p-type dopant) such as Mg, Zn, Ca, Sr, or Ba. However, the material for forming the second semiconductor layer 13 of embodiments is not limited thereto, and various other materials may be used to form the second semiconductor layer 13.

In one or more embodiments, the first semiconductor layer 11 and the second semiconductor layer 13 may have different thicknesses in the longitudinal direction of the light emitting element LD. For example, the first semiconductor layer 11 may have a thickness that is greater than that of the second semiconductor layer 13 in the longitudinal direction of the light emitting element LD. Hence, the active layer 12 of the light emitting element LD may be located at a position closer to the upper surface of the second semiconductor layer 13 than to the lower surface of the first semiconductor layer 11.

Although FIGS. 1 and 2 illustrate that the first semiconductor layer 11 and the second semiconductor layer 13 each is formed of a single layer, embodiments of the present disclosure are not limited thereto. In one or more embodiments, depending on the material of the active layer 12, the first semiconductor layer 11 and the second semiconductor layer 13 each may further include one or more layers, for example, a clad layer and/or a tensile strain barrier reducing (TSBR) layer. The TSBR layer may be a strain relief layer which is located between semiconductor layers having different lattice structures and thus may function as a buffer layer to reduce a difference in lattice constant. Although the TSBR layer may be formed of a p-type semiconductor layer such as p-GaInP, p-AlInP, or p-AlGaInP, embodiments of the present disclosure are not limited thereto.

In one or more embodiments, the light emitting element LD may further include a connection electrode (hereinafter referred to as 'first connection electrode') located over the second semiconductor layer 13, as well as including the first semiconductor layer 11, the active layer 12, and the second semiconductor layer 13. Furthermore, in one or more embodiments, the light emitting element LD may further include another connection electrode (and hereinafter referred to as 'second connection electrode') located on the end of the first semiconductor layer 11.

Each of the first and second connection electrodes may be an ohmic contact electrode, but embodiments of the present disclosure are not limited thereto. In one or more embodiments, each of the first and second connection electrodes may be a Schottky contact electrode. The first and second connection electrodes may include conductive material. For example, the first and second connection electrodes may include opaque metal such as chrome (Cr), titanium (Ti), aluminum (Al), gold (Au), nickel (Ni), and oxides or alloys thereof, which are used alone or in combination, but embodiments of the present disclosure are not limited thereto. In one or more embodiments, the first and second connection electrodes may also include transparent conductive oxides such as indium tin oxide (ITO), indium zinc oxide (IZO), zinc oxide (ZnOx), indium gallium zinc oxide (IGZO), and indium tin zinc oxide (ITZO). Here, the zinc oxide (ZnOx) may be zinc oxide (ZnO) and/or zinc peroxide (ZnO2).

Materials included in the first and second connection electrodes may be identical to or different from each other. The first and second connection electrodes may be substantially transparent or translucent. Therefore, light generated from the light emitting element LD may pass through each of the first and second connection electrodes and then be emitted out of the light emitting element LD. In one or more embodiments, in the case where light generated from the light emitting element LD is emitted out of the light emitting element LD through an area other than the opposite ends of the light emitting element LD rather than passing through the first and second connection electrodes, the first and second connection electrodes may include opaque metal.

In one or more embodiments, the light emitting element LD may further include an insulating layer 14. However, in one or more embodiments, the insulating layer 14 may be omitted, or may be provided to cover only some of the first semiconductor layer 11, the active layer 12, and the second semiconductor layer 13.

The insulating layer 14 may prevent the active layer 12 from short-circuiting due to contacting conductive material other than the first and second semiconductor layers 11 and 13. Furthermore, the insulating layer 14 may reduce or minimize a surface defect of the light emitting element LD, thus enhancing the lifetime and emission efficiency of the light emitting element LD. In case that a plurality of light emitting elements LD are located in close contact with each other, the insulating layer 14 may reduce or prevent the likelihood of an undesired short-circuit from occurring between the light emitting elements LD. The presence or non-presence of the insulating layer 14 is not limited, so long as the active layer 12 may be prevented from short-circuiting with external conductive material.

The insulating layer 14 may be provided to be around (e.g., to enclose) an outer surface (e.g., an overall outer peripheral or circumferential surface) of the emission stack including the first semiconductor layer 11, the active layer 12, and the second semiconductor layer 13.

Although in the foregoing embodiment the insulating layer 14 has been described as enclosing the entirety of the respective outer surfaces (e.g., outer peripheral or circumferential surfaces) of the first semiconductor layer 11, the active layer 12, and the second semiconductor layer 13, embodiments of the present disclosure are not limited thereto. In one or more embodiments, in case that the light emitting element LD includes the first connection electrode, the insulating layer 14 may be around (e.g., may enclose) the entirety of the respective outer surfaces (e.g., outer peripheral or circumferential surfaces) of the first semiconductor layer 11, the active layer 12, the second semiconductor layer 13, and the first connection electrode. In one or more embodiments, the insulating layer 14 may not enclose the entirety of the outer surface (e.g., outer peripheral or circumferential surface) of the first connection electrode, or may be around (e.g., may enclose) only a portion of the outer surface (e.g., outer peripheral or circumferential surface) of the first connection electrode but not enclose the other portion of the outer surface (e.g., outer peripheral or circumferential surface) of the first connection electrode. Furthermore, in one or more embodiments, in case that the first connection electrode is disposed on the first end EP1 of the light emitting element LD and the second connection electrode is disposed on the second end EP2 of the light emitting element LD, the insulating layer 14 may allow at least one area of each of the first and second connection electrodes to be exposed.

The insulating layer 14 may include transparent insulating material. For example, the insulating layer 14 may be include one or more insulating materials selected from the group constituting of silicon oxide (SiOₓ), silicon nitride (SiNₓ), silicon oxynitride (SiOₓN_{y}), aluminum oxide (AlOₓ), titanium oxide (TiOₓ), hafnium oxide (HfOₓ), titanstrontium oxide (SrTiOₓ), cobalt oxide (CoₓO_{y}), magnesium oxide (MgO), zinc oxide (ZnOₓ), ruthenium Oxide (RuOₓ), nickel oxide (NiO), tungsten oxide (WOₓ), tantalum oxide (TaOₓ), gadolinium oxide (GdOₓ), zirconium oxide (ZrOₓ), gallium oxide (GaOₓ), vanadium oxide (VₓO_{y}), ZnO:Al, ZnO:B, InxOy:H, niobium oxide (NbₓO_{y}), magnesium fluoride (MgFₓ), aluminum fluoride (AlFₓ), an alucone polymer film, titanium nitride (TiN), tantalum nitride (TaN), aluminum nitride (AlNₓ), gallium nitride (GaN), tungsten nitride (WN), hafnium nitride (HfN), niobium nitride (NbN), gadolinium nitride (GdN), zirconium nitride (ZrN), and vanadium nitride (VN). However, embodiments of the present disclosure are not limited thereto, and various materials having insulation property may be used as the material of the insulating layer 14.

The insulating layer 14 may have a single-layer structure or a multi-layer structure including a double-layer structure. For example, in case that the insulating layer 14 is formed of a double-layer structure including a first layer and a second layer that are successively stacked, the first layer and the second layer may be made of different materials (or substances) and may be formed through different processes. In one or more embodiments, the first layer and the second layer may include the same material, and may be formed through a successive process.

In one or more embodiments, the light emitting element LD may be implemented as a light emitting pattern having a core-shell structure. In this case, the first semiconductor layer 11 may be located in a core of the light emitting element LD, i.e., a central portion of the light emitting element LD. The active layer 12 may be provided and/or formed to enclose the outer surface (e.g., outer peripheral or circumferential surface) of the first semiconductor layer 11. The second semiconductor layer 13 may be provided and/or formed to enclose the active layer 12. Furthermore, the light emitting element LD may further include a connection electrode formed to enclose at least one side of the second semiconductor layer 13. In one or more embodiments, the light emitting element LD may further include an insulating layer 14 that is provided on the outer surface (e.g., outer peripheral or circumferential surface) of the light emitting pattern having a core-shell structure, and that has transparent insulating material. The light emitting element LD implemented as the light emitting pattern having the core-shell structure may be manufactured in a growth manner.

The light emitting element LD may be employed as a light emitting source (or a light source) for various display devices. The light emitting element LD may be fabricated through a surface treatment process. For example, the light emitting element LD may be surface-treated so that, when a plurality of light emitting elements LD are mixed with a fluidic solution (or solvent) and then supplied to each pixel area (e.g., an emission area of each pixel or an emission area of each sub-pixel), the light emitting elements LD may be evenly distributed rather than unevenly aggregating in the solution.

An emission component (or a light emitting device or a light emitting unit) including the light emitting element LD described above may be used not only in a display device but also in various types of electronic devices each of which requires a light source. For instance, in case that a plurality of light emitting elements LD are located in the pixel area of each pixel of a display panel, the light emitting elements LD may be used as a light source of the pixel. However, the application field of the light emitting element LD is not limited to the above-mentioned examples. For example, the light emitting element LD may also be used in other types of electronic devices such as a lighting device, which requires or suitably uses a light source.

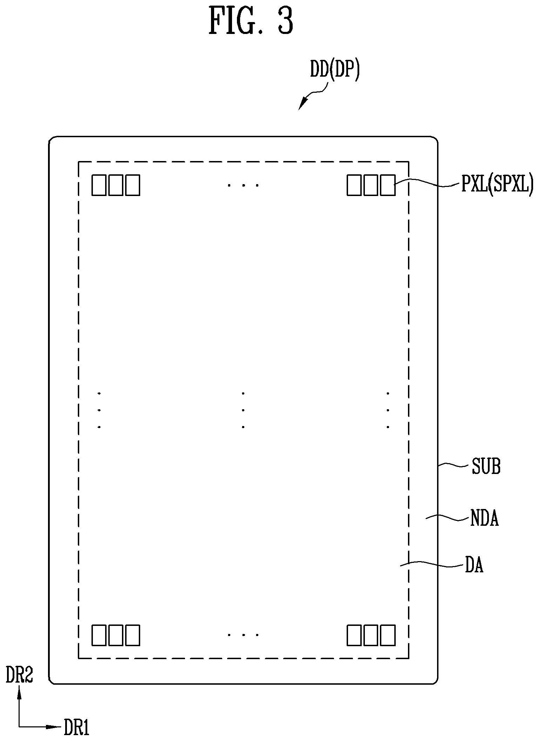

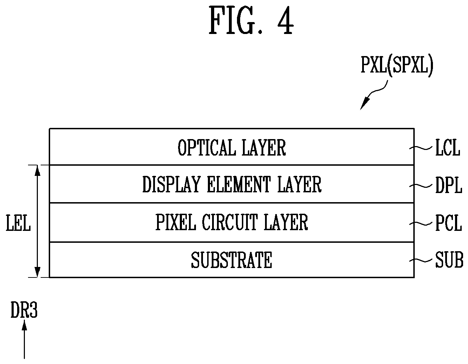

FIG. 3 is a schematic plan view illustrating a display device DD in accordance with one or more embodiments. FIG. 4 is a schematic cross-sectional view illustrating a pixel PXL of FIG. 3.

In FIG. 3, for the sake of explanation, there is schematically illustrated the display device DD, particularly, the structure of a display panel DP provided in the display device DD, centered on a display area DA in which an image is displayed.

Referring to FIG. 1 to 4, if the display device DD is an electronic device having a display surface on at least one surface thereof, e.g., a smartphone, a television, a tablet PC, a mobile phone, a video phone, an electronic-book reader, a desktop PC, a laptop PC, a netbook computer, a workstation, a server, a personal digital assistant (PDA), a portable multimedia player (PMP), an MP3 player, a medical appliance, a camera, or a wearable device, the present disclosure may be applied to the display device DD.

The display device DD may be classified into a passive matrix type display device and an active matrix type display device according to a method of driving the light emitting element LD. For example, in case that the display device DD is implemented as an active matrix type display device, each of the pixels PXL may include a driving transistor configured to control the amount of current to be supplied to the light emitting element LD, and a switching transistor configured to transmit data signals to the driving transistor.

The display panel DP (or the display device DD) may include a substrate SUB, and pixels PXL disposed on the substrate SUB. Each of the pixels PXL may include a plurality of sub-pixels SPXL. Each sub-pixel SPXL may include at least one light emitting element LD.

The substrate SUB may include a display area DA and a non-display area NDA.

The display area DA may be an area in which the pixels PXL for displaying an image are provided. The non-display area NDA may be an area in which a driver for driving each sub-pixel SPXL (or the pixel PXL) and a portion of a line component for connecting each sub-pixel SPXL to the driver are provided.

The non-display area NDA may be disposed adjacent to the display area DA along an edge or periphery of the display area DA. The non-display area NDA may be provided on at least one side of the display area DA. For example, the non-display area NDA may enclose the perimeter (or edges) of the display area DA. The line component connected to each sub-pixel SPXL, and the driver connected to the line component and configured to drive the sub-pixel SPXL may be provided in the non-display area NDA.

The line component may electrically connect the driver with each sub-pixel SPXL. The line component may include a fanout line connected with signal lines, e.g., a scan line, and a data line that are connected to each sub-pixel SPXL to provide signals to each sub-pixel SPXL. Furthermore, in one or more embodiments, the line component may include a fanout line connected to signal lines, e.g., a control line, and a sensing line, which are connected to each sub-pixel SPXL to compensate in real time for variation in electrical characteristics of the sub-pixel SPXL. In addition, the line component may include a fanout line connected with power lines that are configured to provide certain voltages to the respective sub-pixels SPXL and connected to the respective sub-pixels SPXL.

The substrate SUB may include transparent insulating material to allow light transmission. The substrate SUB may be a rigid substrate or a flexible substrate.

For example, the rigid substrate SUB may be one of a glass substrate, a quartz substrate, a glass ceramic substrate, and a crystalline glass substrate.

The flexible substrate SUB may be either a film substrate or a plastic substrate that includes polymer organic material. For example, the flexible substrate SUB may include at least one of the following: polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

One area on the substrate SUB may be provided as the display area DA in which the sub-pixels SPXL (or the pixels PXL) are disposed, and the other area thereof may be provided as the non-display area NDA. For example, the substrate SUB may include a display area DA including a plurality of pixel areas in which the respective sub-pixels SPXL (or the pixel PXL) are disposed, and a non-display area NDA disposed around the perimeter of the display area DA (or adjacent to the display area DA).

The pixels PXL may be provided in the display area DA on the substrate SUB. In one or more embodiments, the pixels PXL may be arranged in the display area DA in a stripe or a PENTILE^{®} arrangement structure, but embodiments of the present disclosure are not limited thereto. This PENTILE^{®} arrangement structure may be referred to as an RGBG matrix structure (e.g., a PENTILE^{®} matrix structure or an RGBG structure (e.g., a PENTILE^{®} structure)). PENTILE^{®} is a registered trademark of Samsung Display Co., Ltd., Republic of Korea.

Each of the pixels PXL may include a pixel circuit layer PCL, a display element layer DPL, and an optical layer LCL that are placed on the substrate SUB along a third direction DR3.

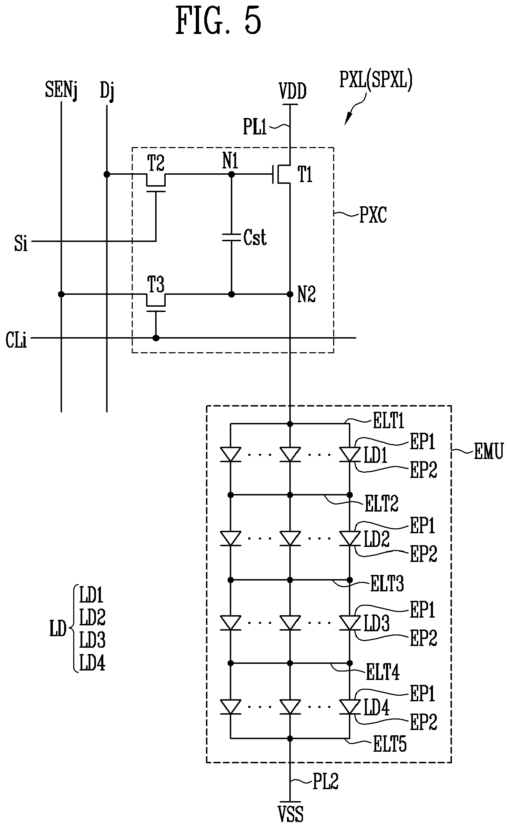

A pixel circuit (refer to "PXC" of FIG. 5) that is provided on the substrate SUB and includes a plurality of transistors and signal lines connected to the transistors may be disposed in the pixel circuit layer PCL. For example, each transistor has a structure in which a semiconductor layer, a gate electrode, a first terminal, and a second terminal are successively stacked with insulating layers interposed therebetween. The semiconductor layer may include amorphous silicon, poly silicon, low temperature poly silicon, and an organic semiconductor, and/or an oxide semiconductor. Although the gate electrode, the first terminal (or a source area), and the second terminal (or a drain area) each may include one of aluminum (Al), copper (Cu), titanium (Ti), and molybdenum (Mo), embodiments of the present disclosure are not limited thereto. In addition, the pixel circuit layer PCL may include at least one or more insulating layers.

The display element layer DPL may be disposed on the pixel circuit layer PCL. An emission component (refer to "EMU" of FIG. 5) including a light emitting element LD configured to emit light may be disposed in the display element layer DPL.

The substrate SUB, the pixel circuit layer PCL disposed on the substrate SUB, and the display element layer DPL disposed on the pixel circuit layer PCL may form a display component LEL (or the emission component) of each pixel PXL (or each sub-pixel SPXL).

The optical layer LCL may be selectively disposed on the display component LEL. The optical layer LCL may convert light emitted from the light emitting element LD to light having excellent color reproducibility and emit the converted light, thus enhancing the light output efficiency of each pixel PXL (or each sub-pixel SPXL). The optical layer LCL may include a color conversion layer and a color filter.

A plurality of sub-pixels SPXL, e.g., a first sub-pixel, a second sub-pixel, and a third sub-pixel, may be provided in a pixel area in which each of the pixels PXL is provided. In one or more embodiments, the first sub-pixel may be a red pixel (or a red sub-pixel), the second sub-pixel may be a green pixel (or a green sub-pixel), and the third sub-pixel may be a blue pixel (or a blue sub-pixel). However, embodiments of the present disclosure are not limited thereto. In one or more embodiments, the second pixel may be a red pixel, the first pixel may be a green pixel, and the third pixel may be a blue pixel. Alternatively, in one or more embodiments, the third sub-pixel may be a red pixel, the first sub-pixel may be a green pixel, and the second sub-pixel may be a blue pixel.

The first sub-pixel may include a first pixel circuit and a first emission component (or a first emission unit). The second sub-pixel may include a second pixel circuit and a second emission component (or a second emission unit). The third sub-pixel may include a third pixel circuit and a third emission component (or a third emission unit).

The first, second, and third pixel circuits and the first, second, and third emission components may be disposed on difference layers and overlap each other. For example, the first, second, and third pixel circuits may be disposed on the pixel circuit layer PCL of each sub-pixel SPXL. The first, second, and third emission components may be disposed in the display element layer DPL that overlaps the pixel circuit layer PCL in the corresponding sub-pixel SPXL.

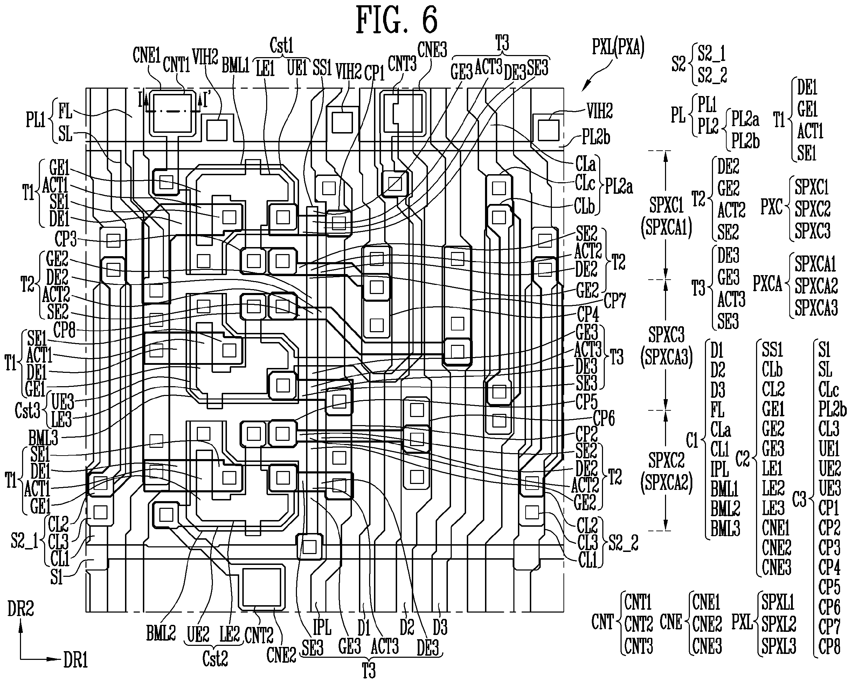

A first alignment electrode (or a first alignment line) and a second alignment electrode (or a second alignment line) that are spaced from each other may be disposed in the first, second, and third emission components. The light emitting element LD may be disposed between the first alignment electrode and the second alignment electrode. Components of each pixel PXL will be described with reference to FIGS. 6 to 10.

Each pixel PXL (or each sub-pixel SPXL) may include at least one or more light emitting elements LD configured to be driven in response to a corresponding scan signal and a corresponding data signal. The light emitting element LD may have a small size ranging from the nano scale (or the nanometer scale) to the micro scale (the micrometer scale) and may be connected in parallel to light emitting elements LD disposed adjacent thereto, but embodiments of the present disclosure are not limited thereto. The light emitting element LD may form a light source of each pixel PXL (or each sub-pixel SPXL).

FIG. 5 is a schematic circuit diagram illustrating an electrical connection relationship of components included in each of the pixels PXL illustrated in FIG. 3.

For example, FIG. 5 illustrates the electrical connection relationship of components included in the pixel PXL (or the sub-pixel SPXL) that may be employed in an active matrix type display device in accordance with one or more embodiments. Here, the electrical connection relationship of the components of each pixel PXL (or each sub-pixel SPXL) is not limited thereto.

Referring to FIGS. 1 to 5, the sub-pixel SPXL (or the pixel PXL) may include an emission component EMU configured to generate light having a luminance corresponding to a data signal. Furthermore, the sub-pixel SPXL may optionally further include a pixel circuit PXC configured to drive the emission component EMU.

For example, the emission component EMU may include a first electrode ELT1 (or a first pixel electrode) electrically connected to a first driving power supply VDD by the pixel circuit PXC and the first power line PL1, a fifth electrode ELT5 (or a second pixel electrode) electrically connected to the second driving power supply VSS through the second power line PL2, and a plurality of light emitting elements LD that are electrically connected between the first and fifth electrodes ELT1 and ELT5. The first driving power supply VDD and the second driving power supply VSS may have different potentials to allow the light emitting elements LD to emit light. For example, the first driving power supply VDD may be set as a high-potential power supply, and the second driving power supply VSS may be set as a low-potential power supply.

In one or more embodiments, the emission component EMU may include at least one series stage. Each series stage may include a pair of electrodes (e.g., two electrodes), and at least one light emitting element LD connected in a forward direction between the pair of electrodes. Here, the number of series stages that form the emission component EMU and the number of light emitting elements LD that form each series stage are not particularly limited. For example, the numbers of light emitting elements LD that form the respective series stages may be identical to or different from each other. The number of light emitting elements LD of each series stage is not particularly limited.

For example, the emission component EMU may include a first series stage including at least one first light emitting element LD1, a second series stage including at least one second light emitting element LD2, a third series stage including at least one third light emitting element LD3, and a fourth series stage including at least one fourth light emitting element LD4.

The first series stage may include a first electrode ELT1, a second electrode ELT2 (or a first bridge electrode), and at least one first light emitting element LD1 electrically connected between the first and second electrodes ELT1 and ELT2. Each first light emitting element LD1 may be electrically connected in the forward direction between the first and second electrodes ELT1 and ELT2. For example, a first end EP1 of the first light emitting element LD1 may be electrically connected to the first electrode ELT1. A second end EP2 of the first light emitting element LD1 may be electrically connected to the second electrode ELT2.

The second series stage may include the second electrode ELT2, a third electrode ELT3 (or a second bridge electrode), and at least one second light emitting element LD2 electrically connected between the second and third electrodes ELT2 and ELT3. Each second light emitting element LD2 may be electrically connected in the forward direction between the second and third electrodes ELT2 and ELT3. For example, a first end EP1 of the second light emitting element LD2 may be electrically connected to the second electrode ELT2. A second end EP2 of the second light emitting element LD2 may be electrically connected to the third electrode ELT3.

The third series stage may include the third electrode ELT3, a fourth electrode ELT4 (or a third bridge electrode), and at least one third light emitting element LD3 electrically connected between the third and fourth electrodes ELT3 and ELT4. Each third light emitting element LD3 may be electrically connected in the forward direction between the third and fourth electrodes ELT3 and ELT4. For example, a first end EP1 of the third light emitting element LD3 may be electrically connected to the third electrode ELT3. A second end EP2 of the third light emitting element LD3 may be electrically connected to the fourth electrode ELT4.

The fourth series stage may include the fourth electrode ELT4, the fifth electrode ELT5, and at least one fourth light emitting element LD4 electrically connected between the fourth and fifth electrodes ELT4 and ELT5. Each fourth light emitting element LD4 may be electrically connected in the forward direction between the fourth and fifth electrodes ELT4 and ELT5. For example, a first end EP1 of the fourth light emitting element LD4 may be electrically connected to the fourth electrode ELT4. A second end EP2 of the fourth light emitting element LD4 may be electrically connected to the fifth electrode ELT5.

The first electrode of the emission component EMU, e.g., the first electrode ELT1, may be an anode electrode of the emission component EMU. The last electrode of the emission component EMU, e.g., the fifth electrode ELT5, may be a cathode electrode of the emission component EMU.

In case that the light emitting elements LD are electrically connected to have a series/parallel structure, power efficiency may be enhanced, compared to the case where an equal number of light emitting elements LD are electrically connected only in parallel to each other. Furthermore, in the sub-pixel SPXL in which the light emitting elements LD are electrically connected in a series/parallel structure, even if a short-circuit defect or the like occurs in some series stages, sufficient luminance may be expressed by the light emitting elements LD of the other series stages, so that the probability of occurrence of a black spot defect in the sub-pixel SPXL may be reduced. However, embodiments of the present disclosure are not limited thereto. The emission component EMU may be formed by connecting the light emitting elements LD only in series. Alternatively, the emission component EMU may be formed by connecting the light emitting elements LD only in parallel.

Each of the light emitting elements LD may include a first end EP1 (e.g., a p-type end) electrically connected to the first driving power supply VDD via at least one electrode (e.g., the first electrode ELT1), the pixel circuit PXC, the first power line PL1, and/or the like, and a second end EP2 (e.g., an n-type end) electrically connected to the second driving power supply VSS via at least another electrode (e.g., the fifth electrode ELT5), the second power line PL2, and the like. In other words, the light emitting elements LD may be electrically connected in the forward direction between the first driving power supply VDD and the second driving power supply VSS. The light emitting elements LD electrically connected in the forward direction may form valid light sources of the emission component EMU.

The light emitting elements LD may emit, when driving current is supplied thereto through the corresponding pixel circuit PXC, light having a luminance corresponding to the driving current. For example, during each frame period, the pixel circuit PXC may supply driving current corresponding to a grayscale value to be represented in the corresponding frame to the emission component EMU. Hence, the light emitting elements LD may emit light having luminance corresponding to the driving current, so that the emission component EMU may express the luminance corresponding to the driving current.

The light emitting elements LD of the emission component EMU may emit light having a luminance corresponding to driving current supplied thereto through the pixel circuit PXC. For example, during each frame period, the pixel circuit PXC may supply driving current corresponding to a grayscale value of a corresponding frame data to the emission component EMU. The driving current supplied to the emission component EMU may be divided into parts that flow into the respective light emitting elements LD. Hence, each of the light emitting elements LD may emit light having a luminance corresponding to current applied thereto, so that the emission component EMU may emit light having a luminance corresponding to the driving current.

The pixel circuit PXC may be electrically connected to a scan line Si and a data line Dj of the corresponding sub-pixel SPXL. For example, if the sub-pixel SPXL is disposed in an i-th row and a j-th column of the display area DA, the pixel circuit PXC of the sub-pixel SPXL may be electrically connected to an i-th scan line Si and a j-th data line Dj of the display area DA. Furthermore, the pixel circuit PXC may be electrically connected to an i-th control line CLi and a j-th sensing line SENj of the display area DA.

The pixel circuit PXC may include first to third transistors T1, T2, and T3, and a storage capacitor Cst.

The first transistor T1 may be a driving transistor configured to control driving current to be applied to the emission component EMU, and may be electrically connected between the first driving power supply VDD and the emission component EMU. In detail, a first terminal of the first transistor T1 may be electrically connected to the first driving power supply VDD by the first power line PL1. A second terminal of the first transistor T1 may be electrically connected to a second node N2. A gate electrode of the first transistor T1 may be electrically connected to a first node N1. The first transistor T1 may control, in response to a voltage applied to the first node N1, the amount of driving current to be applied from the first driving power supply VDD to the emission component EMU through the second node N2. In one or more embodiments, the first terminal of the first transistor T1 may be a drain electrode, and the second terminal of the first transistor T1 may be a source electrode, and embodiments of the present disclosure are not limited thereto. In one or more embodiments, the first terminal may be a source electrode, and the second terminal may be a drain electrode.

The second transistor T2 may be a switching transistor configured to select a sub-pixel SPXL in response to a scan signal and activate the sub-pixel SPXL, and may be electrically connected between the data line Dj (e.g., the j-th data line) and the first node N1. A first terminal of the second transistor T2 may be electrically connected to the data line Dj. A second terminal of the second transistor T2 may be electrically connected to the first node N1. A gate electrode of the second transistor T2 may be electrically connected to the scan line Si (e.g., the i-th scan line). The first terminal and the second terminal of the second transistor T2 are different terminals, and, for example, if the first terminal is a drain electrode, and the second terminal may be a source electrode.

When a scan signal having a gate-on voltage (e.g., a high level voltage) is supplied from the scan line Si, the second transistor T2 may be turned on to electrically connect the data line Dj with the first node N1. The first node N1 may be a point at which the second terminal of the second transistor T2 and the gate electrode of the first transistor T1 are electrically connected to each other. The second transistor T2 may transmit a data signal to the gate electrode of the first transistor T1.

The third transistor T3 may obtain a sensing signal through the sensing line SENj by connecting the first transistor T1 to the sensing line SENj (e.g., the j-th sensing line), and detect, using the sensing signal, characteristics of the sub-pixel SPXL such as a threshold voltage of the first transistor T1. Information about the characteristics of each sub-pixel SPXL may be used to convert image data such that a deviation in characteristic between sub-pixels SPXL may be compensated for. A second terminal of the third transistor T3 may be electrically connected to the second terminal of the first transistor T1. A first terminal of the third transistor T3 may be electrically connected to the sensing line SENj. A gate electrode of the third transistor T3 may be electrically connected to the control line CLi (e.g., the i-th control line). Furthermore, in one or more embodiments, the first terminal of the third transistor T3 may be electrically connected to an initialization power supply. The third transistor T3 may be an initialization transistor configured to initialize the second node N2, and may be turned on when a sensing control signal is supplied thereto from the control line CLi, so that the voltage of the initialization power supply may be transmitted to the second node N2. Hence, a second storage electrode of the storage capacitor Cst that is electrically connected to the second node N2 may be initialized.

The storage capacitor Cst may include a first storage electrode (or a lower electrode) and a second storage electrode (or an upper electrode). The first storage electrode may be electrically connected to the first node N1. The second storage electrode may be electrically connected to the second node N2. The storage capacitor Cst may be charged with a data voltage corresponding to a data signal to be supplied to the first node N1 during one frame period. Hence, the storage capacitor Cst may store a voltage corresponding to a difference between a voltage of the gate electrode of the first transistor T1 and a voltage of the second node N2.

Although FIG. 5 illustrates an embodiment where all of the first to third transistors T1, T2, and T3 are N-type transistors, embodiments of the present disclosure are not limited thereto. For example, at least one of the first to third transistors T1, T2, and T3 may be changed to a P-type transistor. Furthermore, although FIG. 5 illustrates an embodiment where the emission component EMU is electrically connected between the pixel circuit PXC and the second driving power supply VSS, the emission component EMU may be electrically connected between the first driving power supply VDD and the pixel circuit PXC.

The structure of the pixel circuit PXC may be changed in various ways. For example, the pixel circuit PXC may further include at least one transistor element such as a transistor element configured to initialize the first node N1, and/or a transistor element configured to control an emission time of the light emitting elements LD, or other circuit elements such as a boosting capacitor configured to boost the voltage of the first node N1.

In one or more embodiments, for the sake of explanation, a transverse direction (or an X-axis direction) in a plan view will be indicated by a first direction DR1, a longitudinal direction (or a Y-axis direction) in a plan view will be indicated by a second direction DR2, and a vertical direction in a sectional will be indicated by the third direction DR3.

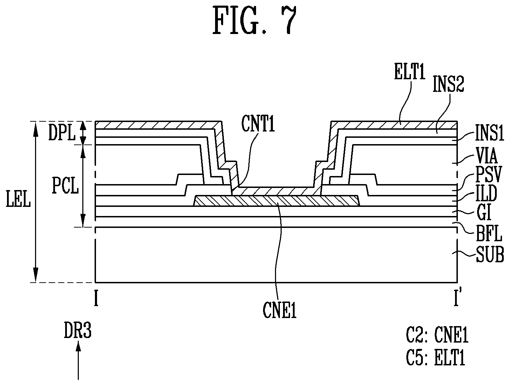

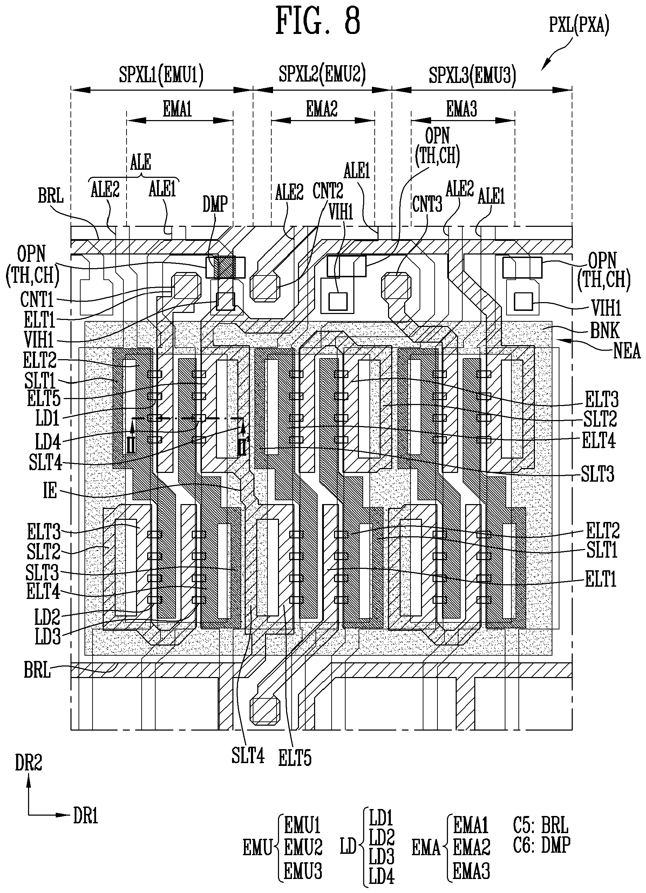

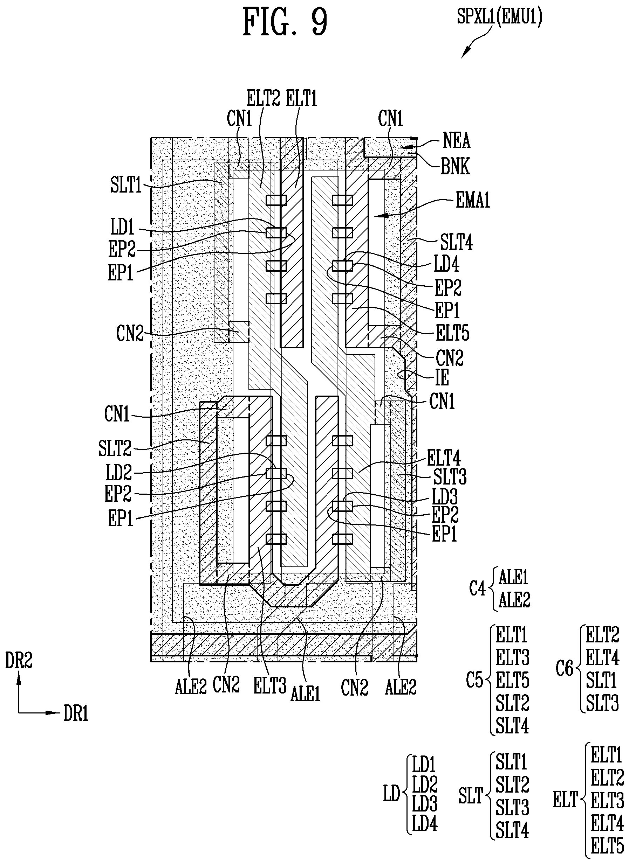

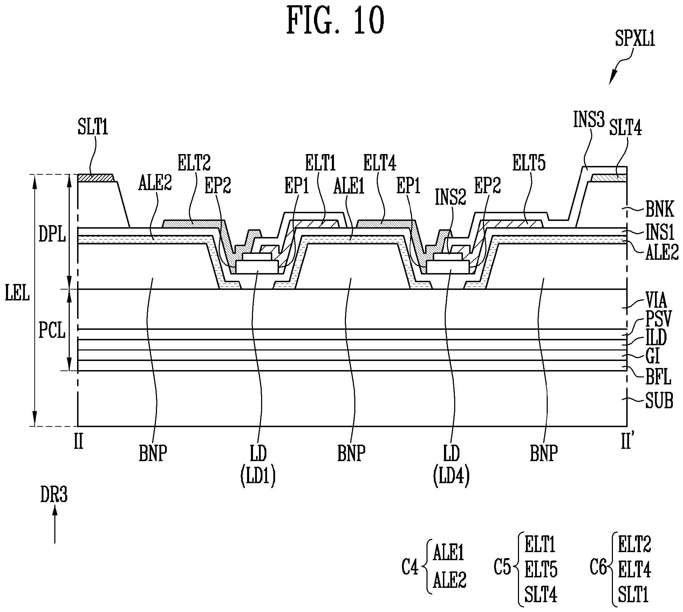

FIG. 6 is a schematic plan view illustrating a pixel circuit layer PCL of a pixel PXL in accordance with one or more embodiments. FIG. 7 is a schematic cross-sectional view taken along the line I-I' of FIG. 6. FIG. 8 is a schematic plan view illustrating a display element layer DPL of the pixel PXL in accordance with one or more embodiments. FIG. 9 is a schematic plan view illustrating only some components included in a first sub-pixel SPXL1 of FIG. 8. FIG. 10 is a schematic cross-sectional view taken along the line II-II' of FIG. 8.

In FIGS. 6 to 10, not only the components included in the pixel PXL but also an area in which the components are provided (or located) may be embraced in the definition of the term "pixel PXL".

Referring to FIGS. 1 to 10, the pixel PXL may include a first sub-pixel SPXL1, a second sub-pixel SPXL2, and a third sub-pixel SPXL3.

The first sub-pixel SPXL1 may include a first pixel circuit SPXC1 and a first emission component EMU1. The second sub-pixel SPXL2 may include a second pixel circuit SPXC2 and a second emission component EMU2. The third sub-pixel SPXL3 may include a third pixel circuit SPXC3 and a third emission component EMU3.

The first pixel circuit SPXC1, the second pixel circuit SPXC2, and the third pixel circuit SPXC3 may form the pixel circuit PXC of the pixel PXL. The first emission component EMU1, the second emission component EMU2, and the third emission component EMU3 may form the emission component EMU of the pixel PXL.

The pixel area PXA may include a first pixel circuit area SPXCA1, a second pixel circuit area SPXCA2, and a third pixel circuit area SPXCA3. The first pixel circuit area SPXCA1 may be an area in which the first pixel circuit SPXC1 is provided. The second pixel circuit area SPXCA2 may be an area in which the second pixel circuit SPXC2 is provided. The third pixel circuit area SPXCA3 may be an area in which the third pixel circuit SPXC3 is provided.

The pixel area PXA may include a first emission area EMA1, a second emission area EMA2, and a third emission area EMA3. For example, the pixel area PXA may include the first emission area EMA1, the second emission area EMA2, and the third emission area EMA3 that are partitioned from each other along the first direction DR1.

The first emission area EMA1 may be an area where light is emitted from the light emitting elements LD that are driven by the first pixel circuit SPXC1. The light emitting elements LD may be a component of the first emission component EMU1. In one or more embodiments, the first emission area EMA1 may be an emission area of the first sub-pixel SPXL1.

The second emission area EMA2 may be an area where light is emitted from the light emitting elements LD that are driven by the second pixel circuit SPXC2. The light emitting elements LD may be a component of the second emission component EMU2. In one or more embodiments, the second emission area EMA2 may be an emission area of the second sub-pixel SPXL2.

The third emission area EMA3 may be an area where light is emitted from the light emitting elements LD that are driven by the third pixel circuit SPXC3. The light emitting elements LD may be a component of the third emission component EMU3. In one or more embodiments, the third emission area EMA3 may be an emission area of the third sub-pixel SPXL3.

The first emission area EMA1, the second emission area EMA2, and the third emission area EMA3 may form the emission area EMA of the pixel PXL.

The pixel area PXA may include a non-emission area NEA that is adjacent to the first emission area EMA1 (or encloses the perimeter of the first emission area EMA1), a non-emission area NEA that is adjacent to the second emission area EMA2 (or encloses the perimeter of the second emission area EMA2), and a non-emission area NEA that is adjacent to the third emission area EMA3 (or encloses the perimeter of the third emission area EMA3).

Hereinafter, the term "sub-pixel SPXL" or "sub-pixels SPXL" will be used to arbitrarily designate any one sub-pixel SPXL of the first sub-pixel SPXL1, the second sub-pixel SPXL2, and the third sub-pixel SPXL3, or collectively designate two or more kinds of sub-pixels SPXL.

The pixel circuit layer PCL and the display element layer DPL may be disposed on the substrate SUB in the pixel PXL or the pixel area PXA. The pixel circuit layer PCL and the display element layer DPL each may include a plurality of insulating layers. The pixel circuit layer PCL may include, for example, a buffer layer BFL, a gate insulating layer GI, an interlayer insulating layer ILD, a passivation layer PSV, and a via layer VIA that are successively provided on the substrate SUB. The display element layer DPL may include a first insulating layer INS1, a second insulating layer INS2, and/or a third insulating layer INS3 that are successively provided on the pixel circuit layer PCL.

The buffer layer BFL may be disposed on the overall surface of the substrate SUB. The buffer layer BFL may prevent impurities from diffusing into the transistors T1, T2, and T3 included in the first to third pixel circuits SPXC1, SPXC2, and SPXC3. The buffer layer BFL may be an inorganic insulating layer including inorganic material. The buffer layer BFL may include at least one of silicon nitride (SiNₓ), silicon oxide (SiOₓ), silicon oxynitride (SiOₓN_{y}), and aluminum oxide (AlOₓ). The buffer layer BFL may be provided in the form of a single layer structure, or provided in the form of a multilayer structure having at least two or more layers. In case that the buffer layer BFL is provided in the form of a multilayer structure, the respective layers may be formed of the same material or different materials. The buffer layer BFL may be omitted depending on the material of the substrate SUB or processing conditions.

The gate insulating layer GI may be disposed on the overall surface of the buffer layer BFL. The gate insulating layer GI may include the same material as that of the buffer layer BFL, or include suitable (or selected) material from among the materials exemplified as the constituent materials of the buffer layer BFL. The gate insulating layer GI may be an inorganic insulating layer including inorganic material.

The interlayer insulating layer ILD may be provided and/or formed on the overall surface of the gate insulating layer GI. The interlayer insulating layer ILD may include the same material as that of the gate insulating layer GI, or may include one or more suitable (or selected) materials from among materials exemplified as the constituent material of the gate insulating layer GI.

The passivation layer PSV may be provided and/or formed on the overall surface of the interlayer insulating layer ILD. The passivation layer PSV may include the same material as that of the gate insulating layer GI, or may include one or more suitable (or selected) materials from among materials exemplified as the constituent material of the gate insulating layer GI.

The via layer VIA may be provided and/or formed on the overall surface of the passivation layer PSV. The via layer VIA may be an inorganic insulating layer including inorganic material or an organic insulating layer including organic material. The inorganic insulating layer may include, for example, at least one of silicon oxide (SiOₓ), silicon nitride (SiNₓ), silicon oxynitride (SiOₓN_{y}), and aluminum oxide (AlOₓ). The organic insulating layer may include, for example, at least one of polyacrylates resin, epoxy resin, phenolic resin, polyamides resin, polyimides rein, unsaturated polyesters resin, poly-phenylen ethers resin, poly-phenylene sulfides resin, and benzocyclobutene resin.

The first insulating layer INS1 may be provided and/or formed on the overall surface of the pixel circuit layer PCL. The first insulating layer INS1 may be formed of a single layer or multiple layers, and include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The second insulating layer INS2 may be provided and/or formed on the first insulating layer INS1. The second insulating layer INS2 may include the same material as that of the first insulating layer INS1, or may include one or more suitable (or selected) materials from among materials exemplified as the constituent material of the first insulating layer INS1.

The third insulating layer INS3 may be provided and/or formed on the second insulating layer INS2. The third insulating layer INS3 may include the same material as that of the first insulating layer INS1, or may include one or more suitable (or selected) materials from among materials exemplified as the constituent material of the first insulating layer INS1.

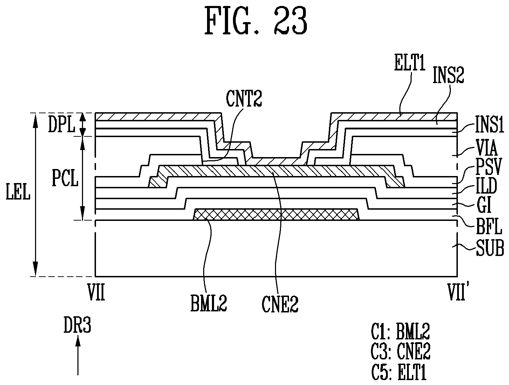

The pixel PXL may include at least one or more conductive layers disposed between the above-mentioned insulating layers. For example, the conductive layers may include a first conductive layer C1 provided on the substrate SUB (e.g., see FIG. 23), a second conductive layer C2 provided on the gate insulating layer GI, a third conductive layer C3 provided on the interlayer insulating layer ILD (E.G., see FIG. 23), a fourth conductive layer C4 provided on the via layer VIA, a fifth conductive layer C5 disposed on the second insulating layer INS2, and/or a sixth conductive layer C6 disposed on the third insulating layer INS3. However, the insulating layers and the conductive layers are not limited to that of those of the foregoing embodiment. In one or more embodiments, except the insulating layers and the conductive layers, other insulating layers and other conductive layers may be provided on the substrate SUB.

Signal lines that are electrically connected to the pixel PXL may be formed on the substrate SUB. The signal lines may transmit certain signals (or certain voltages) to the pixel PXL. For example, the signal lines may include a first scan line S1, a second scan line S2, data lines D1, D2, and D3, a power line PL, and an initialization power line IPL.

A scan signal and a control signal may be selectively applied to the first scan line S1. The first scan line S1 may extend in the first direction DR1. The first scan line S1 may be formed of the third conductive layer C3. The third conductive layer C3 may be formed of a single layer or multiple layers made of molybdenum (Mo), copper (Cu), aluminum (Al), chrome (Cr), gold (Au), silver (Ag), titanium (Ti), nickel (Ni), neodymium (Nd), indium (In), tin (Sn), and an oxide or alloy thereof.

The first scan line S1 may be disposed on a sub-scan line SS1, and may be electrically connected to the sub-scan line SS1 through a contact hole. For example, the first scan line S1 may be electrically connected to the sub-scan line SS1 through a contact hole passing through the interlayer insulating layer ILD.

The sub-scan line SS1 may extend in the second direction DR2. The sub-scan line SS1 may be formed of the second conductive layer C2. The second conductive layer C2 may be formed of a single-layer structure or a multi-layer structure made of molybdenum (Mo), copper (Cu), chrome (Cr), gold (Au), silver (Ag), titanium (Ti), nickel (Ni), neodymium (Nd), indium (In), tin (Sn), and an oxide or alloy thereof. For example, the second conductive layer C2 may have a multi-layer structure formed by successively or repeatedly stacking titanium (Ti), copper (Cu), and/or indium tin oxide (ITO).

In one or more embodiments, the sub-scan line SS1 may be integrally provided with a second gate electrode GE2 of the second transistor T2 of each of the first, second, and third pixel circuits SPXC1, SPXC2, and SPXC3. For example, a portion of the sub-scan line SS1 may be the second gate electrode GE2 of the second transistor T2 of each of the first, second, and third pixel circuits SPXC1, SPXC2, and SPXC3. Hence, the sub-scan line SS1 may be electrically connected to the second gate electrode GE2 of the second transistor T2 of each of the first, second, and third pixel circuits SPXC1, SPXC2, and SPXC3.

Furthermore, the sub-scan line SS1 may be integrally provided with a third gate electrode GE3 of the third transistor T3 of each of the first, second, and third pixel circuits SPXC1, SPXC2, and SPXC3. For example, another portion of the sub-scan line SS1 may be the third gate electrode GE3 of the third transistor T3 of each of the first, second, and third pixel circuits SPXC1, SPXC2, and SPXC3. Hence, the sub-scan line SS1 may be electrically connected to the third gate electrode GE3 of the third transistor T3 of each of the first, second, and third pixel circuits SPXC1, SPXC2, and SPXC3.

As described above, because the sub-scan line SS1 is electrically connected with the first scan line S1 through the corresponding contact hole, the first scan line S1 may be electrically connected with some components (e.g., the second and third transistors T2 and T3) of each of the first, second, and third pixel circuits SPXC1, SPXC2, and SPXC3 by the sub-scan line SS1. In this case, the first scan line S1 may supply a scan signal to the second transistor T2 of each of the first, second, and third pixel circuits SPXC1, SPXC2, and SPXC3 during a driving period of the light emitting elements LD, and may supply a control signal to the third transistor T3 of each of the first, second, and third pixel circuits SPXC1, SPXC2, and SPXC3 during a sensing period.

The sub-scan line SS1 may be a common component provided in common to the first, second, and third pixel circuits SPXC1, SPXC2, and SPXC3. In other words, the first, second, and third pixel circuits SPXC1, SPXC2, and SPXC3 may share one sub-scan line SS1.

The data lines D1, D2, and D3 may include a first data line D1, a second data line D2, and a third data line D3 that extend in the second direction DR2 and are spaced from each other in the first direction DR1. Each of the first, second, and third data lines D1, D2, and D3 may be supplied with a corresponding data signal.

The first data line D1 may be electrically connected to the second transistor T2 of the first pixel circuit SPXC1. The second data line D2 may be electrically connected to the second transistor T2 of the second pixel circuit SPXC2. The third data line D3 may be electrically connected to the second transistor T2 of the third pixel circuit SPXC3. Each of the first, second, and third data lines D1, D2, and D3 may be formed of the first conductive layer C1. The first conductive layer C1 may include the same material as that of the third conductive layer C3, or may include one or more materials selected from among materials exemplified as the constituent material of the third conductive layer C3.

The power line PL may include a first power line PL1 and a second power line PL2.

The voltage of the first driving power supply (VDD of FIG. 5) may be applied to the first power line PL1. The first power line PL1 may extend in the second direction DR2. In one or more embodiments, the first power line PL1 may include a first layer FL and a second layer SL. The first layer FL may be formed of the first conductive layer C1. The second layer SL may be formed of the third conductive layer C3. The second layer SL may be electrically connected with the first layer FL through at least one or more contact holes. For example, the second layer SL may be electrically connected with the first layer FL through at least one or more contact holes that successively pass through the buffer layer BFL, the gate insulating layer GI, and the interlayer insulating layer ILD. The first power line PL1 may be implemented as a double layer structure including the first layer FL and the second layer SL, so that line resistance may be reduced, and thus signal distortion may be reduced. However, embodiments of the present disclosure are not limited thereto, and the first power line PL1 may be implemented as a single layer structure or a multi-layer structure including triple or more layers.

The voltage of the second driving power supply (VSS of FIG. 5) may be applied to the second power line PL2. The second power line PL2 may include a 2a-th power line PL2a (or a second vertical power line) and a 2b-th power line PL2b (or a second horizontal power line).

The 2a-th power line PL2a may extend in the second direction DR2. The 2a-th power line PL2a may include a first layer CLa, a second layer CLb, and a third layer CLc. The first layer CLa may be formed of the first conductive layer C1. The second layer CLb may be formed of the second conductive layer C2. The third layer CLc may be formed of the third conductive layer C3.

The first layer CLa, the second layer CLb, and the third layer CLc may overlap each other. The first, second, and third layers CLa, CLb, and CLc may be electrically connected to each other through at least one or more contact holes. For example, the third layer CLc may be electrically connected with the first layer CLa through a contact hole that successively passes through the buffer layer BFL, the gate insulating layer GI, and the interlayer insulating layer ILD. Furthermore, the third layer CLc may be electrically connected to the second layer CLb through a contact hole passing through the interlayer insulating layer ILD. Hence, the first layer CLa and the second layer CLb may be electrically connected to each other through the third layer CLc.

In the foregoing embodiment, there has been described the case where the 2a-th power line PL2a is implemented as a triple-layer structure, but embodiments of the present disclosure are not limited thereto. In one or more embodiments, the 2a-th power line PL2a may be implemented as a double-layer structure in a manner similar to that of the first power line PL1, or may be implemented as a single-layer structure.

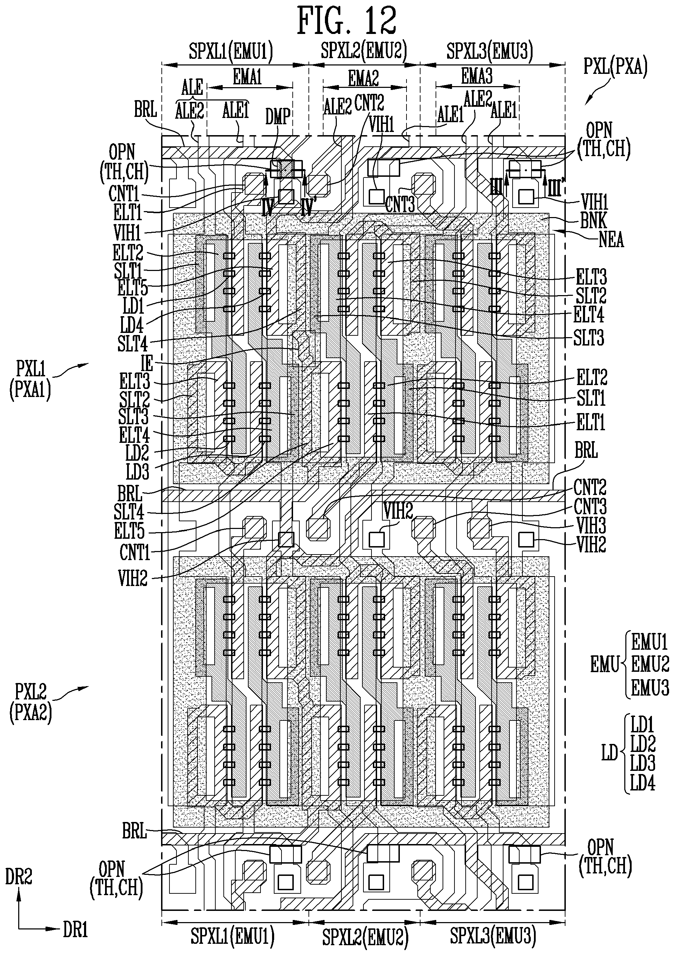

The 2b-th power line PL2b may extend in the first direction DR1. The 2b-th power line PL2b may be implemented as a single-layer structure. The 2b-th power line PL2b may be formed of the third conductive layer C3. The 2b-th power line PL2b may be electrically connected, through second via holes (refer to "VIH2" of FIG. 12), to at least one of the alignment electrodes ALE of each of the first, second, and third emission components EMU1, EMU2, and EMU3 which will be described below. Although each of the alignment electrodes ALE may be supplied with a certain alignment signal through the corresponding second via hole VIH2, embodiments of the present disclosure are not limited thereto.

The 2a-th power line PL2a and the 2b-th power line PL2b may be electrically connected to each other through a contact hole. For example, the 2b-th power line PL2b may be electrically connected to the 2a-th power line PL2a through the contact hole that successively passes through the buffer layer BFL, the gate insulating layer GI, and the interlayer insulating layer ILD. The second power line PL2 including the 2a-th power line PL2a and the 2b-th power line PL2b that are electrically connected to each other may have a mesh structure.

The second scan line S2 may extend in the second direction DR2 crossing with the first direction DR1 that is a direction in which the first scan line S1 extends. In the pixel PXL, the second scan line S2 may intersect the first scan line S1 and at least partially overlap the first scan line S1. The second scan line S2 may be a signal line which may be selectively supplied with a scan signal and a control signal. For example, the second scan line S2 may be supplied with a scan signal during a driving period of the light emitting elements LD, and may be supplied with a control signal during a certain sensing period.

In one or more embodiments, the second scan line S2 may include a 2-1-th scan line S2_1 and a 2-2-th scan line S2_2. The 2-1-th scan line S2_1 and the 2-2-th scan line S2_2 each may extend in the second direction DR2.

Each of the 2-1-th scan line S2_1 and the 2-2-th scan line S2_2 may be implemented as a triple-layer structure including a first conductive line CL1, a second conductive line CL2, and a third conductive line CL3. The first conductive line CL1 may be formed of the first conductive layer C1. The second conductive line CL2 may be formed of the second conductive layer C2. The third conductive line CL3 may be formed of the third conductive layer C3.

The first conductive line CL1, the second conductive line CL2, and the third conductive line CL3 may overlap each other. For example, the third conductive line CL3 may be electrically connected with the first conductive line CL1 through a contact hole that successively passes through the buffer layer BFL, the gate insulating layer GI, and the interlayer insulating layer ILD. Furthermore, the third conductive line CL3 may be electrically connected with the second conductive line CL2 through a contact hole passing through the interlayer insulating layer ILD. Hence, the first conductive line CL1 and the second conductive line CL2 may be electrically connected to each other by the third conductive line CL3.

Although in the foregoing embodiment there has been described an example where each of the 2-1-th scan line S2_1 and the 2-2-th scan line S2_2 may be implemented as a triple-layer structure including the first conductive line CL1, the second conductive line CL2, and the third conductive line CL3, embodiments of the present disclosure are not limited thereto. In one or more embodiments, each of the 2-1-th scan line S2_1 and the 2-2-th scan line S2_2 may be implemented as a single layer structure, a double layer structure, or a multi-layer structure including triple or more layers.

In one or more embodiments, the first conductive line CL1 of each of the 2-1-th and 2-2-th scan lines S2_1 and S2_2 may be provided in common to some of the pixels PXL disposed on the same pixel column in the second direction DR2. For example, the first conductive line CL1 of each of the 2-1-th and 2-2-th scan lines S2_1 and S2_2 of the pixel PXL may be provided in common to the pixels PXL disposed on the same pixel column in the second direction DR2. In other words, the pixels PXL that are disposed on the same pixel column in the second direction DR2 may share the first conductive line CL1 of each of the 2-1-th and 2-2-th scan lines S2_1 and S2_2.

At least one of the 2-1-th scan line S2_1 and the 2-2-th scan line S2_2 may be electrically connected with the first scan line S1 through a contact hole. For example, the 2-1-th scan line S2_1 may be electrically connected to the first scan line S1 through a contact hole that successively passes through at least one insulating layer, e.g., the buffer layer BFL, the gate insulating layer GI, and the interlayer insulating layer ILD. Hence, the first scan line S1 may be selectively supplied with a scan signal and a control signal from the 2-1-th scan line S2_1. In other words, the second scan line S2 may function as a signal line that is electrically connected with the first scan line S1 and configured to transmit, along with the first scan line S1, a scan signal and a control signal to some components of each of the first, second, and third pixel circuits SPXC1, SPXC2, and SPXC3, e.g., the second and third transistors T2 and T3 of each of the first, second, and third pixel circuits SPXC1, SPXC2, and SPXC3.

The initialization power line IPL may extend in the second direction DR2. The initialization power line IPL may be the sensing line SENj (or the j-th sensing line) described with reference to FIG. 5. The voltage of the initialization power supply may be applied to the initialization power line IPL. In one or more embodiments, the initialization power line IPL may be formed of the first conductive layer C1.

The initialization power line IPL may be electrically connected to the third transistor T3 of the first pixel circuit SPXC1 by a first conductive pattern CP1, may be electrically connected to the third transistor T3 of the second pixel circuit SPXC2 by a second conductive pattern CP2, and may be electrically connected to the third transistor T3 of the third pixel circuit SPXC3 by the second conductive pattern CP2.

The first conductive pattern CP1 may be formed of the third conductive layer C3. A first end of the first conductive pattern CP1 may be electrically connected with the initialization power line IPL through a contact hole. For example, the first end of the first conductive pattern CP1 may be electrically connected with the initialization power line IPL through the contact hole that successively passes through the buffer layer BFL, the gate insulating layer GI, and the interlayer insulating layer ILD.

A second end of the first conductive pattern CP1 may be electrically connected with the third transistor T3 of the first pixel circuit SPXC1 through another contact hole. For example, the second end of the first conductive pattern CP1 may be electrically connected with a third drain area DE3 of the third transistor T3 of the first pixel circuit SPXC1 through the contact hole that successively passes through the gate insulating layer GI and the interlayer insulating layer ILD.

The second conductive pattern CP2 may be formed of the third conductive layer C3. The second conductive pattern CP2 may be electrically connected with the initialization power line IPL through a contact hole. For example, the second conductive pattern CP2 may be electrically connected with the initialization power line IPL through the contact hole that successively passes through the buffer layer BFL, the gate insulating layer GI, and the interlayer insulating layer ILD.

The second conductive pattern CP2 may be electrically connected with the third transistor T3 of the second pixel circuit SPXC2 through another contact hole. For example, the second conductive pattern CP2 may be electrically connected with a third drain area DE3 of the third transistor T3 of the second pixel circuit SPXC2 through the contact hole that successively passes through the gate insulating layer GI and the interlayer insulating layer ILD.

The second conductive pattern CP2 may be electrically connected with the third transistor T3 of the third pixel circuit SPXC3 through another contact hole. For example, the second conductive pattern CP2 may be electrically connected with a third drain area DE3 of the third transistor T3 of the third pixel circuit SPXC3 through the contact hole that successively passes through the gate insulating layer GI and the interlayer insulating layer ILD.

The first power line PL1, the second power line PL2, the initialization power line IPL, the sub-scan line SS1, the first scan line S1, and the second scan line S2 may be common components provided in common in the first, second, and third pixel circuits SPXC1, SPXC2, and SPXC3.

Each of the first, second, and third pixel circuits SPXC1, SPXC2, and SPXC3 may include a first transistor T1, a second transistor T2, a third transistor T3, and a storage capacitor. For example, the first pixel circuit SPXC1 may include first, second, and third transistors T1, T2, and T3, and a first storage capacitor Cst1. The second pixel circuit SPXC2 may include first, second, and third transistors T1, T2, and T3, and a second storage capacitor Cst2. The third pixel circuit SPXC3 may include first, second, and third transistors T1, T2, and T3, and a third storage capacitor Cst3.

The first transistor T1 of each of the first, second, and third pixel circuits SPXC1, SPXC2, and SPXC3 may correspond to the first transistor T1 described with reference to FIG. 5. The second transistor T2 of each of the first, second, and third pixel circuits SPXC1, SPXC2, and SPXC3 may correspond to the second transistor T2 described with reference to FIG. 5. The third transistor T3 of each of the first, second, and third pixel circuits SPXC1, SPXC2, and SPXC3 may correspond to the third transistor T3 described with reference to FIG. 5.

The first, second, and third pixel circuits SPXC1, SPXC2, and SPXC3 may have a substantially similar or identical structure. Hereinafter, the first pixel circuit SPXC1 from among the first, second, and third pixel circuits SPXC1, SPXC2, and SPXC3 will be described as a representative example, and descriptions of the second and third pixel circuits SPXC2 and SPXC3 will be simplified.

The first pixel circuit SPXC1 may include a first transistor T1, a second transistor T2, a third transistor T3, and a first storage capacitor Cst1.

The first transistor T1 may include a first gate electrode GE1, a first active pattern ACT1, a first source area SE1, and a first drain area DE1.

The first gate electrode GE1 may be electrically connected to a second source area SE2 of the second transistor T2 by a third conductive pattern CP3. The first gate electrode GE1 may be formed of the second conductive layer C2.

The third conductive pattern CP3 may be formed of the third conductive layer C3. A first end of the third conductive pattern CP3 may be electrically connected with the first gate electrode GE1 through a contact hole. For example, the first end of the third conductive pattern CP3 may be electrically connected with the first gate electrode GE1 through the contact hole that passes through the interlayer insulating layer ILD. A second end of the third conductive pattern CP3 may be electrically connected with the second source area SE2 through another contact hole. For example, the second end of the third conductive pattern CP3 may be electrically connected with the second source area SE2 through the contact hole that successively passes through the gate insulating layer GI and the interlayer insulating layer ILD.

The first active pattern ACT1, the first source area SE1, and the first drain area DE1 each may be a semiconductor pattern formed of poly silicon, amorphous silicon, an oxide semiconductor, or the like. Each of the first active pattern ACT1, the first source area SE1, and the first drain area DE1 may be formed of an undoped semiconductor layer or a semiconductor layer doped with an impurity. For example, each of the first source area SE1 and the first drain area DE1 may be formed of a semiconductor layer doped with an impurity. The first active pattern ACT1 may be formed of an undoped semiconductor layer.

The first active pattern ACT1, the first source area SE1, and the first drain area DE1 may be provided and/or formed on the buffer layer BFL.

The first active pattern ACT1 may be a channel area of the first transistor T1 as an area overlapping the first gate electrode GE1. In the case where the first active pattern ACT1 is relatively long, the channel area of the first transistor T1 may also be relatively long. In this case, a driving range of a certain voltage (or a certain signal) to be applied to the first transistor T1 may be increased. Consequently, the gray scale of light emitted from the light emitting elements LD may be precisely controlled.

The first source area SE1 may be electrically connected to (brought into contact with) a first end of the first active pattern ACT1. Furthermore, the first source area SE1 may be electrically connected to a first bottom metal layer BML1 through a contact hole that passes through the buffer layer BFL.

The first bottom metal layer BML1 may be formed of the first conductive layer C1. The first bottom metal layer BML1 may be electrically connected to the first source area SE1 through a contact hole. If the first bottom metal layer BML1 is electrically connected to the first transistor T1, a swing width margin of the second driving power supply VSS may be further increased. In this case, a driving range of a certain voltage to be applied to the first gate electrode GE1 of the first transistor T1 may be increased.

The first drain area DE1 may be electrically connected to (or brought into contact with) a second end of the first active pattern ACT1. Furthermore, the first drain area DE1 may be electrically connected with the first power line PL1 through a contact hole. For example, the first drain area DE1 may be electrically connected with the first layer FL of the first power line PL1 through the contact hole that passes through the buffer layer BFL.

The second transistor T2 may include a second gate electrode GE2, a second active pattern ACT2, a second source area SE2, and a second drain area DE2.

The second gate electrode GE2 may be integrally provided with the sub-scan line SS1. In this case, the second gate electrode GE2 may correspond to one area of the sub-scan line SS1. As described above, because the sub-scan line SS1 is electrically connected with the first scan line S1 through a contact hole, a certain signal (e.g., a scan signal) applied to the first scan line S1 may be ultimately supplied to the second gate electrode GE2.

The second active pattern ACT2, the second source area SE2, and the second drain area DE2 each may be a semiconductor pattern formed of poly silicon, amorphous silicon, an oxide semiconductor, or the like. Each of the second active pattern ACT2, the second source area SE2, and the second drain area DE2 may be formed of an undoped semiconductor layer or a semiconductor layer doped with an impurity. For example, each of the second source area SE2 and the second drain area DE2 may be formed of a semiconductor layer doped with an impurity. The second active pattern ACT2 may be formed of an undoped semiconductor layer. The second active pattern ACT2, the second source area SE2, and the second drain area DE2 may be provided and/or formed on the buffer layer BFL.

The second active pattern ACT2 may be a channel area of the second transistor T2 as an area overlapping the second gate electrode GE2.

The second source area SE2 may be electrically connected to (brought into contact with) a first end of the second active pattern ACT2. Furthermore, the second source area SE2 may be electrically connected to the first gate electrode GE1 by the third conductive pattern CP3.

The second drain area DE2 may be electrically connected to (or brought into contact with) a second end of the second active pattern ACT2. Furthermore, the second drain area DE2 may be electrically connected to the first data line D1 by a fourth conductive pattern CP4.

The fourth conductive pattern CP4 may be formed of the third conductive layer C3. A first end of the fourth conductive pattern CP4 may be electrically connected with the first data line D1 through a contact hole that successively passes through the buffer layer BFL, the gate insulating layer GI, and the interlayer insulating layer ILD. A second end of the fourth conductive pattern CP4 may be electrically connected to the second drain area DE2 through a contact hole that successively passes through the gate insulating layer GI and the interlayer insulating layer ILD. The second drain area DE2 and the first data line D1 may be electrically connected to each other by the fourth conductive pattern CP4.

The third transistor T3 may include a third gate electrode GE3, a third active pattern ACT3, a third source area SE3, and a third drain area DE3.

The third gate electrode GE3 may be integrally provided with the sub-scan line SS1. In this case, the third gate electrode GE3 may correspond to another area of the sub-scan line SS1. As described above, because the sub-scan line SS1 is electrically connected with the first scan line S1 through the corresponding contact hole, a certain signal (e.g., a control signal) applied to the first scan line S1 may be ultimately supplied to the third gate electrode GE3.

The third active pattern ACT3, the third source area SE3, and the third drain area DE3 each may be a semiconductor pattern formed of poly silicon, amorphous silicon, an oxide semiconductor, or the like. Each of the third active pattern ACT3, the third source area SE3, and the third drain area DE3 may be formed of an undoped semiconductor layer or a semiconductor layer doped with an impurity. For example, each of the third source area SE3 and the third drain area DE3 may be formed of a semiconductor layer doped with an impurity. The third active pattern ACT3 may be formed of an undoped semiconductor layer.

The third active pattern ACT3, the third source area SE3, and the third drain area DE3 may be provided and/or formed on the buffer layer.

The third active pattern ACT3 may correspond to a channel area of the third transistor T3 as an area overlapping the third gate electrode GE3.

The third source area SE3 may be electrically connected to (brought into contact with) a first end of the third active pattern ACT3. Furthermore, the third source area SE3 may be electrically connected to the first bottom metal layer BML1 through a contact hole that passes through the buffer layer BFL.

The third drain area DE3 may be electrically connected to (or brought into contact with) a second end of the third active pattern ACT3. Furthermore, the third drain area DE3 may be electrically connected to the initialization power line IPL by the first conductive pattern CP1.

The first storage capacitor Cst1 may include a first lower electrode LE1 and a first upper electrode UE1. Here, the first storage capacitor Cst1 may be the storage capacitor Cst described with reference to FIG. 5.

The first lower electrode LE1 may be integrally provided with the first gate electrode GE1. In this case, the first lower electrode LE1 may be one area of the first gate electrode GE1. The first lower electrode LE1 may be formed of the second conductive layer C2.

The first upper electrode UE1 may be disposed to overlap the first lower electrode LE1 in a plan view, and have a size(or a surface area) greater than that of the first lower electrode LE1, but embodiments of the present disclosure are not limited thereto. In a plan view, the first upper electrode UE1 may overlap each of the first source area SE1 and the third source area SE3. The first upper electrode UE1 may be formed of the third conductive layer C3.

The first upper electrode UE1 may be electrically connected with the first bottom metal layer BML1 through a contact hole that successively passes through the buffer layer BFL, the gate insulating layer GI, and the interlayer insulating layer ILD. As described above, because the first source area SE1 and the third source area SE3 are electrically connected with the first bottom metal layer BML1, the first upper electrode UE1 may be electrically connected with the first and third source areas SE1 and SE3 by the first bottom metal layer BML1.

The second pixel circuit SPXC2 may include a first transistor T1, a second transistor T2, a third transistor T3, and a second storage capacitor Cst2.

The first transistor T1 may include a first gate electrode GE1, a first active pattern ACT1, a first source area SE1, and a first drain area DE1.

The first gate electrode GE1 may be electrically connected to a second source area SE2 of the second transistor T2.

The first active pattern ACT1 may be a channel area of the first transistor T1.

The first source area SE1 may be electrically connected to the first active pattern ACT1. Furthermore, the first source area SE1 may be electrically connected to a second bottom metal layer BML2 through a contact hole that passes through the buffer layer BFL.

The second bottom metal layer BML2 may be a component corresponding to the first bottom metal layer BML1. The second bottom metal layer BML2 may be formed of the first conductive layer C1. The second bottom metal layer BML2 may be electrically connected to the first source area SE1 through a contact hole. Furthermore, the second bottom metal layer BML2 may be electrically connected to the third source area SE3 of the third transistor T3 through another contact hole that passes through the buffer layer BFL. In addition, the second bottom metal layer BML2 may be electrically connected to a second upper electrode UE2 through another contact hole that successively passes through the buffer layer BFL, the gate insulating layer GI, and the interlayer insulating layer ILD.

The first drain area DE1 may be electrically connected to the first active pattern ACT1. Furthermore, the first drain area DE1 may be electrically connected with the first layer FL of the first power line PL1 through another contact hole that passes through the buffer layer BFL.

The second transistor T2 may include a second gate electrode GE2, a second active pattern ACT2, a second source area SE2, and a second drain area DE2.

The second gate electrode GE2 may be integrally provided with the sub-scan line SS1 and may be electrically connected with the first scan line S1. The second gate electrode GE2 may be formed of the second conductive layer C2.

The second active pattern ACT2 may be a channel area of the second transistor T2.

The second source area SE2 may be electrically connected to the second active pattern ACT2. Furthermore, the second source area SE2 may be electrically connected to the first gate electrode GE1 by a fifth conductive pattern CP5.

The fifth conductive pattern CP5 may be formed of the third conductive layer C3. A first end of the fifth conductive pattern CP5 may be electrically connected to the second source area SE2 through a contact hole that successively passes through the gate insulating layer GI and the interlayer insulating layer ILD. A second end of the fifth conductive pattern CP5 may be electrically connected to the first gate electrode GE1 through a contact hole that passes through the interlayer insulating layer ILD.

The second drain area DE2 may be connected to the second active pattern ACT2. Furthermore, the second drain area DE2 may be electrically connected to the second data line D2 by a sixth conductive pattern CP6.

The sixth conductive pattern CP6 may be formed of the third conductive layer C3. A first end of the sixth conductive pattern CP6 may be electrically connected with the second data line D2 through a contact hole that successively passes through the buffer layer BFL, the gate insulating layer GI, and the interlayer insulating layer ILD. A second end of the sixth conductive pattern CP6 may be electrically connected to the second drain area DE2 through a contact hole that successively passes through the gate insulating layer GI and the interlayer insulating layer ILD.

The third transistor T3 may include a third gate electrode GE3, a third active pattern ACT3, a third source area SE3, and a third drain area DE3.

The third gate electrode GE3 may be integrally provided with the sub-scan line SS1 and may be electrically connected with the first scan line S1. The third gate electrode GE3 may be formed of the second conductive layer C2.

The third active pattern ACT3 may be a channel area of the third transistor T3.

The third source area SE3 may be electrically connected to the third active pattern ACT3. Furthermore, the third source area SE3 may be electrically connected to the second bottom metal layer BML2 through a contact hole.

The third drain area DE3 may be connected to the third active pattern ACT3. Furthermore, the third drain area DE3 may be electrically connected to the initialization power line IPL by the second conductive pattern CP2.

The second storage capacitor Cst2 may have a structure substantially equal or similar to that of the first storage capacitor Cst1 of the first pixel circuit SPXC1. For example, the second storage capacitor Cst2 may include a second lower electrode LE2 and a second upper electrode UE2.

The second lower electrode LE2 may be formed of the second conductive layer C2 and be integrally provided with the first gate electrode GE1 of the first transistor T1. The second upper electrode UE2 may be formed of the third conductive layer C3 and overlap the second lower electrode LE2. The second upper electrode UE2 may be electrically connected to the second bottom metal layer BML2 through a contact hole.

As described above, the second upper electrode UE2 may be electrically connected to each of the first source area SE1 and the third source area SE3 by the second bottom metal layer BML2.

The third pixel circuit SPXC3 may include a first transistor T1, a second transistor T2, a third transistor T3, and a third storage capacitor Cst3.

The first transistor T1 may include a first gate electrode GE1, a first active pattern ACT1, a first source area SE1, and a first drain area DE1.

The first gate electrode GE1 may be electrically connected to a second source area SE2 of the second transistor T2. The first gate electrode GE1 may be formed of the second conductive layer C2.

The first active pattern ACT1 may be a channel area of the first transistor T1.

The first source area SE1 may be connected to the first active pattern ACT1. Furthermore, the first source area SE1 may be electrically connected to a third bottom metal layer BML3 through a contact hole that passes through the buffer layer BFL.

The third bottom metal layer BML3 may be a component corresponding to each of the first and second bottom metal layers BML1 and BML2. The third bottom metal layer BML3 may be formed of the first conductive layer C1. The third bottom metal layer BML3 may be electrically connected to the first source area SE1 through a contact hole. Furthermore, the third bottom metal layer BML3 may be electrically connected to the third source area SE3 of the third transistor T3 through another contact hole that passes through the buffer layer BFL. In addition, the third bottom metal layer BML3 may be electrically connected to a third upper electrode UE3 through another contact hole that successively passes through the buffer layer BFL, the gate insulating layer GI, and the interlayer insulating layer ILD.

The first drain area DE1 may be connected to the first active pattern ACT1. Furthermore, the first drain area DE1 may be electrically connected with the first layer FL of the first power line PL1 through another contact hole that passes through the buffer layer BFL.

The second transistor T2 may include a second gate electrode GE2, a second active pattern ACT2, a second source area SE2, and a second drain area DE2.

The second gate electrode GE2 may be integrally provided with the sub-scan line SS1 and may be electrically connected with the first scan line S1. The second gate electrode GE2 may be formed of the second conductive layer C2.

The second active pattern ACT2 may be a channel area of the second transistor T2.

The second source area SE2 may be connected to the second active pattern ACT2. Furthermore, the second source area SE2 may be electrically connected to the first gate electrode GE1 through an eighth conductive pattern CP8.

The eighth conductive pattern CP8 may be formed of the third conductive layer C3. A first end of the eighth conductive pattern CP8 may be electrically connected to the second source area SE2 through a contact hole that successively passes through the gate insulating layer GI and the interlayer insulating layer ILD. A second end of the eighth conductive pattern CP8 may be electrically connected to the first gate electrode GE1 through a contact hole that passes through the interlayer insulating layer ILD. Hence, the first gate electrode GE1 and the second source area SE2 may be electrically connected to each other by the eighth conductive pattern CP8.

The second drain area DE2 may be connected to the second active pattern ACT2. Furthermore, the second drain area DE2 may be electrically connected to the third data line D3 by a seventh conductive pattern CP7.

The seventh conductive pattern CP7 may be formed of the third conductive layer C3. A first end of the seventh conductive pattern CP7 may be electrically connected with the third data line D3 through a contact hole that successively passes through the buffer layer BFL, the gate insulating layer GI, and the interlayer insulating layer ILD. A second end of the seventh conductive pattern CP7 may be electrically connected to the second drain area DE2 through a contact hole that successively passes through the gate insulating layer GI and the interlayer insulating layer ILD. Hence, the second drain area DE2 and the third data line D3 may be electrically connected to each other by the seventh conductive pattern CP7.

The third transistor T3 may include a third gate electrode GE3, a third active pattern ACT3, a third source area SE3, and a third drain area DE3.

The third gate electrode GE3 may be integrally provided with the sub-scan line SS1 and may be electrically connected with the first scan line S1.

The third active pattern ACT3 may be a channel area of the third transistor T3.

The third source area SE3 may be connected to the third active pattern ACT3.

Furthermore, the third source area SE3 may be electrically connected to the third bottom metal layer BML3 by a contact hole passing through the buffer layer BFL.

The third drain area DE3 may be connected to the third active pattern ACT3. Furthermore, the third drain area DE3 may be electrically connected to the initialization power line IPL by the eighth conductive pattern CP8.

The third storage capacitor Cst3 may have a structure substantially equal or similar to that of each of the first and second storage capacitors Cst1 and Cst2. For example, the third storage capacitor Cst3 may include a third lower electrode LE3 and a third upper electrode UE3.

The third lower electrode LE3 may correspond to the second conductive layer C2, and may be integrally provided with the first gate electrode GE1 of the corresponding transistor, e.g., the first transistor T1. The third upper electrode UE3 may be formed of the third conductive layer C3, and may overlap the third lower electrode LE3. The third upper electrode UE3 may be electrically connected to the third bottom metal layer BML3 through a contact hole. As described above, the third upper electrode UE3 may be electrically connected to each of the first source area SE1 and the third source area SE3 by the third bottom metal layer BML3.

The first pixel circuit SPXC1 may be electrically connected to the first emission component EMU1. For example, the first emission component EMU1 may be electrically connected to a first contact electrode CNE1 through a first contactor CNT1 (or referred as to contact opening), and may be electrically connected to the first upper electrode UE1 of the first storage capacitor Cst1 by the first contact electrode CNE1. For example, a first electrode ELT1 (or a first pixel electrode) of the first emission component EMU1 may be electrically connected to the first contact electrode CNE1 through the first contactor CNT1. In one or more embodiments, the first contact electrode CNE1 may overlap the first upper electrode UE1 of the first storage capacitor Cst1 in a plan view, and may be electrically connected with the first upper electrode UE1 through a contact hole.

The second pixel circuit SPXC2 may be electrically connected to the second emission component EMU2. For example, the second emission component EMU2 may be electrically connected to a second contact electrode CNE2 through a second contactor CNT2, and may be electrically connected to the second upper electrode UE2 of the second storage capacitor Cst2 by the second contact electrode CNE2. For example, a first electrode ELT1 (or a first pixel electrode) of the second emission component EMU2 may be electrically connected to the second contact electrode CNE2 through the second contactor CNT2. In one or more embodiments, the second contact electrode CNE2 may overlap the second upper electrode UE2 of the second storage capacitor Cst2 in a plan view, and may be electrically connected with the second upper electrode UE2 through a contact hole.

The third pixel circuit SPXC3 may be electrically connected to the third emission component EMU3. For example, the third emission component EMU3 may be electrically connected to a third contact electrode CNE3 through a third contactor CNT3, and may be electrically connected to the third upper electrode UE3 of the third storage capacitor Cst3 by the third contact electrode CNE3. For example, a first electrode ELT1 (or a pixel electrode) of the third emission component EMU3 may be electrically connected to the third contact electrode CNE3 through the third contactor CNT3. In one or more embodiments, the third contact electrode CNE3 may overlap the third upper electrode UE3 of the third storage capacitor Cst3 in a plan view, and may be electrically connected with the third upper electrode UE3 through a contact hole.

The first, second, and third contact electrodes CNE1, CNE2, and CNE3 each may be formed of the second conductive layer C2, and may be disposed on the gate insulating layer Gl. For example, the first, second, and third contact electrodes CNE1, CNE2, and CNE3 each may have a multi-layer structure formed by successively or repeatedly stacking titanium (Ti), copper (Cu), and/or indium tin oxide (ITO). In this case, because contact resistance attributable to an oxide layer (e.g., an aluminum oxide layer) may be improved, an issue of heat generation from the contactor CNT and a reduction in luminance of the display device DD (or the display panel DP) may be mitigated.

The first, second, and third contactors CNT1, CNT2, and CNT3 may have a substantially similar or identical structure. Hereinafter, the first contactor CNT1 from among the first, second, and third contactors CNT1, CNT2, and CNT3 will be described as a representative example, and the description of the second and third contactors CNT2 and CNT3 will be simplified.

An interlayer insulating layer ILD may be disposed on the first contact electrode CNE1. The interlayer insulating layer ILD may be partially open to include, in at least non-emission area NEA, the first contactor CNT1 through which one area of the first contact electrode CNE1 is exposed. The passivation layer PSV may be disposed on the interlayer insulating layer ILD. The passivation layer PSV may be partially open to expose one area of the first contact electrode CNE1. The via layer VIA may be disposed on the passivation layer PSV. The via layer VIA may be partially open to expose one area of the first contact electrode CNE1 that is exposed through the first contactor CNT1 of the interlayer insulating layer ILD. The first insulating layer INS1 may be disposed on the via layer VIA. The first insulating layer INS1 may be partially open to expose one area of the first contact electrode CNE1. The second insulating layer INS2 may be disposed on the first insulating layer INS1. The second insulating layer INS2 may be partially open to expose one area of the first contact electrode CNE1.

The first electrode ELT1 may be disposed on the second insulating layer INS2. The first electrode ELT1 may directly contact the first contact electrode CNE1 exposed through the first contactor CNT1. In the case where the first contact electrode CNE1 of the first pixel circuit SPXC1 (or the pixel circuit layer PCL) formed of the second conductive layer C2 (or a gate conductive layer) directly contacts the first electrode ELT1 of the first emission component EMU1 (or the display element layer DPL) formed of the fifth conductive layer C5, the contact resistance may be reduced or minimized, so that a heat generation issue and a luminance reduction problem of the display device DD (or the display panel DP) may be mitigated.

Hereinafter, the emission component EMU of the pixel PXL will be described in detail based on FIG. 8. The pixel PXL may include an emission component EMU disposed in the display element layer DPL. The emission component EMU may include a first emission component EMU1, a second emission component EMU2, and a third emission component EMU3.

Each of the first, second, and third emission components EMU1, EMU2, and EMU3 may include light emitting elements LD that are electrically connected to a corresponding pixel circuit PXC and are configured to emit light, and electrodes (or electrode patterns) that are electrically connected to the light emitting elements LD. For example, the first emission component EMU1 may include light emitting elements LD that are electrically connected to the first pixel circuit SPXC1, and electrodes that are electrically connected to the light emitting elements LD. The second emission component EMU2 may include light emitting elements LD that are electrically connected to the second pixel circuit SPXC2, and electrodes that are electrically connected to the light emitting elements LD. The third emission component EMU3 may include light emitting elements LD that are electrically connected to the third pixel circuit SPXC3, and electrodes that are electrically connected to the light emitting elements LD. The first pixel circuit SPXC1 and the first emission component EMU1 may form a first sub-pixel SPXL1. The second pixel circuit SPXC2 and the second emission component EMU2 may form a second sub-pixel SPXL2. The third pixel circuit SPXC3 and the third emission component EMU3 may form a third sub-pixel SPXL3.

The first sub-pixel SPXL1 may include a first emission area EMA1 and a non-emission area NEA that encloses at least one side of the first emission area EMA1. The second sub-pixel SPXL2 may include a second emission area EMA2 and a non-emission area NEA that encloses at least one side of the second emission area EMA2. The third sub-pixel SPXL3 may include a third emission area EMA3 and a non-emission area NEA that encloses at least one side of the third emission area EMA3.

The display element layer DPL may include a bank BNK disposed in the non-emission area NEA.

The bank BNK may be a pixel defining layer as a structure which defines (or partitions) the first, second, and third emission areas EMA1, EMA2, and EMA3. For example, the bank BNK may be a structure which defines the respective emission areas EMA of adjacent sub-pixels SPXL. The bank BNK may define a supply position of light emitting elements LD during a process of supplying (or inputting) the light emitting elements LD to each sub-pixel SPXL. For example, because the emission area EMA of each sub-pixel SPXL is defined (or partitioned) by the bank BNK, a mixed solution (e.g., ink) including a target amount and/or type of light emitting elements LD may be supplied (or inputted) to the corresponding emission area EMA.

In one or more embodiments, the bank BNK may include at least one light shielding material and/or reflective material (or scattering material), thus preventing a light leakage defect in which light (or rays) leaks between adjacent sub-pixels SPXL. In one or more embodiments, the bank BNK may include transparent material (or substance). The transparent material may include, for example, polyamides resin, polyimides resin, and the like, but embodiments of the present disclosure are not limited thereto. In one or more embodiments, in order to enhance the efficiency of light emitted from each sub-pixel SPXL, a separate reflective material layer may be provided and/or formed on the bank BNK.

The bank BNK may include, in the pixel area PXA, opening areas that expose components disposed thereunder. In one or more embodiments, the first to third emission areas EMA1, EMA2, and EMA3 may be respectively defined by the opening areas of the bank BNK. The first to third emission areas EMA1, EMA2, and EMA3 may respectively correspond to the opening areas of the bank BNK.

Because the bank BNK is disposed in the non-emission area NEA between the first to third emission areas EMA1, EMA2, and EMA3, a supply (or input) area of the pixel area PXA to which light emitting elements LD are to be supplied (or input) may be determined. Hence, at the step of supplying light emitting elements LD to the pixel PXL, the light emitting elements LD may be prevented from being supplied to undesired areas, and the light emitting elements LD may be efficiently supplied to each of the first to third emission areas EMA1, EMA2, and EMA3. Hence, the light emitting elements LD may be prevented from being unnecessarily wasted. The manufacturing cost of the display device DD may be reduced.

Each of the first, second, and third emission components EMU1, EMU2, and EMU3 may include electrodes ELT, light emitting elements LD which are electrically connected to the electrodes ELT, and alignment electrodes ALE provided at positions corresponding to the electrodes ELT. For example, each of the first, second, and third emission components EMU1, EMU2, and EMU3, includes a first electrode ELT1 (or a first pixel electrode), a second electrode ELT2 (or a first bridge electrode), a third electrode ELT3 (or a second bridge electrode), a fourth electrode ELT4 (or a third bridge electrode), a fifth electrode ELT5 (or a second pixel electrode), light emitting elements LD, and first and second alignment electrodes ALE1 and ALE2. The number, shape, size, arrangement structure, and the like of the electrodes ELT and/or the alignment electrodes ALE may be changed in various ways depending on the structures of the first, second, and third sub-pixels SPXL1, SPXL2, and SPXL3 (particularly, the first, second, and third emission components EMU1, EMU2, and EMU3).

In one or more embodiments, based on one surface of the substrate SUB on which the first, second, and third sub-pixels SPXL1, SPXL2, and SPXL3 are provided (or located), the alignment electrodes ALE, the light emitting elements LD, and the electrodes ELT may be provided in the order listed, but embodiments of the present disclosure are not limited thereto. In one or more embodiments, the positions and formation sequence of electrodes that form the first, second, and third sub-pixels SPXL1, SPXL2, and SPXL3 (or the first, second, and third emission components EMU1, EMU2, and EMU3) may be changed in various ways.

The alignment electrodes ALE may include the first alignment electrode ALE1 and the second alignment electrode ALE2 that are spaced from each other in the first direction DR1. In one or more embodiments, the first alignment electrode ALE1 and the second alignment electrode ALE2 may extend in the second direction DR2. In at least each of the first, second, and third emission areas EMA1, EMA2, EMA3, the first and second alignment electrodes ALE1 and ALE2 may be arranged in a sequence of the second alignment electrode ALE2, the first alignment electrode ALE1, and the second alignment electrode ALE2 along the first direction DR1. Each of the first alignment electrode ALE1 and the second alignment electrode ALE2 may have a bar-like shape that extends in the second direction DR2 and has a certain width in the first direction DR1, but embodiments of the present disclosure are not limited thereto.

The alignment electrodes ALE each may receive a certain alignment signal before the light emitting elements LD are aligned in each of the first, second, and third emission areas EMA1, EMA2, and EMA3, and thus may be used as an electrode (or an alignment line) for aligning the light emitting elements LD. At the step of aligning the light emitting elements LD, the first alignment electrode ALE1 may receive a first alignment signal, and the second alignment electrode ALE2 may receive a second alignment signal.

The above-mentioned first and second alignment signals may be signals each having a voltage difference and/or a phase difference enabling the light emitting elements LD to be aligned between the first and second alignment electrodes ALE1 and ALE2. At least one of the first and second alignment signals may be an AC signal, but embodiments of the present disclosure are not limited thereto.

In one or more embodiments, the first alignment electrode ALE1 may be electrically connected to the first power line PL1 through a first via hole (refer to "VIH1" of FIG. 12) so that, at the step of driving the light emitting elements LD, the first alignment electrode ALE1 may be supplied with the voltage of the first driving power supply VDD from the first power line PL1. The second alignment electrode ALE2 may be electrically connected to the second power line PL2 through a second via hole VIH2 (e.g., see FIG. 12) so that, at the step of driving the light emitting elements LD, the second alignment electrode ALE2 may be supplied with the voltage of the second driving power supply VSS from the second power line PL2.

The first and second alignment electrodes ALE1 and ALE2 may be arranged in common in adjacent sub-pixels SPXL in the second direction DR2. In other words, the sub-pixels SPXL may share the first and second alignment electrodes ALE1 and ALE2. Here, embodiments of the present disclosure are not limited thereto. In one or more embodiments, a portion of the first alignment electrode ALE1 may be removed. The first and second alignment electrodes ALE1 and ALE2 may be formed of the fourth conductive layer C4.

Bank patterns BNP may be disposed under the first alignment electrode ALE1 and the second alignment electrode ALE2 to change the surface profiles (or the shapes) of the first and second alignment electrodes ALE1 and ALE2 such that light emitted from the light emitting elements LD may be guided in an image display direction of the display device DD (or the display panel DP). The bank patterns BNP may be a support component for supporting each of the first and second alignment electrodes ALE1 and ALE2.

The bank patterns BNP may be provided and/or formed on the pixel circuit layer PCL. For example, the bank patterns BNP may be provided and/or formed on the via layer VIA of the pixel circuit layer PCL. The bank patterns BNP each may be formed of a separate pattern that is individually disposed under each of the first and second alignment electrodes ALE1 and ALE2 such that the separate pattern overlaps a portion of a corresponding one of the first and second alignment electrodes ALE1 and ALE2. In one or more embodiments, the bank patterns BNP may be formed of an integrated pattern that has openings or recesses corresponding to areas between the first and second alignment electrodes ALE1 and ALE2 in each of the first, second, and third emission areas EMA1, EMA2, and EMA3 and is generally integrally formed in the display area DA.

Because the bank patterns BNP are provided under respective partial areas of the alignment electrodes ALE, the respective partial areas of the alignment electrodes ALE may protrude in an upward direction of the pixel PXL, i.e., in the third direction DR3, in the areas where the respective bank patterns BNP are formed.

The bank patterns BNP each may be an inorganic insulating layer including inorganic material or an organic insulating layer including organic material. In one or more embodiments, the bank patterns BNP each may include an organic layer having a single layer structure and/or an inorganic layer having a single layer structure, but embodiments of the present disclosure are not limited thereto. In one or more embodiments, the bank patterns BNP may be provided in the form of a multilayer structure formed by stacking at least one organic insulating layer and at least one inorganic insulating layer. However, the material of the bank patterns BNP is not limited to the foregoing embodiment. In one or more embodiments, the bank patterns BNP may include conductive material (or conductive substance). The shape of the bank patterns BNP may be changed in various ways within a range in which efficiency of light emitted from the light emitting element LD may be enhanced.

The first alignment electrode ALE1 and the second alignment electrode ALE2 each may be formed of material having a reflectivity (or a certain reflectivity) to allow light emitted from the light emitting elements LD to travel in an image display direction of the display device DD. For example, the first alignment electrode ALE1 and the second alignment electrode ALE2 each may be formed of conductive material (or substance). The conductive material may include opaque metal that is suitable for reflecting, in the image display direction (or an upward direction of the display element layer DPL) of the display device DD, light emitted from the light emitting elements LD. For example, the opaque metal may include metal such as silver (Ag), magnesium (Mg), aluminum (Al), platinum (Pt), palladium (Pd), gold (Au), nickel (Ni), neodymium (Nd), iridium (Ir), chrome (Cr), titanium (Ti), and an alloy thereof. However, the material of the first alignment electrode ALE1 and the second alignment electrode ALE2 are not limited to the foregoing embodiment. In one or more embodiments, the first alignment electrode ALE1 and the second alignment electrode ALE2 each may include transparent conductive material (or substance). The transparent conductive material (or substance) may include transparent conductive oxides such as indium tin oxide (ITO), indium zinc oxide (IZO), zinc oxide (ZnOx), indium gallium zinc oxide (IGZO), and indium tin zinc oxide (ITZO), and a conductive polymer such as PEDOT (poly(3,4-ethylenedioxythiophene)). In case that the first alignment electrode ALE1 and the second alignment electrode ALE2 each include transparent conductive material (or substance), a separate conductive layer formed of opaque metal for reflecting light emitted from the light emitting elements LD in the image display direction of the display device DD may be added. However, the material of the first alignment electrode ALE1 and the second alignment electrode ALE2 is not limited to the foregoing materials.

Although the first alignment electrode ALE1 and the second alignment electrode ALE2 each may be provided and/or formed in the form of a single layer structure, embodiments of the present disclosure are not limited thereto. In one or more embodiments, the first alignment electrode ALE1 and the second alignment electrode ALE2 each may be provided and/or formed to have a multilayer structure formed by stacking at least two materials from among metals, alloys, conductive oxide, and conductive polymers. The first alignment electrode ALE1 and the second alignment electrode ALE2 each may be provided in the form of a multilayer structure including at least double layers to reduce or minimize a distortion due to a signal delay when signals are transmitted to the opposite ends (e.g., the first and second ends EP1 and EP2) of the light emitting elements LD.

In case that the bank patterns BNP and/or the alignment electrodes ALE include reflective material, a reflective wall structure may be formed around the light emitting elements LD. Hence, light emitted from the light emitting elements LD may be emitted in the upward direction of each pixel PXL (e.g., in a frontal direction of the display panel DP including a predetermined viewing angle range), so that the light output efficiency of the display device DD (or the display panel DP) may be improved.

Hereinafter, the configuration of the first sub-pixel SPXL1 will be described based on FIG. 9. For the convenience sake, repetitive explanation of the same configuration as that described above will be omitted.

Although at least two to several tens of light emitting elements LD may be aligned and/or disposed in the first emission area EMA1 of the first sub-pixel SPXL1, the number of light emitting elements LD is not limited thereto. In one or more embodiments, the number of light emitting elements LD aligned and/or disposed in the first emission area EMA1 may be changed in various ways.

The light emitting elements LD each may be disposed or located between the first alignment electrode ALE1 and the second alignment electrode ALE2. In a plan view, each of the light emitting elements LD may include a first end EP1 and a second end EP2 that are located on respective opposite ends of the light emitting element LD in the longitudinal direction thereof, e.g., in the first direction DR1 (e.g., a first end EP1 and a second end EP2 of a light emitting elements LD may be opposite each other). In one or more embodiments, the second semiconductor layer (refer to "13" of FIG. 1) including a p-type semiconductor layer may be disposed or located on the first end EP1 (or the p-type end), and the first semiconductor layer (refer to "1 1" of FIG. 1) including an n-type semiconductor layer may be disposed or located on the second end EP2 (or the n-type end).

The light emitting elements LD may be disposed at positions spaced from each other and aligned in substantially parallel to each other. A distance by which the light emitting elements LD are spaced from each other is not particularly limited. In one or more embodiments, a plurality of light emitting elements LD may be disposed adjacent to each other to form a group, and another plurality of light emitting elements LD may be spaced from each other at regular intervals to form a group. The light emitting elements LD may be aligned in one direction with an uneven density.

Each of the light emitting elements LD may emit any one light of color light and/or white light. Each of the light emitting elements LD may be aligned between the first alignment electrode ALE1 and the second alignment electrode ALE2 such that the longitudinal direction thereof is parallel to the first direction DR1. The light emitting elements LD may be provided in a diffused form in ink, and may be supplied (or inputted) to the first emission area EMA1. The light emitting elements LD may be input (or supplied) to the first emission area EMA1 by an inkjet printing scheme, a slit coating scheme, or other various schemes. For example, the light emitting elements LD may be mixed with a volatile solvent and then input (or supplied) to the first emission area EMA1 by an inkjet printing scheme or a slit coating scheme. Here, if the first alignment electrode ALE1 and the second alignment electrode ALE2 are respectively supplied with corresponding alignment signals, an electric field may be formed between the second alignment electrode ALE2 and the first alignment electrode ALE1. The light emitting elements LD may be aligned in a desired area by the electric field. After the light emitting elements LD are aligned, the solvent may be removed by a volatilization scheme or other schemes. In this way, the light emitting elements LD each having a longitudinal direction parallel to the first direction DR1 may be reliably aligned between the alignment electrodes ALE.

In one or more embodiments, the light emitting elements LD may include a first light emitting element LD1, a second light emitting element LD2, a third light emitting element LD3, and a fourth light emitting element LD4.

The first light emitting element LD1 may be aligned between a left upper end area of the first alignment electrode ALE1 and the second alignment electrode ALE2 and electrically connected to the first electrode ELT1 and the second electrode ELT2. The first light emitting element LD1 may include a first end EP1 which is disposed adjacent to the first alignment electrode ALE1, and a second end EP2 which is disposed adjacent to the second alignment electrode ALE2. The first end EP1 of the first light emitting element LD1 may be electrically connected to the first electrode ELT1. The second end EP2 of the first light emitting element LD1 may be electrically connected to the second electrode ELT2.

The second light emitting element LD2 may be aligned between a left lower end area of the first alignment electrode ALE1 and the second alignment electrode ALE2 and electrically connected to the second electrode ELT2 and the third electrode ELT3. The second light emitting element LD2 may include a first end EP1 which is disposed adjacent to the first alignment electrode ALE1, and a second end EP2 which is disposed adjacent to the second alignment electrode ALE2. The first end EP1 of the second light emitting element LD2 may be electrically connected to the second electrode ELT2. The second end EP2 of the second light emitting element LD2 may be electrically connected to the third electrode ELT3.

The third light emitting element LD3 may be aligned between a right lower end area of the first alignment electrode ALE1 and the second alignment electrode ALE2 and electrically connected to the third electrode ELT3 and the fourth electrode ELT4. The third light emitting element LD3 may include a first end EP1 which is disposed adjacent to the first alignment electrode ALE1, and a second end EP2 which is disposed adjacent to the second alignment electrode ALE2. The first end EP1 of the third light emitting element LD3 may be electrically connected to the third electrode ELT3. The second end EP2 of the third light emitting element LD3 may be electrically connected to the fourth electrode ELT4.

The fourth light emitting element LD4 may be aligned between a right upper end area of the first alignment electrode ALE1 and the second alignment electrode ALE2 and electrically connected to the fourth electrode ELT4 and the fifth electrode ELT5. The fourth light emitting element LD4 may include a first end EP1 which is disposed adjacent to the first alignment electrode ALE1, and a second end EP2 which is disposed adjacent to the second alignment electrode ALE2. The first end EP1 of the fourth light emitting element LD4 may be electrically connected to the fourth electrode ELT4. The second end EP2 of the fourth light emitting element LD4 may be electrically connected to the fifth electrode ELT5.

As described above, the first end EP1 of each of the first, second, third, and fourth light emitting elements LD1, LD2, LD3, and LD4 may be disposed adjacent to the corresponding first alignment electrode ALE1. The second end EP2 of each of the first, second, third, and fourth light emitting elements LD1, LD2, LD3, and LD4 may be disposed adjacent to the corresponding second alignment electrode ALE2.

In a plan view, the first light emitting element LD1 may be disposed in a left upper end area of the first emission area EMA1, the second light emitting element LD2 may be disposed in a left lower end area of the first emission area EMA1, the third light emitting element LD3 may be disposed in a right lower end area of the first emission area EMA1, and the fourth light emitting element LD4 may be disposed in a right upper end area of the first emission area EMA1. Here, the arrangement and/or connection structure of the light emitting elements LD may be changed in various ways depending on the structure of the first emission component EMU1 and/or the number of series stages.

Each of the first, second, third, and fourth light emitting elements LD1, LD2, LD3, and LD4 may be formed of a light emitting diode which is made of material having an inorganic crystal structure and has a subminiature size, e.g., ranging from the nano scale (or the nanometer scale) to the micro scale (or the micrometer scale).

The electrodes ELT may be provided in at least the first emission area EMA1, and each may be provided at a position corresponding to at least one alignment electrode ALE and the light emitting elements LD. For example, the electrodes ELT may be formed on the alignment electrodes ALE and/or the light emitting elements LD in such a way that each of the electrodes ELT overlaps the corresponding alignment electrodes ALE and/or the corresponding light emitting elements LD, whereby the electrodes ELT may be electrically connected to the light emitting elements LD.

The first electrode ELT1 (or the first pixel electrode) may be disposed on a first area (e.g., the left upper end area) of the first alignment electrode ALE1 and the first ends EP1 of the first light emitting elements LD1, and thus electrically connected to the first ends EP1 of the first light emitting elements LD1. The first electrode ELT1 may be formed of the fifth conductive layer C5.

The second electrode ELT2 may be disposed both on a first area (e.g., an upper end area) of the second alignment electrode ALE2 that opposes the first area of the first alignment electrode ALE1 and on the second ends EP2 of the first light emitting elements LD1, and thus electrically connected to the second ends EP2 of the first light emitting elements LD1. Furthermore, the second electrode ELT2 may be disposed on a second area (e.g., the left lower end area) of the first alignment electrode ALE1 and the first ends EP1 of the second light emitting elements LD2, and thus electrically connected to the first ends EP1 of the second light emitting elements LD2. For example, the second electrode ELT2 may be a first bridge electrode which electrically connects the second ends EP2 of the first light emitting elements LD1 and the first ends EP1 of the second light emitting elements LD2 to each other in the first emission area EMA1. To this end, the second electrode ELT2 may have a bent shape. For example, the second electrode ELT2 may have a bent or curved structure on a boundary between an area where at least one first light emitting element LD1 is disposed and an area where at least one second light emitting element LD2 is disposed. The second electrode ELT2 may be formed of the sixth conductive layer C6.

The third electrode ELT3 may be disposed on a second area (e.g., a lower end area) of the second alignment electrode ALE2 and the second ends EP2 of the second light emitting elements LD2, and thus electrically connected to the second ends EP2 of the second light emitting elements LD2. Furthermore, the third electrode ELT3 may be disposed on a third area (e.g., the right lower end area) of the first alignment electrode ALE1 and the first ends EP1 of the third light emitting elements LD3, and thus electrically connected to the first ends EP1 of the third light emitting elements LD3. For example, the third electrode ELT3 may electrically connect the second ends EP2 of the second light emitting elements LD2 and the first ends EP1 of the third light emitting elements LD3 to each other in the first emission area EMA1. To this end, the third electrode ELT3 may have a bent shape. For example, the third electrode ELT3 may have a bent or curved structure on a boundary between an area where at least one second light emitting element LD2 is disposed and an area where at least one third light emitting element LD3 is disposed. The third electrode ELT3 may be formed of the fifth conductive layer C5.

The fourth electrode ELT4 may be disposed both on the second area (e.g., the lower end area) of the second alignment electrode ALE2 that opposes the third area of the first alignment electrode ALE1 and on the second ends EP2 of the third light emitting elements LD3, and thus electrically connected to the second ends EP2 of the third light emitting elements LD3. Furthermore, the fourth electrode ELT4 may be disposed on a fourth area (e.g., the right upper end area) of the first alignment electrode ALE1 and the first ends EP1 of the fourth light emitting elements LD4, and thus electrically connected to the first ends EP1 of the fourth light emitting elements LD4. For example, the fourth electrode ELT4 may electrically connect the second ends EP2 of the third light emitting elements LD3 and the first ends EP1 of the fourth light emitting elements LD4 to each other in the first emission area EMA1. To this end, the fourth electrode ELT4 may have a bent shape. For example, the fourth electrode ELT4 may have a bent or curved structure on a boundary between an area where at least one third light emitting element LD3 is disposed and an area where at least one fourth light emitting element LD4 is disposed. The fourth electrode ELT4 may be formed of the sixth conductive layer C6.

The fifth electrode ELT5 may be disposed on the first area (e.g., the upper end area) of the second alignment electrode ALE2 and the second ends EP2 of the fourth light emitting elements LD4, and thus electrically connected to the second ends EP2 of the fourth light emitting elements LD4. The fifth electrode ELT5 may be formed of the fifth conductive layer C5.

In this way, the light emitting elements LD aligned between the alignment electrodes ALE may be connected in a desired form by using the electrodes ELT. For example, the first light emitting elements LD1, the second light emitting elements LD2, the third light emitting elements LD3, and the fourth light emitting elements LD4 may be successively electrically connected in series by using the electrodes ELT.

In one or more embodiments, the first electrode ELT1 of the first sub-pixel SPXL1 may be electrically connected to the first contact electrode CNE1 through the first contactor CNT1. The first electrode ELT1 of the second sub-pixel SPXL2 may be electrically connected to the second contact electrode CNE2 through the second contactor CNT2. The first electrode ELT1 of the third sub-pixel SPXL3 may be electrically connected to the third contact electrode CNE3 through the third contactor CNT3. The electrodes ELT of each of the first, second, and third sub-pixels SPXL1, SPXL2, and SPXL3 may be driving electrodes provided to drive the light emitting elements LD disposed in the emission area EMA of the corresponding sub-pixel SPXL.

The first sub-pixel SPXL1 (or the first emission component EMU1) may further include sub-electrodes SLT that are electrically connected to the electrodes ELT. The sub-electrodes SLT may include first, second, third, and fourth sub-electrodes SLT1, SLT2, SLT3, and SLT4. In one or more embodiments, the first sub-electrode SLT1 may be electrically connected to the second electrode ELT2. The second sub-electrode SLT2 may be electrically connected to the third electrode ELT3. The third sub-electrode SLT3 may be electrically connected to the fourth electrode ELT4. The fourth sub-electrode SLT4 may be electrically connected to the fifth electrode ELT5.

The first sub-electrode SLT1 may be formed of the sixth conductive layer C6. The second sub-electrode SLT2 may be formed of the fifth conductive layer C5. The third sub-electrode SLT3 may be formed of the sixth conductive layer C6. The fourth sub-electrode SLT4 may be formed of the fifth conductive layer C5.

The first sub-electrode SLT1 may be integrally provided with the second electrode ELT2. The second sub-electrode SLT2 may be integrally provided with the third electrode ELT3. The third sub-electrode SLT3 may be integrally provided with the fourth electrode ELT4. The fourth sub-electrode SLT4 may be integrally provided with the fifth electrode ELT5. However, embodiments of the present disclosure are not limited thereto.

Each of the first, second, third, and fourth sub-electrodes SLT1, SLT2, SLT3, and SLT4 may be electrically connected to the corresponding electrode ELT by connectors CN1 and CN2. For example, a first end of each of the first, second, third, and fourth sub-electrodes SLT1, SLT2, SLT3, and SLT4 may be electrically connected to the corresponding electrode ELT by the first connector CN1, and a second end thereof may be electrically connected to the corresponding electrode ELT by the second connector CN2. For example, the first connector CN1 and/or the second connector CN2 may be integrally provided with the sub-electrodes SLT and/or the electrodes ELT and disposed at the same layer as that of the sub-electrodes SLT and/or the electrodes ELT, but embodiments of the present disclosure are not limited thereto.

The sub-electrodes SLT may extend in the second direction DR2 and may be spaced from the electrodes ELT in the first direction DR1. The first connector CN1 and/or the second connector CN2 may extend in the first direction DR1 between the sub-electrodes SLT and the electrodes ELT. As such, in the case in which the sub-electrodes SLT that are electrically connected with the electrodes ELT are provided, a dark spot defect of the first sub-pixel SPXL1 (or the pixel PXL) may be mitigated. In one or more embodiments, the sub-electrodes SLT may be disposed over the bank BNK, and may overlap the bank BNK. For example, each of the first, second, third, and fourth sub-electrodes SLT1, SLT2, SLT3, and SLT4 may be disposed over the bank BNK, and may overlap the bank BNK in a plan view.

At least one of the sub-electrodes SLT of the first sub-pixel SPXL1 may be electrically connected with at least one of the sub-electrodes SLT of an adjacent sub-pixel SPXL. For example, the fourth sub-electrode SLT4 of the first sub-pixel SPXL1 may be electrically connected to the fourth sub-electrode SLT4 of the second sub-pixel SPXL2.

In one or more embodiments, at least one of the sub-electrodes SLT of the sub-pixel SPXL may be electrically connected with at least one of the sub-electrodes SLT of an adjacent sub-pixel SPXL by an intermediate electrode IE. For example, the fourth sub-electrode SLT4 of the first sub-pixel SPXL1 may be electrically connected to the fourth sub-electrode SLT4 of the second sub-pixel SPXL2 by the intermediate electrode IE.

The intermediate electrode IE may be disposed on a boundary between adjacent sub-pixels SPXL or in space therebetween, e.g., in the non-emission area NEA, and may be connected to at least one of the sub-electrodes SLT of each of the adjacent sub-pixels SPXL. The intermediate electrode IE may be integrally provided with at least one of the sub-electrodes SLT of the sub-pixels SPXL and disposed at the same layer as that of the at least one, but embodiments of the present disclosure are not limited thereto.

The fourth sub-electrode SLT4 of the first sub-pixel SPXL1 may be spaced from the fourth sub-electrode SLT4 of the second sub-pixel SPXL2. The fourth sub-electrode SLT4 of the first sub-pixel SPXL1 and the fourth sub-electrode SLT4 of the second sub-pixel SPXL2 may be electrically connected to each other by the intermediate electrode IE. The intermediate electrode IE may be integrally provided with the fourth sub-electrode SLT4 of the first sub-pixel SPXL1 and/or the fourth sub-electrode SLT4 of the second sub-pixel SPXL2 and disposed at a layer identical thereto, but embodiments of the present disclosure are not limited thereto.

Although FIG. 8 illustrates the case where the sub-electrodes SLT of the third sub-pixel SPXL3 are separated from the sub-electrodes SLT of the first sub-pixel SPXL1 and/or the sub-electrodes SLT of the second sub-pixel SPXL2, embodiments of the present disclosure are not limited thereto. In one or more embodiments, at least one of the sub-electrodes SLT of the third sub-pixel SPXL3 may be electrically connected to at least one of the sub-electrodes SLT of the first sub-pixel SPXL1 and/or the sub-electrodes SLT of the second sub-pixel SPXL2.

A bridge line BRL may be disposed between adjacent sub-pixels SPXL (or the pixels PXL) provided on different pixel rows. The bridge line BRL may extend in the first direction DR1, and may be electrically connected with at least one of the electrodes ELT of each of the first, second, and third sub-pixels SPXL1, SPXL2, and SPXL3. The bridge line BRL may be formed of the fifth conductive layer C5. The bridge line BRL may be electrically connected to the second power line PL2 through a third via hole (refer to "VIH3" of FIG. 12), and may be supplied with the voltage of the second driving power supply VSS.

In one or more embodiments, the fifth electrode ELT5 of each of the first, second, and third sub-pixels SPXL1, SPXL2, and SPXL3 may be electrically connected with the bridge line BRL. The fifth electrode ELT5 of each of the first, second, and third sub-pixels SPXL1, SPXL2, and SPXL3 may be integrally formed with the bridge line BRL, and may diverge from the bridge line BRL and extend in the second direction DR2. The bridge line BRL and the fifth electrode ELT5 of each of the first, second, and third sub-pixels SPXL1, SPXL2, and SPXL3 may have mesh structures. Because the bridge line BRL and the fifth electrode ELT5 of each of the first, second, and third sub-pixels SPXL1, SPXL2, and SPXL3 are electrically connected to each other, the fifth electrode ELT5 of the first sub-pixel SPXL1, the fifth electrode ELT5 of the second sub-pixel SPXL2, and the fifth electrode ELT5 of the third sub-pixel SPXL3 may be electrically connected to each other.

The fifth electrode ELT5 of the first sub-pixel SPXL1 may extend in the second direction DR2, and may be electrically connected to the bridge line BRL that is located on an upper end of the first sub-pixel SPXL1. The fifth electrode ELT5 of the second sub-pixel SPXL2 may extend in a direction opposite to the second direction DR2, and may be electrically connected to the bridge line BRL that is located on a lower end of the second sub-pixel SPXL2. The fifth electrode ELT5 of the third sub-pixel SPXL3 may extend in the second direction DR2, and may be electrically connected to the bridge line BRL that is located on an upper end of the third sub-pixel SPXL3. However, a connection relationship between the electrodes ELT of each sub-pixel SPXL and the bridge line BRL is not limited thereto. The connection structure of the electrodes ELT and the bridge line BRL may be changed in various ways within a range in which the electrodes ELT and the bridge line BRL may form a mesh structure.

As described above, in the case in which, from among the electrodes ELT of adjacent sub-pixels SPXL, the fifth electrodes ELT5 that are cathode electrodes are connected to each other and connected with the bridge line BRL to form a mesh structure, the number of contacts on the bridge line BRL may be reduced so that design space may be secured in the display device DD having a high resolution, a resistance increase risk may be reduced, and electrostatic discharge may be improved.

In one or more embodiments, a plurality of openings OPN that exposes partial areas of the first alignment electrodes ALE1 may be located in the non-emission area NEA of the pixel PXL. In the case where a bright spot defect occurs in at least one sub-pixel SPXL of the first, second, and third sub-pixels SPXL1, SPXL2, and SPXL3 and the corresponding sub-pixel SPXL is required to be repaired, the openings OPN may be provided to remove an exposed portion of the corresponding first alignment electrode ALE1. In at least one of the openings OPN, a dummy pattern DMP may be located on the exposed portion of the corresponding first alignment electrodes ALE1. The dummy pattern DMP may be formed of the sixth conductive layer C6, and may be formed through a process substantially similar or identical to that of the second and fourth electrodes ELT2 and ELT4 of each of the first, second, and third sub-pixels SPXL1, SPXL2, and SPXL3 and provided on a layer substantially similar or identical to the second and fourth electrodes ELT2 and ELT4. Detailed description of the openings OPN will be described with reference to FIGS. 12 to 17.

In accordance with the foregoing embodiment, the first contact electrode CNE1 of the first pixel circuit SPXC1 and the first electrode ELT1 of the first emission component EMU1 may directly contact each other through the first contactor CNT1 and thus may be electrically connected to each other. The second contact electrode CNE2 of the second pixel circuit SPXC2 and the first electrode ELT1 of the second emission component EMU2 may directly contact each other through the second contactor CNT2 and thus may be electrically connected to each other. The third contact electrode CNE3 of the third pixel circuit SPXC3 and the first electrode ELT1 of the third emission component EMU3 may directly contact each other through the third contactor CNT3 and thus may be electrically connected to each other. Hence, the light emitting elements LD of each of the first, second, and third sub-pixels SPXL1, SPXL2, and SPXL3 may be aligned in the emission area EMA of the corresponding sub-pixel SPXL and then may be driven by the contact electrode CNE and the first electrode ELT1 that are electrically connected thereto. In this case, the alignment electrodes ALE may be used as only alignment lines for aligning the light emitting elements LD without being involved in the operation of driving the light emitting elements LD. Therefore, after the process of aligning the light emitting elements LD has been performed, some of the alignment electrodes ALE may be cut off, so that an electrode separation process for individually driving the sub-pixels SPXL (or the pixels PXL) that are adjacent to each other in the second direction DR2 may be omitted, and an electrode separation area for the electrode separation process may also be omitted, whereby the surface area of the emission area EMA of each sub-pixel SPXL (or each pixel PXL) may be increased.

Hereinafter, a cross-sectional structure of the first sub-pixel SPXL1 will be described in detail with reference to FIG. 10.

The first sub-pixel SPXL1 may include a display component LEL configured of the substrate SUB, the pixel circuit layer PCL, and the display element layer DPL.

The pixel circuit layer PCL and the display element layer DPL may be disposed on one surface of the substrate SUB and overlap each other. For example, the pixel area PXA of the substrate SUB may include the pixel circuit layer PCL disposed on one surface of the substrate SUB, and the display element layer DPL disposed on the pixel circuit layer PCL. The pixel circuit layer PCL may include a buffer layer BFL, a gate insulating layer GI, an interlayer insulating layer ILD, a passivation layer PSV, and a via layer VIA that are successively stacked on the substrate SUB.

The display element layer DPL may include bank patterns BNP, first and second alignment electrodes ALE1 and ALE2, light emitting elements LD, electrodes ELT, and/or sub-electrodes SLT.

The bank patterns BNP may be provided and/or formed on the pixel circuit layer PCL, for example, the via layer VIA. The bank patterns BNP each may be an inorganic insulating layer including inorganic material or an organic insulating layer including organic material. In one or more embodiments, the bank patterns BNP each may include an organic layer having a single layer structure and/or an inorganic layer having a single layer structure, but embodiments of the present disclosure are not limited thereto. In one or more embodiments, the bank patterns BNP may be provided in the form of a multilayer structure formed by stacking at least one organic insulating layer and at least one inorganic insulating layer. However, the material of the bank patterns BNP is not limited to the foregoing embodiment. In one or more embodiments, the bank patterns BNP may include conductive material (or conductive substance). The shape of the bank patterns BNP may be changed in various ways within a range in which efficiency of light emitted from the light emitting element LD may be enhanced.

The bank patterns BNP each may be used as a reflector. For example, the bank patterns BNP, along with the first alignment electrode ALE1 and the second alignment electrode ALE2 disposed thereover, may be used as a reflector that guides light emitted from the light emitting element LD in a desired direction so that the light output efficiency of each of the first, second, and third sub-pixels SPXL1, SPXL2, and SPXL3 may be enhanced.

The first alignment electrode ALE1 and the second alignment electrode ALE2 may be provided and/or formed on the bank patterns BNP.

The first alignment electrode ALE1 and the second alignment electrode ALE2 may be provided and/or formed on the pixel circuit layer PCL (or the via layer VIA) and the bank patterns BNP.

The first alignment electrode ALE1 and the second alignment electrode ALE2 may be disposed at the same plane, and have substantially the same thickness (or the same thickness) in the third direction DR3. The first alignment electrode ALE1 and the second alignment electrode ALE2 may be concurrently (e.g., simultaneously) formed through the same process, or may be successively formed.

The first alignment electrode ALE1 and the second alignment electrode ALE2 each may have a shape corresponding to a profile of the bank pattern BNP disposed thereunder.

In case that the first alignment electrode ALE1 and the second alignment electrode ALE2 each are formed of conductive material having a reflectivity, light emitted from the opposite ends EP1 and EP2 of each of the light emitting elements LD may more reliably travel in the image display direction (e.g., the third direction DR3) of the display device DD. For example, if the first alignment electrode ALE1 and the second alignment electrode ALE2 have inclined surfaces or curved surfaces that correspond to the shapes of the bank patterns BNP and are disposed to oppose the opposite ends EP1 and EP2 of each of the light emitting elements LD, light emitted from the opposite ends EP1 and EP2 of each of the light emitting elements LD may be reflected by the first alignment electrode ALE1 and the second alignment electrode ALE2 and more reliably travel in the image display direction (e.g., the third direction DR3) of the display device DD. Consequently, the efficiency of light emitted from the light emitting elements LD may be enhanced.

The first insulating layer INS1 may be disposed on the first and second alignment electrodes ALE1 and ALE2.

The first insulating layer INS1 may be provided and/or formed on overall surfaces of the first and second alignment electrodes ALE1 and ALE2. The first insulating layer INS1 may be partially open in at least the non-emission area NEA so that components disposed thereunder may be exposed. For example, the first insulating layer INS1 may be partially open to include, in at least the non-emission area NEA, openings OPN each of which exposes one area of the first alignment electrode ALE1.

The bank BNK may be disposed on the first insulating layer INS1.

The bank BNK may be provided and/or formed on the first insulating layer INS1 in the non-emission area NEA. The bank BNK may enclose the first emission area EMA1 of the first sub-pixel SPXL1.

The light emitting elements LD may be disposed on the first insulating layer INS1. The light emitting elements LD may be disposed on the first insulating layer INS1 between the alignment electrodes ALE.

For example, the light emitting elements LD may be supplied (or inputted) to the first emission area EMA1 in an inkjet printing scheme or the like. The light emitting elements LD may be aligned on a surface of the first insulating layer INS1 disposed in the area between the first alignment electrode ALE1 and the second alignment electrode ALE2 by an electric field formed by signals (or alignment signals) that are respectively applied to the first alignment electrode ALE1 and the second alignment electrode ALE2. For instance, the light emitting elements LD supplied to the first emission area EMA1 may be arranged such that the first ends EP1 thereof oppose the first alignment electrode ALE1, and the second ends EP2 thereof oppose the second alignment electrode ALE2.

The light emitting elements LD may include a first light emitting element LD1, a second light emitting element LD2, a third light emitting element LD3, and a fourth light emitting element LD4.

The second insulating layer INS2 (or an insulating pattern) may be disposed on each of the first, second, third, and fourth light emitting elements LD1, LD2, LD3, and LD4. The second insulating layer INS2 may be disposed on each of the first, second, third, and fourth light emitting elements LD1, LD2, LD3, and LD4, and partially cover an outer surface (e.g., an outer peripheral or circumferential surface or a surface) of each of the first, second, third, and fourth light emitting elements LD1, LD2, LD3, and LD4, such that the first end EP1 and the second end EP2 of each of the first, second, third, and fourth light emitting elements LD1, LD2, LD3, and LD4 are exposed to the outside.

The second insulating layer INS2 may include an inorganic insulating layer including inorganic material, or an organic insulating layer. For example, the second insulating layer INS2 may include an inorganic insulating layer suitable for protecting the active layer (refer to "12" of FIG. 1) of each of the first, second, third, and fourth light emitting elements LD1, LD2, LD3, and LD4 from external oxygen, water, or the like. However, embodiments of the present disclosure are not limited thereto. The second insulating layer INS2 may be formed of an organic insulating layer including organic material, depending on design conditions and the like of the display device DD (or the display panel DP) to which the first, second, third, and fourth light emitting elements LD1, LD2, LD3, and LD4 are applied. The second insulating layer INS2 may be formed of a single layer or multiple layers.

In case that a gap (or space) is present between the first insulating layer INS1 and the light emitting elements LD before the formation of the second insulating layer INS2, the gap may be filled with the second insulating layer INS2 during a process of forming the second insulating layer INS2.

Because the second insulating layer INS2 is formed on the first, second, third, and fourth light emitting elements LD1, LD2, LD3, and LD4 that have been completely aligned in the first emission area EMA1, the first, second, third, and fourth light emitting elements LD1, LD2, LD3, and LD4 may be prevented from being removed from the aligned positions thereof.

The second insulating layer INS2 may be provided and/or formed on the first insulating layer INS1 in the non-emission area NEA. The second insulating layer INS2 may be partially open in at least the non-emission area NEA so that components disposed thereunder may be exposed. For example, the second insulating layer INS2 may be partially open to include a plurality of through holes TH corresponding to the openings OPN of the first insulating layer INS1.

The electrodes ELT may be formed on the opposite ends of the light emitting elements LD, i.e., the first and second ends EP1 and EP2, which are not covered with the second insulating layer INS2.

The first electrode ELT1 may be directly disposed on the first ends EP1 of the first light emitting elements LD1, and may contact the first ends EP1 of the first light emitting elements LD1.

The second electrode ELT2 may be directly disposed on the second ends EP2 of the first light emitting elements LD1, and may contact the second ends EP2 of the first light emitting elements LD1. Furthermore, the second electrode ELT2 may be directly disposed on the first ends EP1 of the second light emitting elements LD2, and may contact the first ends EP1 of the second light emitting elements LD2. In other words, the second electrode ELT2 may electrically connect the second ends EP2 of the first light emitting elements LD1 with the first ends EP1 of the second light emitting elements LD2.

The third electrode ELT3 may be directly disposed on the second ends EP2 of the second light emitting elements LD2, and may contact the second ends EP2 of the second light emitting elements LD2. Furthermore, the third electrode ELT3 may be directly disposed on the first ends EP1 of the third light emitting elements LD3, and may contact the first ends EP1 of the third light emitting elements LD3. In other words, the third electrode ELT3 may electrically connect the second ends EP2 of the second light emitting elements LD2 with the first ends EP1 of the third light emitting elements LD3.

The fourth electrode ELT4 may be directly disposed on the second ends EP2 of the third light emitting elements LD3, and may contact the second ends EP2 of the third light emitting elements LD3. Furthermore, the fourth electrode ELT4 may be directly disposed on the first ends EP1 of the fourth light emitting elements LD4, and may contact the first ends EP1 of the fourth light emitting elements LD4. In other words, the fourth electrode ELT4 may electrically connect the second ends EP2 of the third light emitting elements LD3 with the first ends EP1 of the fourth light emitting elements LD4.

The fifth electrode ELT5 may be directly disposed on the second ends EP2 of the fourth light emitting elements LD4, and may contact the second ends EP2 of the fourth light emitting elements LD4 and thus may be electrically connected to the second ends EP2 of the fourth light emitting elements LD4.

The first electrode ELT1, the third electrode ELT3, and/or the fifth electrode ELT5 may be formed of the fifth conductive layer C5 disposed on the second insulating layer INS2. The first electrode ELT1, the third electrode ELT3, and/or the fifth electrode ELT5 may be concurrently (e.g., simultaneously) formed through the same process. The second electrode ELT2 and/or the fourth electrode ELT4 may be formed of the sixth conductive layer C6 disposed on the third insulating layer INS3. The second electrode ELT2 and/or the fourth electrode ELT4 may be concurrently (e.g., simultaneously) formed through the same process. The third insulating layer INS3 may be disposed on the first electrode ELT1, the third electrode ELT3, and/or the fifth electrode ELT5. The second electrode ELT2 and/or the fourth electrode ELT4 may be disposed on the third insulating layer INS3.

The third insulating layer INS3 may be disposed on the second insulating layer INS2 in the non-emission area NEA. The third insulating layer INS3 may be partially open in at least the non-emission area NEA so that components disposed thereunder may be exposed. For example, the third insulating layer INS3 may be partially open to include a plurality of contact holes CH corresponding to the openings OPN of the first insulating layer INS1 and the through holes TH of the second insulating layer INS2.

As described above, in case that the third insulating layer INS3 is disposed between the electrodes ELT that are formed of a plurality of conductive layers, the electrodes ELT may be reliably separated from each other by the third insulating layer INS3, so that electrical stability between the first and second ends EP1 and EP2 of the light emitting elements LD may be secured.

The electrodes ELT each may be formed of various transparent conductive materials. For example, the electrodes ELT each may include at least one of various transparent conductive materials including indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO), and may be substantially transparent or translucent to provide satisfactory transmittance. Hence, light emitted from the first and second ends EP1 and EP2 of the light emitting elements LD may pass through the electrodes ELT and then may be emitted out of the display panel DP.

The sub-electrodes SLT may be disposed at the same layer as that of the respective electrodes ELT. The sub-electrodes SLT and the electrodes ELT that are electrically connected to each other, and the connectors CN1 and CN2 that connect the sub-electrodes SLT and the electrodes ELT may be integrally provided and disposed at the same layer.

For example, the first sub-electrode SLT1 may be disposed at the same layer as that of the second electrode ELT2. For example, the first sub-electrode SLT1 and the second electrode ELT2 may be concurrently (e.g., simultaneously) formed through the same process, but embodiments of the present disclosure are not limited thereto. The second sub-electrode SLT2 may be disposed at the same layer as that of the third electrode ELT3. For example, the second sub-electrode SLT2 and the third electrode ELT3 may be concurrently (e.g., simultaneously) formed through the same process, but embodiments of the present disclosure are not limited thereto. The third sub-electrode SLT3 may be disposed at the same layer as that of the fourth electrode ELT4. For example, the third sub-electrode SLT3 and the fourth electrode ELT4 may be concurrently (e.g., simultaneously) formed through the same process, but embodiments of the present disclosure are not limited thereto. Furthermore, the fourth sub-electrode SLT4 may be disposed at the same layer as that of the fifth electrode ELT5. For example, the fourth sub-electrode SLT4 and the fifth electrode ELT5 may be concurrently (e.g., simultaneously) formed through the same process, but embodiments of the present disclosure are not limited thereto.

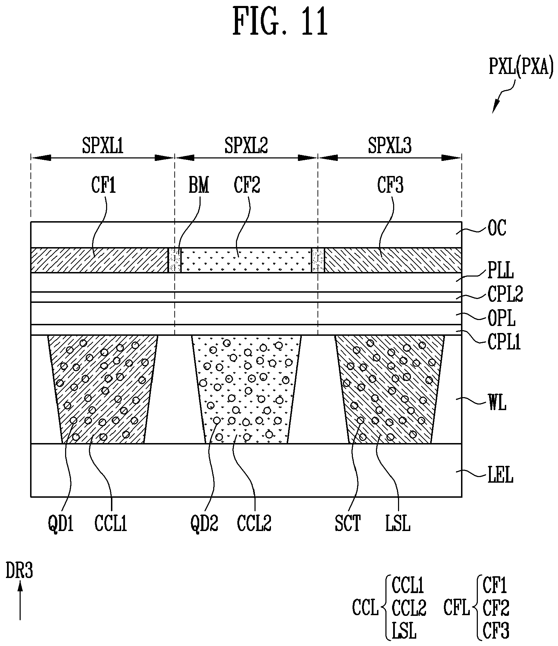

FIG. 11 is a cross-sectional view illustrating first to third sub-pixels SPXL1, SPXL2, and SPXL3 in accordance with one or more embodiments. Particularly, FIG. 11 illustrates an optical layer that includes a partition wall WL, a color conversion layer CCL, a color filter layer CFL, and/or an overcoat layer OC that are provided on the display component LEL of the first sub-pixel SPXL1 described with reference to FIGS. 8 to 10. The optical layer may correspond to the optical layer LCL described with reference to FIG. 4.

Referring to FIGS. 1 to 11, the partition wall WL (e.g., "dam structure" or "wall structure") may be disposed on the display component LEL for the first to third sub-pixels SPXL1, SPXL2, and SPXL3. For example, the partition wall WL may be disposed between the first to third sub-pixels SPXL1, SPXL2, and SPXL3 or on boundaries therebetween, and include openings which respectively overlap the first to third sub-pixels SPXL1, SPXL2, and SPXL3. Each of the openings of the partition wall WL may provide space in which the color conversion layer CCL may be provided.

The partition wall WL may include organic material such as acrylic resin, epoxy resin, phenolic resin, polyamide resin, polyimide resin, polyester resin, polyphenylene sulfide resin, or benzocyclobutene (BCB). However, embodiments of the present disclosure are not limited thereto. The partition wall WL may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

In one or more embodiments, the partition wall WL may include at least one light shielding and/or reflective material. Therefore, a light leakage between adjacent sub-pixels SPXL may be prevented from being caused. For example, the partition wall WL may include at least one black matrix material and/or color filter material. For instance, the partition wall WL may be formed of a black opaque pattern which may block transmission of light. In one or more embodiments, a reflective layer or the like may be formed on a surface (e.g., a sidewall) of the partition wall WL to increase the light efficiency of each sub-pixel SPXL.

The color conversion layer CCL may be disposed on the display component LEL including the light emitting elements LD in the openings of the partition wall WL. The color conversion layer CCL may include a first color conversion layer CCL1 disposed in the first sub-pixel SPXL1, a second color conversion layer CCL2 disposed in the second sub-pixel SPXL2, and a light scattering layer LSL disposed in the third sub-pixel SPXL3.

In one or more embodiments, the first to third sub-pixels SPXL1, SPXL2, and SPXL3 may include light emitting elements LD configured to emit the same color of light. For example, the first to third sub-pixels SPXL1, SPXL2, and SPXL3 may include light emitting elements LD configured to emit the third color of light (or blue light). Because the color conversion layer CCL including color conversion particles is disposed in each of the first to third sub-pixels SPXL1, SPXL2, and SPXL3, a full-color image may be displayed.

The first color conversion layer CCL1 may include first color conversion particles for converting the third color of light emitted from the light emitting element LD to the first color of light. For example, the first color conversion layer CCL1 may include a plurality of first quantum dots QD1 that is diffused in a matrix material such as base resin.

In one or more embodiments, in the case in which the light emitting element LD is a blue light emitting element configured to emit blue light and the first sub-pixel SPXL1 is a red pixel, the first color conversion layer CCL1 may include the first quantum dots QD1 that may convert blue light emitted from the blue light emitting element to red light. The first quantum dots QD1 may absorb blue light, shift the wavelength thereof according to an energy transition, and thus emit red light. In one or more embodiments, in the case in which the first sub-pixel SPXL1 is one of pixels of other colors, the first color conversion layer CCL1 may include the first quantum dots QD1 corresponding to the color of the first sub-pixel SPXL1.

The second color conversion layer CCL2 may include second color conversion particles for converting the third color of light emitted from the light emitting element LD to the second color of light. For example, the second color conversion layer CCL2 may include a plurality of second quantum dots QD2 that is dispersed in a matrix material such as base resin.

In one or more embodiments, in case that the light emitting element LD is a blue light emitting element configured to emit blue light and the second sub-pixel SPXL2 is a green pixel, the second color conversion layer CCL2 may include the second quantum dots QD2 that may convert blue light emitted from the blue light emitting element to green light. The second quantum dots QD2 may absorb blue light, shift the wavelength thereof according to an energy transition, and thus emit green light. In one or more embodiments, in the case in which the second sub-pixel SPXL2 is one of pixels of other colors, the second color conversion layer CCL2 may include the second quantum dots QD2 corresponding to the color of the second sub-pixel SPXL2.

In one or more embodiments, as blue light having a relatively short wavelength in a visible ray area is incident on each of the first quantum dots QD1 and the second quantum dots QD2, absorption coefficients of the first quantum dot QD1 and the second quantum dot QD2 may be increased. Therefore, eventually, the efficiency of light emitted from the first sub-pixel SPXL1 and the second sub-pixel SPXL2 may be enhanced, and satisfactory color reproducibility may be secured. Furthermore, because the emission component EMU for the first to third sub-pixels SPXL1, SPXL2, and SPXL3 is formed of light emitting elements LD (e.g., blue light emitting elements) configured to emit the same color of light, the efficiency of fabricating the display device DD may be enhanced.

The light scattering layer LSL may be provided to efficiently use the third color of light (or blue light) emitted from the light emitting element LD. For example, in the case in which the light emitting element LD is a blue light emitting element configured to emit blue light and the third sub-pixel SPXL3 is a blue pixel, the light scattering layer LSL may include at least one type of light scatterer SCT to efficiently use light emitted from the light emitting element LD.

For example, the light scattering layer LSL may include a plurality of light scatterers SCT that is diffused in a matrix material such as base resin. For instance, the light scattering layer LSL may include light scatterers SCT formed of material such as silica, but the constituent material of the light scatterers SCT is not limited thereto. The light scatterers SCT may not only be provided in the third sub-pixel SPXL3, but may also be selectively included in the first color conversion layer CCL1 or the second color conversion layer CCL2. In one or more embodiments, the light scatterers SCT may be omitted, and the light scattering layer LSL may be formed of transparent polymer.

A first capping layer CPL1 may be disposed on the color conversion layer CCL. The first capping layer CPL1 may be provided over the first to third sub-pixels SPXL1, SPXL2, and SPXL3. The first capping layer CPL1 may cover the color conversion layer CCL. The first capping layer CPL1 may prevent the color conversion layer CCL from being damaged or contaminated by permeation of external impurities such as water or air.

The first capping layer CPL1 may be an inorganic layer, and be formed of silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), or silicon oxynitride (SiOₓN_{y}).

A refractive index conversion layer OPL may be disposed on the first capping layer CPL1. The refractive index conversion layer OPL may function to recycle light provided from the color conversion layer CCL by total reflection and thus enhance light extraction efficiency. Hence, the refractive index conversion layer OPL may have a relatively low refractive index compared to that of the color conversion layer CCL. For example, the refractive index of the color conversion layer CCL may approximately range from 1.6 to 2.0, and the refractive index of the refractive index conversion layer OPL may approximately range from 1.1 to 1.3.

A second capping layer CPL2 may be disposed on the refractive index conversion layer OPL. The second capping layer CPL2 may be provided over the first to third sub-pixels SPXL1, SPXL2, and SPXL3. The second capping layer CPL2 may cover the refractive index conversion layer OPL. The second capping layer CPL2 may prevent the refractive index conversion layer OPL from being damaged or contaminated by permeation of external impurities such as water or air.

The second capping layer CPL2 may be an inorganic layer, and be formed of silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), or silicon oxynitride (SiOₓN_{y}).

A planarization layer PLL may be disposed on the second capping layer CPL2. The planarization layer PLL may be provided over the first to third sub-pixels SPXL1, SPXL2, and SPXL3.

The planarization layer PLL may include organic material such as acrylic resin, epoxy resin, phenolic resin, polyamide resin, polyimide resin, polyester resin, polyphenylene sulfide resin, or benzocyclobutene (BCB). However, embodiments of the present disclosure are not limited thereto. The planarization layer PLL may include various types of inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The color filter layer CFL may be disposed on the planarization layer PLL. The color filter layer CFL may include color filters CF1, CF2, and CF3 corresponding to the colors of the respective sub-pixels SPXL. Because the color filters CF1, CF2, and CF3 corresponding to the respective colors of the first to third sub-pixels SPXL1, SPXL2, and SPXL3 are disposed, a full-color image may be displayed.

The color filter layer CFL may include a first color filter CF1 disposed in the first sub-pixel SPXL1 and configured to allow light emitted from the first sub-pixel SPXL1 to selectively pass therethrough, a second color filter CF2 disposed in the second sub-pixel SPXL2 and configured to allow light emitted from the second sub-pixel SPXL2 to selectively pass therethrough, and a third color filter CF3 disposed in the third sub-pixel SPXL3 and configured to allow light emitted from the third sub-pixel SPXL3 to selectively pass therethrough.

In one or more embodiments, the first color filter CF1, the second color filter CF2, and the third color filter CF3 may be respectively a red color filter, a green color filter, and a blue color filter, but embodiments of the present disclosure are not limited thereto. Hereinafter, the term "color filter CF" or "color filters CF" will be used to designate any color filter from among the first color filter CF1, the second color filter CF2, and the third color filter CF3, or collectively designate two or more kinds of color filters.

The first color filter CF1 may overlap the display component LEL (or the light emitting elements LD) of the first sub-pixel SPXL1 and the first color conversion layer CCL1 in the third direction DR3. The first color filter CF1 may include color filter material for allowing the first color of light (or red light) to selectively pass therethrough. For example, in the case in which the first sub-pixel SPXL1 is a red pixel, the first color filter CF1 may include red color filter material.

The second color filter CF2 may overlap the display component LEL (or the light emitting elements LD) of the second sub-pixel SPXL2 and the second color conversion layer CCL2 in the third direction DR3. The second color filter CF2 may include color filter material for allowing the second color of light (or green light) to selectively pass therethrough. For example, in the case in which the second sub-pixel SPXL2 is a green pixel, the second color filter CF2 may include green color filter material.

The third color filter CF3 may overlap the display component LEL (or the light emitting elements LD) of the third sub-pixel SPXL3 and the light scattering layer LSL in the third direction DR3. The third color filter CF3 may include color filter material for allowing the third color of light (or blue light) to selectively pass therethrough. For example, in the case in which the third sub-pixel SPXL3 is a blue pixel, the third color filter CF3 may include blue color filter material.

A light shielding layer BM may be disposed between the first to third color filters CF1, CF2, and CF3. The light shielding layer BM may be disposed between the first to third sub-pixels SPXL1, SPXL2, and SPXL3 or on boundaries therebetween. The material of the light shielding layer BM is not particularly limited. Various light shielding materials including black matrix material may be used to form the light shielding layer BM. In the case in which the light shielding layer BM is formed between the first to third color filters CF1, CF2, and CF3, a color mixing defect which is visible from a front surface or side surface of the display device DD may be prevented from occurring.

An overcoat layer OC may be disposed on the color filter layer CFL. The overcoat layer OC may be provided over the first to third sub-pixels SPXL1, SPXL2, and SPXL3. The overcoat layer OC may cover a lower component including the color filter layer CFL. The overcoat layer OC may prevent water or air from permeating the lower component. Furthermore, the overcoat layer OC may protect the lower component from foreign material such as dust.

The overcoat layer OC may include organic material such as acrylic resin, epoxy resin, phenolic resin, polyamide resin, polyimide resin, polyester resin, polyphenylene sulfide resin, or benzocyclobutene (BCB). However, embodiments of the present disclosure are not limited thereto. The overcoat layer OC may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

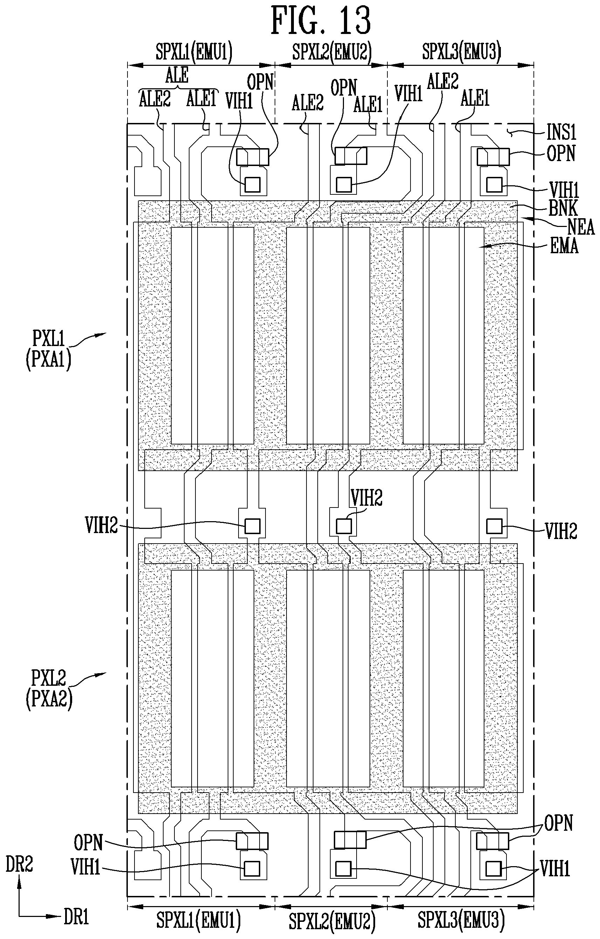

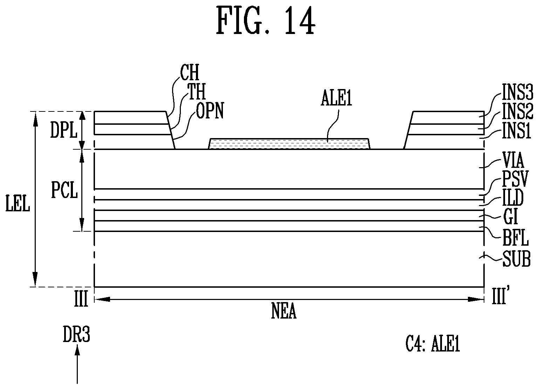

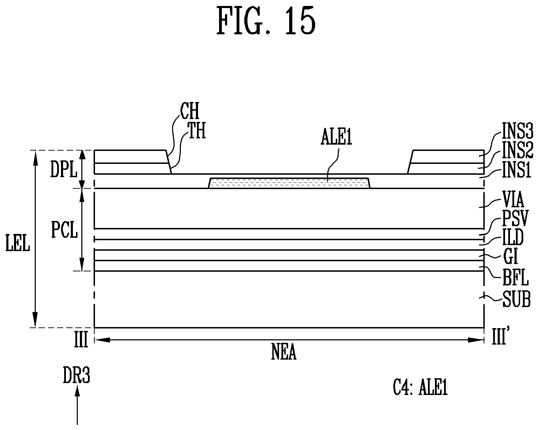

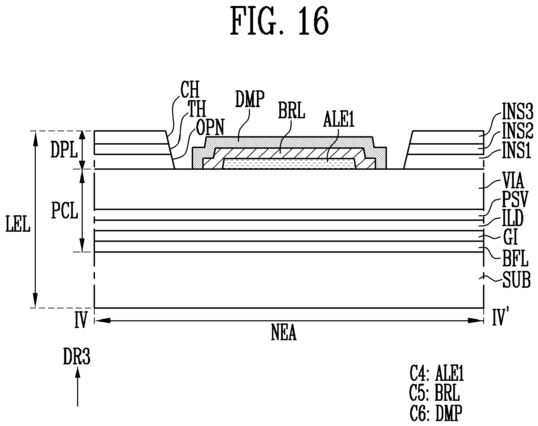

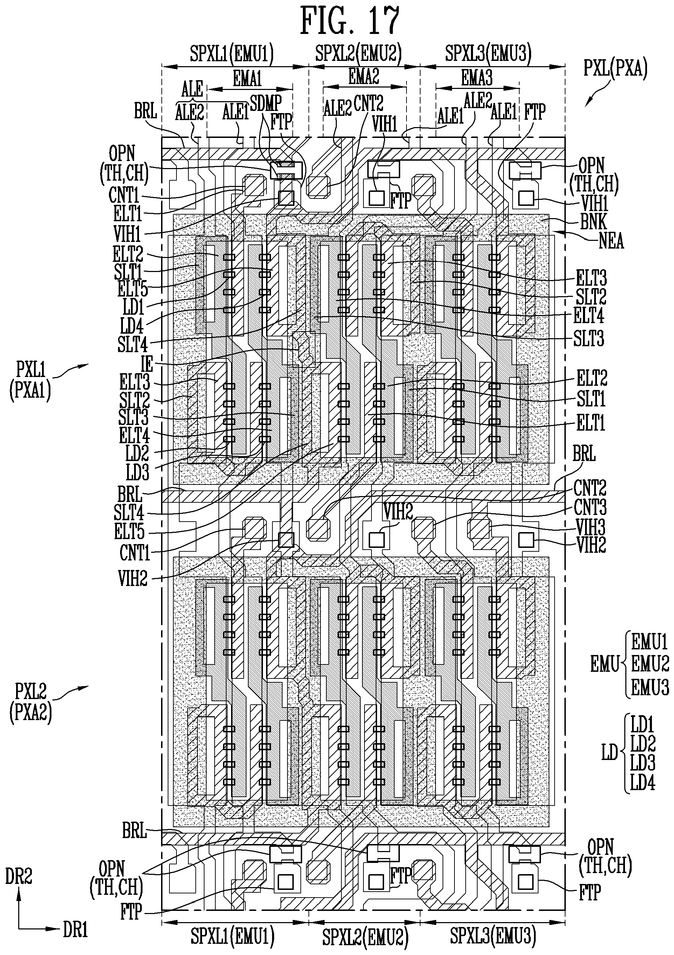

FIG. 12 is a schematic plan view illustrating a first pixel PXL1 and a second pixel PXL2 in accordance with one or more embodiments. FIG. 13 is a schematic plan view illustrating only a bank BNK and first and second alignment electrodes ALE1 and ALE2 that are provided in common in the first and second pixels PXL1 and PXL2 of FIG. 12. FIGS. 14 and 15 are schematic cross-sectional views taken along the line III-III' of FIG. 12. FIG. 16 is a schematic cross-sectional view taken along the line IV-IV' of FIG. 12. FIG. 17 is a schematic plan view illustrating the forms of the first and second pixels PXL1 and PXL2 of FIG. 12 after a repair operation has been performed.

In FIGS. 12 to 17, each of the first and second pixels PXL1 and PXL2 may have a structure substantially identical or similar to the pixel PXL described with reference to FIGS. 8 to 10, so that the configuration of each of the first and second pixels PXL1 and PXL2 will be described with reference to FIGS. 8 to 10.

The description of the embodiment of FIGS. 12 to 17 will be focused on differences from the above-mentioned embodiments so as to avoid redundant description.

Referring to FIGS. 1 to 17, the display device DD (or the display panel DP) may include the first pixel PXL1 and the second pixel PXL2 that are disposed adjacent to each other in the second direction DR2. A first pixel area PXA1 where the first pixel PXL1 is disposed and a second pixel area PXA2 where the second pixel PXL2 is disposed may be provided in the display area DA of the display device DD. For example, the first pixel PXL1 may be disposed on an i-th pixel row on a j-th pixel column, and the second pixel PXL2 may be disposed on an i+1-th pixel row on the j-th pixel column.

A bridge line BRL may be disposed between pixels PXL (or pixel areas PXA) adjacent to in the second direction DR2. For example, the bridge line BRL may be disposed between the first pixel area PXA1 and the second pixel area PXA2 or on a boundary therebetween. The bridge line BRL may be electrically connected to the second power line (refer to "PL2" of FIG. 6) through a third via hole VIH3. The third via hole VIH3 may be formed by removing a portion of at least one insulating layer disposed between the bridge line BRL and the second power line PL2.

The bridge line BRL may be electrically connected to some components of the first pixel PXL1 and some components of the second pixel PXL2. For example, the bridge line BRL may be electrically connected to the respective fifth electrodes ELT5 of the first to third sub-pixels SPXL1, SPXL2, and SPXL3 of the first pixel PXL1 and the respective fifth electrodes ELT5 of the first to third sub-pixels SPXL1, SPXL2, and SPXL3 of the second pixel PXL2. In one or more embodiments, the bridge line BRL may be electrically connected to the cathode electrode of each of the sub-pixels SPXL of the first and second pixels PXL1 and PXL2.

The first pixel PXL1 and the second pixel PXL2 may share an alignment electrode ALE. For example, the first alignment electrode ALE1 and the second alignment electrode ALE2 may be provided in common in the first pixel PXL1 and the second pixel PXL2. The first alignment electrode ALE1 may be electrically connected to the first power line (refer to "PL1" of FIG. 6) through the first via hole VIH1. The second alignment electrode ALE2 may be electrically connected to the second power line (refer to "PL2" of FIG. 6) through the second via hole VIH2. The first via hole VIH1 may be formed by a portion of at least one insulating layer disposed between the first power line PL1 and the first alignment electrode ALE1. The second via hole VIH2 may be formed by at least a portion of at least one insulating layer disposed between the second power line PL2 and the second alignment electrode ALE2.

In one or more embodiments, the first alignment electrode ALE1 may be electrically connected with the first power line PL1 in an operation of driving the light emitting elements LD, and thus may be supplied with the voltage of the first driving power supply VDD from the first power line PL1. The second alignment electrode ALE2 may be electrically connected to the second power line PL2 in the operation of driving the light emitting elements LD so that the second alignment electrode ALE2 may be supplied with the voltage of the second driving power supply VSS from the second power line PL2.

One area of the first alignment electrode ALE1 may be exposed to the outside in at least the non-emission area NEA. For example, one area of the first alignment electrode ALE1 may be exposed to the outside through a corresponding one of the openings OPN, a through hole TH related to the corresponding opening OPN, and a contact hole CH related to the through hole TH.

Each of the openings OPN may be formed by removing a portion of the first insulating layer INS1 located on the first alignment electrode ALE1 so that one area of the first alignment electrode ALE1 may be exposed in at least the non-emission area NEA. The through hole TH may be formed by removing a portion of the second insulating layer INS2 disposed on the first insulating layer INS1 in at least the non-emission area NEA such that the through hole TH may correspond to the corresponding opening OPN of the first insulating layer INS1. The contact hole CH may be formed by removing a portion of the third insulating layer INS3 disposed on the second insulating layer INS2 in at least the non-emission area NEA such that the contact hole CH may correspond to the through hole TH of the second insulating layer INS2.

A portion of the bridge line BRL may be disposed on one area of the first alignment electrode ALE1 that is exposed through at least one opening OPN from among the openings OPN. The dummy pattern DMP may be disposed on a portion of the bridge line BRL. The bridge line BRL may be formed of the fifth conductive layer C5. The dummy pattern DMP may be formed of the sixth conductive layer C6. The dummy pattern DMP may be provided on a layer identical to that of the second and fourth electrodes ELT2 and ELT4 of each of the first to third sub-pixels SPXL1, SPXL2, and SPXL3 of the first and second pixels PXL1 and PXL2. For example, the dummy pattern DMP may be formed through a process identical to that of the second and fourth electrodes ELT2 and ELT4, and provided on a layer identical thereto.

In at least the non-emission area NEA, one area of the first alignment electrode ALE1 and/or the dummy pattern DMP that is exposed to the outside through the corresponding opening OPN of the first insulating layer INS1, the through hole TH of the second insulating layer INS2 that corresponds to the corresponding opening OPN, and the contact hole CH of the third insulating layer INS3 that corresponds to the through hole TH may be partially disconnected (or removed) when a bright spot defect is caused in the corresponding sub-pixel SPXL, thus allowing the bright spot defect to be repaired. The bright spot defect may be caused by an event in which, when the first alignment electrode ALE1 that is supplied with the voltage of the first driving power supply VDD from the first power line PL1 overlaps an electrode (e.g., the first electrode ELT1) disposed thereon, the voltage of the first driving power supply VDD is supplied to the electrode by a short-circuit between the first alignment electrode ALE1 and the electrode due to a step difference of the first alignment electrode ALE1.

In the case where the bright spot defect occurs, as illustrated in FIG. 17, a repair process of interrupting an electrical connection between the first power line PL1 and the first alignment electrode ALE1 may be performed by removing a portion of one area of the first alignment electrode ALE1 that is exposed to the outside through the opening OPN of the first insulating layer INS1, the through hole TH of the second insulating layer INS2, and the contact hole CH of the third insulating layer INS3 (or by cutting off the first alignment electrode ALE1 that is exposed to the outside). For example, the first alignment electrode ALE1 may float by cutting off the first alignment electrode ALE1 that is exposed to the outside through the opening OPN, the through hole TH, and the contact hole CH. During the foregoing process, floating patterns FTP that are separated from the first alignment electrode ALE1 may be formed. Each of the floating patterns FTP may be a portion of the first alignment electrode ALE1 that overlaps the first via hole VIH1.

If the bridge line BRL and the dummy pattern DMP are disposed on the one area of the first alignment electrode ALE1 that is exposed through the opening OPN of the first insulating layer INS1, the through hole TH of the second insulating layer INS2, and the contact hole CH of the third insulating layer INS3, the dummy pattern DMP, the bridge line BRL, and the one area of the first alignment electrode ALE1 may be removed (or cut off) together during the foregoing repair process. The dummy pattern DMP may be divided by removing a portion thereof into two sub-dummy patterns SDMP that are spaced from each other, and the two sub-dummy patterns SDMP may remain in the first and second pixel areas PXA1 and PXA2.

Because the electrical connection between the first alignment electrode ALE1 and the first power line PL1 is interrupted by the foregoing repair process (or method), the first alignment electrode ALE1 may float. Therefore, even if a short-circuit is caused between the first alignment electrode ALE1 and the electrode (or the first electrode ELT1) disposed thereover, the voltage of the first driving power supply VDD may not be transmitted to the electrode, so that the bright spot defect may be mitigated, whereby the reliability of the display device DD (or the display panel DP) may be enhanced.

In one or more embodiments, the first insulating layer INS1 may not include an opening OPN. In this case, as illustrated in FIG. 15, the first alignment electrode ALE1 may be covered with the first insulating layer INS1. Here, the second insulating layer INS2 formed on the first insulating layer INS1 may be partially open to include, in at least the non-emission area NEA, the through hole TH through which a portion of the first insulating layer INS1 on the first alignment electrode ALE1 is exposed. The third insulating layer INS3 formed on the second insulating layer INS2 may be partially open to include, in at least the non-emission area NEA, the contact hole CH that corresponds to the through hole TH of the second insulating layer INS2. When the foregoing repair process is performed, both one area of the first insulating layer INS1 that is exposed through the through hole TH of the second insulating layer INS2 and the contact hole CH of the third insulating layer INS3 and the first alignment electrode ALE1 disposed under the one area of the first insulating layer INS1 may be removed (or cut off).

Hereinafter, another embodiment will be described. In descriptions of the following embodiment, like reference numerals will be used to designate the above-described configurations and the same components, and redundant explanation thereof will be omitted or simplified.

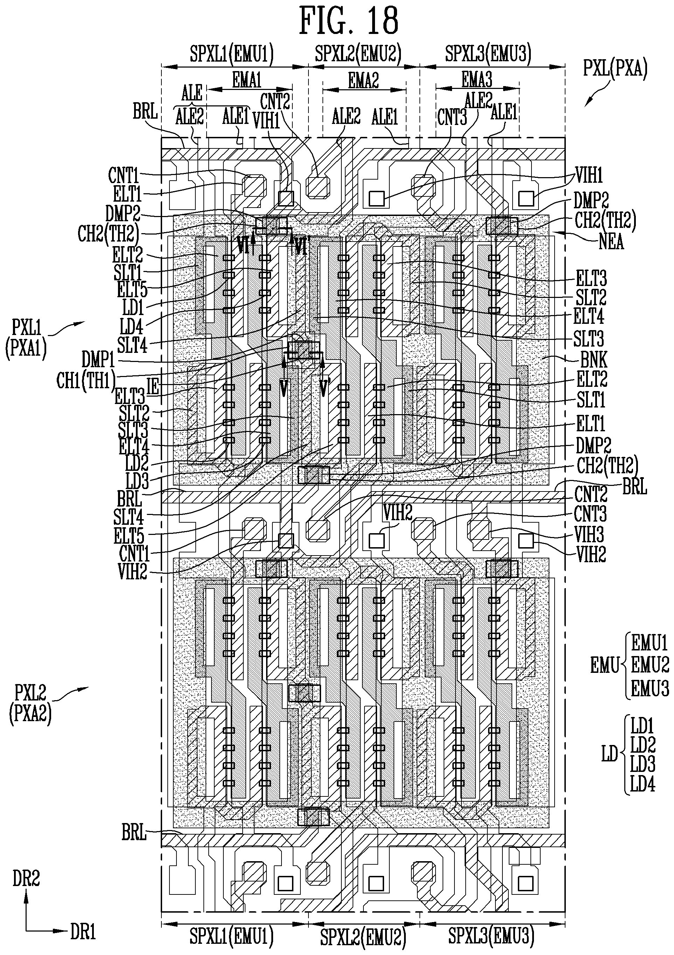

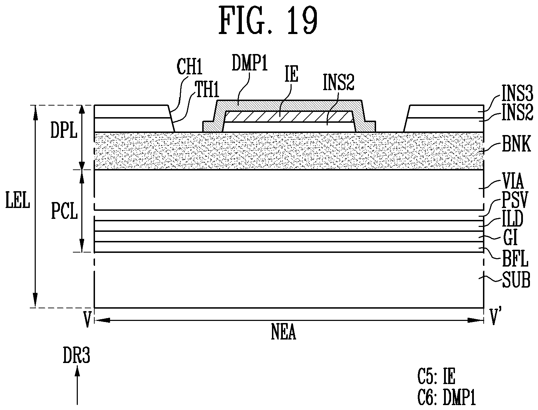

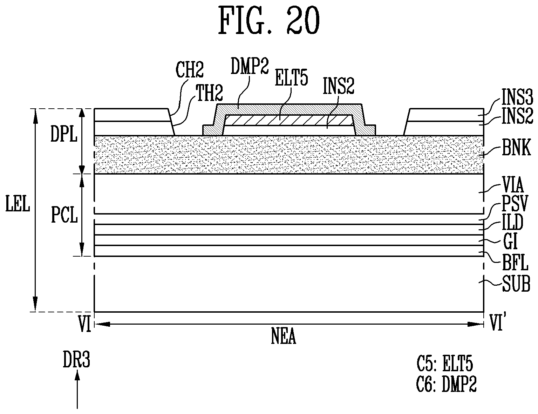

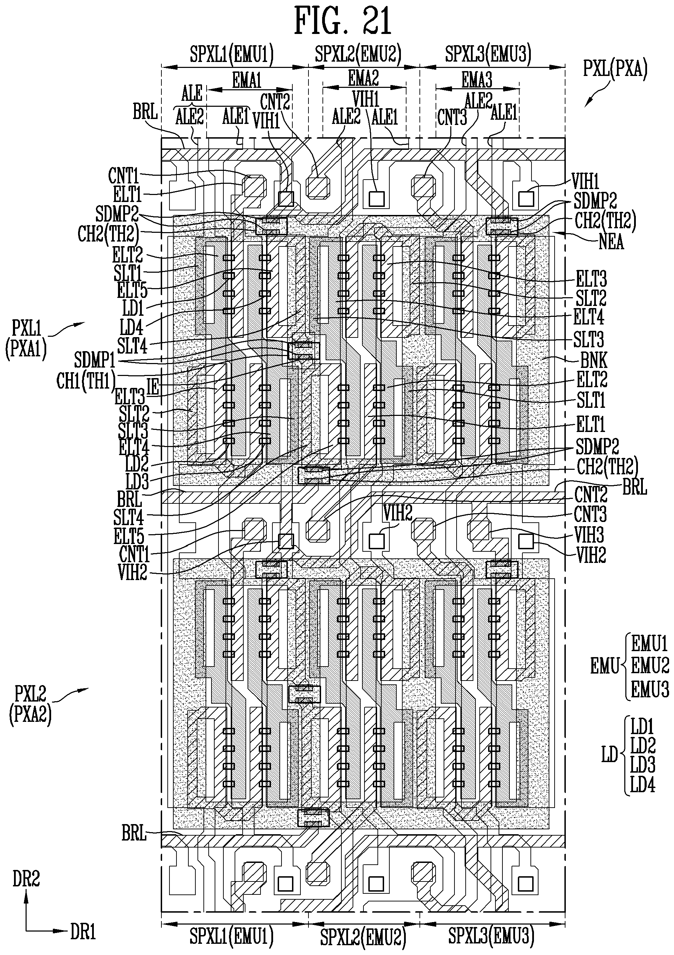

FIG. 18 is a schematic plan view illustrating a first pixel PXL1 and a second pixel PXL2 in accordance with one or more embodiments. FIG. 19 is a schematic cross-sectional view taken along the line V-V' of FIG. 18. FIG. 20 is a schematic cross-sectional view taken along the line VI-VI' of FIG. 18. FIG. 21 is a schematic plan view illustrating the forms of the first and second pixels PXL1 and PXL2 of FIG. 18 after a repair operation has been performed.

Referring to FIGS. 1 to 11, and 18 to 21, some components included in each of the first and second pixels PXL1 and PXL2 may be exposed to the outside. For example, the intermediate electrode IE included in each of the first and second pixels PXL1 and PXL2 may be exposed to the outside through a first contact hole CH1. Furthermore, the fifth electrode ELT5 included in each of the first and second pixels PXL1 and PXL2 may be exposed to the outside through a second contact hole CH2. The intermediate electrode IE and the fifth electrodes ELT5 may be provided at the same layer. For example, the intermediate electrode IE and the fifth electrodes ELT5 may be formed of the fifth conductive layer C5 through the same process.

The first contact hole CH1 may be formed by removing a portion of the third insulating layer INS3 located on the intermediate electrode IE so that one area of the intermediate electrode IE may be exposed in at least the non-emission area NEA. Here, in at least the non-emission area NEA, the second insulating layer INS2 disposed under the third insulating layer INS3 may be partially open to include a first through hole TH1 through which the bank BNK is exposed in the first contact hole CH1 of the third insulating layer INS3.

The second contact hole CH2 may be formed by removing a portion of the third insulating layer INS3 located on the fifth electrodes ELT5 in at least the non-emission area NEA so that one area of each of the fifth electrodes ELT5 may be exposed. Here, in at least the non-emission area NEA, the second insulating layer INS2 disposed under the third insulating layer INS3 may be partially open to include a second through hole TH2 through which the bank BNK is exposed in the second contact hole CH2 of the third insulating layer INS3.

In a plan view, the first and second contact holes CH1 and CH2 of the third insulating layer INS3 may overlap the bank BNK in the non-emission area NEA.

A first dummy pattern DMP1 may be located on the intermediate electrode IE that is exposed to the outside through the first contact hole CH1 of the third insulating layer INS3. A second dummy pattern DMP2 may be located on one area of each fifth electrode ELT5 that is exposed to the outside through the second contact hole CH2 of the third insulating layer INS3. The first dummy pattern DMP1 may be directly disposed on the intermediate electrode IE. The second dummy pattern DMP2 may be directly disposed on one area of each fifth electrode ELT5. The first dummy pattern DMP1 and the second dummy pattern DMP2 may be provided at the same layer. For example, the first dummy pattern DMP1 and the second dummy pattern DMP2 may be formed of the sixth conductive layer C6 through the same process. The first and second dummy pattern DMP1 and DMP2 may be formed through a process identical with that of the second and fourth electrodes ELT2 and ELT4 of each of the first and second pixels PXL1 and PXL2.

The first dummy pattern DMP1 may be a protective component that covers the intermediate electrode IE that is exposed through the first contact hole CH1 of the third insulating layer INS3 to prevent the intermediate electrode IE from being damaged by an etchant that is used during a process of forming the second and fourth electrodes ELT2 and ELT4 that are formed of the sixth conductive layer C6. The second dummy pattern DMP2 may be a protective component that covers each fifth electrode ELT5 that is exposed through the second contact hole CH2 of the third insulating layer INS3 to prevent the fifth electrode ELT5 from being damaged by an etchant that is used during a process forming the second and fourth electrodes ELT2 and ELT4.

In at least the non-emission area NEA, both the first dummy pattern DMP1 that is exposed through the first contact hole CH1 of the third insulating layer INS3 and the intermediate electrode IE disposed thereunder may be partially disconnected (or removed) when a bright spot defect is caused in the corresponding sub-pixel SPXL, thus allowing the bright spot defect to be repaired. In at least the non-emission area NEA, both the second dummy pattern DMP2 that is exposed through the second contact hole CH2 of the third insulating layer INS3 and the fifth electrode ELT5 disposed thereunder may be partially disconnected when a bright spot defect is caused in the corresponding sub-pixel SPXL, thus allowing the bright spot defect to be repaired.

In the case in which the bright spot defect occurs, as illustrated in FIG. 21, a repair process of interrupting the electrical connection between the fifth electrodes ELT5 of adjacent sub-pixels SPXL may be performed by removing both the first dummy pattern DMP1 that is exposed to the outside through the first contact hole CH1 of the third insulating layer INS3 and the intermediate electrode IE disposed thereunder (or cutting off the exposed first dummy pattern DMP1 and the intermediate electrode IE disposed thereunder) and removing both the second dummy pattern DMP2 that is exposed to the outside through the second contact hole CH2 of the third insulating layer INS3 and the fifth electrode ELT5 disposed thereunder (or cutting of the exposed second dummy pattern DMP2 and the fifth electrode ELT5 disposed thereunder). In other words, in the case in which the bright spot defect occurs, a repair process of removing portions of some components that are exposed to the outside through each of the first and second contact holes CH1 and CH2 may be performed so that the fifth electrode ELT5 (or the cathode electrode) of each sub-pixel SPXL may float. The first dummy pattern DMP1 may be divided by removing a portion thereof into two first sub-dummy patterns SDMP1 that are spaced from each other through the foregoing repair process, and the two first sub-dummy patterns SDMP1 may remain in the first and second pixel areas PXA1 and PXA2. The second dummy pattern DMP2 may be divided by removing a portion thereof into two second sub-dummy patterns SDMP2 that are spaced from each other through the foregoing repair process, and the two second sub-dummy patterns SDMP2 may remain in the first and second pixel areas PXA1 and PXA2.

The fifth electrode ELT5 (or the cathode electrode) of each sub-pixel SPXL may float through the repair process (or method), so that the corresponding sub-pixel SPXL may become a dark spot, thus preventing the bright spot defect from occurring.

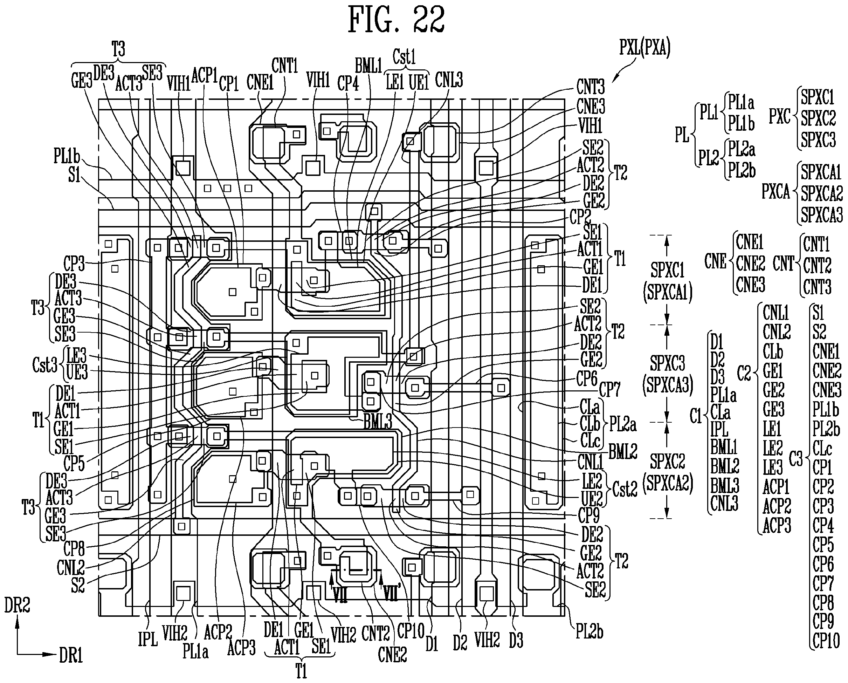

FIG. 22 is a schematic plan view illustrating a pixel circuit layer PCL of a pixel PXL in accordance with one or more embodiments. FIG. 23 is a schematic cross-sectional view taken along the line VII-VII' of FIG. 22.

Although FIG. 23 simply illustrates the pixel PXL, e.g., illustrating that each electrode is formed of a single electrode and each insulating layer is formed of a single insulating layer, embodiments of the present disclosure are not limited thereto.

The description of the embodiment of FIGS. 22 and 23 will be focused on differences from the above-mentioned embodiments so as to avoid redundant description.

Referring to FIGS. 1 to 5, 22, and 23, the pixel PXL may be provided in the pixel area PXA that is one area of the display area DA of the display device DD (or the display panel DP).

The pixel area PXA may include a first pixel circuit area SPXCA1, a second pixel circuit area SPXCA2, and a third pixel circuit area SPXCA3. The first pixel circuit SPXC1 may be located in the first pixel circuit area SPXCA1. The second pixel circuit SPXC2 may be located in the second pixel circuit area SPXCA2. The third pixel circuit SPXC3 may be located in the third pixel circuit area SPXCA3. The first pixel circuit SPXC1, the second pixel circuit SPXC2, and the third pixel circuit SPXC3 may form the pixel circuit PXC of each pixel PXL. One area of the display area DA in which the pixel circuit PXC is disposed may be a pixel circuit area PXCA.

The pixel area PXA may include a line area that is provided around each of the first and second pixel circuit areas SPXCA1 and SPXCA2 and/or in a portion thereof. For example, a line area may be provided at an upper side of the first pixel circuit area SPXCA1 and a lower side of the second pixel circuit area SPXCA2. The first horizontal power line PL1b, the second horizontal power line PL2b, the first scan line S1, and the second scan line S2 that extend in the first direction DR1 may be disposed in the line area.

The first, second, and third pixel circuits SPXC1, SPXC2, and SPXC3 may be located in the pixel circuit layer PCL on the substrate SUB. The pixel circuit layer PCL may include at least one or more insulating layers. For example, the pixel circuit layer PCL may include a buffer layer BFL, a gate insulating layer GI, an interlayer insulating layer ILD, a passivation layer PSV, and a via layer VIA that are successively stacked on the substrate SUB in the third direction DR3. In addition, the pixel circuit layer PCL may include conductive layers disposed between the foregoing insulating layers. For example, the pixel circuit layer PCL may include a first conductive layer C1 disposed between the substrate SUB and the buffer layer BFL, a second conductive layer C2 disposed on the gate insulating layer GI, and a third conductive layer C3 disposed on the interlayer insulating layer ILD.

A display element layer DPL may be disposed on the pixel circuit layer PCL. The display element layer DPL may include a first insulating layer INS1, a second insulating layer INS2, and a third insulating layer INS3 (refer to "INS3" of FIG. 10) that are disposed on the via layer VIA. Furthermore, the display element layer DPL may include a fourth conductive layer (refer to "C4" of FIG. 9) disposed on the via layer VIA, a fifth conductive layer C5 disposed on the second insulating layer INS2, and a sixth conductive layer (refer to "C6" of FIG. 9) disposed on the third insulating layer INS3.

The pixel circuit layer PCL and the display element layer DPL may be the same as the pixel circuit layer PCL and the display element layer DPL of the pixel PXL described with reference to FIG. 6 to 10; therefore, detailed description thereof will be omitted.

Signal lines that are disposed on the substrate SUB and electrically connected to the pixel PXL may be located in the pixel circuit area PXCA. For example, the signal lines may include a first scan line S1, a second scan line S2, data lines D1, D2, and D3, a power line PL, and an initialization power line IPL.

A scan signal may be applied to the first scan line S1. The first scan line S1 may extend in the first direction DR1. The first scan line S1 may be formed of the third conductive layer C3. The first scan line S1 may be disposed on a first connection line CNL1 and electrically connected to the first connection line CNL1 through a contact hole. For example, the first scan line S1 may be electrically connected to the first connection line CNL1 through a contact hole passing through the interlayer insulating layer ILD.

The first connection line CNL1 may extend in the second direction DR2. The first connection line CNL1 may be formed of the second conductive layer C2. The first connection line CNL1 may be integrally provided with the second gate electrode GE2 of the second transistor T2 of each of the first, second, and third pixel circuits SPXC1, SPXC2, and SPXC3. For example, a portion of the first connection line CNL1 may be the second gate electrode GE2 of the second transistor T2 of each of the first, second, and third pixel circuits SPXC1, SPXC2, and SPXC3.

A control signal may be applied to the second scan line S2. The second scan line S2 may extend in the first direction DR1. The second scan line S2 may be formed of the third conductive layer C3. The second scan line S2 may be disposed on a second connection line CNL2 and electrically connected to the second connection line CNL2 through a contact hole. For example, the second scan line S2 may be electrically connected to the second connection line CNL2 through a contact hole passing through the interlayer insulating layer ILD.

The second connection line CNL2 may extend in the second direction DR2. The second connection line CNL2 may be formed of the second conductive layer C2. The second connection line CNL2 may be integrally provided with the third gate electrode GE3 of the third transistor T3 of each of the first, second, and third pixel circuits SPXC1, SPXC2, and SPXC3. For example, a portion of the second connection line CNL2 may be the third gate electrode GE3 of the third transistor T3 of each of the first, second, and third pixel circuits SPXC1, SPXC2, and SPXC3.

The data lines D1, D2, and D3 may include a first data line D1, a second data line D2, and a third data line D3 that extend in the second direction DR2 and are spaced from each other in the first direction DR1. Each of the first, second, and third data lines D1, D2, and D3 may be supplied with a corresponding data signal. The first data line D1 may be electrically connected to the second transistor T2 of the first pixel circuit SPXC1. The second data line D2 may be electrically connected to the second transistor T2 of the second pixel circuit SPXC2. The third data line D3 may be electrically connected to the second transistor T2 of the third pixel circuit SPXC3. Each of the first, second, and third data lines D1, D2, and D3 may be formed of the first conductive layer C1.

The power line PL may include a first power line PL1 and a second power line PL2 that are spaced from each other.

The first power line PL1 may include a first vertical power line PL1a extending in the second direction DR2, and a first horizontal power line PL1b extending in the first direction DR1. The voltage of the first driving power supply VDD may be applied to the first power line PL1.

The first vertical power line PL1a and the first horizontal power line PL1b may be disposed on different layers and may be electrically connected to each other through a contact hole. For example, the first vertical power line PL1a may be formed of the first conductive layer C1. The first horizontal power line PL1b may be formed of the third conductive layer C3. The first vertical power line PL1a and the first horizontal power line PL1b may be electrically connected to each other through the contact hole. The first power line PL1 may have a mesh structure because the first vertical power line PL1a and the first horizontal power line PL1b are electrically connected to each other.

The second power line PL2 may include a second vertical power line PL2a extending in the second direction DR2, and a second horizontal power line PL2b extending in the first direction DR1. The voltage of the second driving power supply VSS may be applied to the second power line PL2.

The second vertical power line PL2a may extend in the second direction DR2. The second vertical power line PL2a may include a first layer CLa, a second layer CLb, and a third layer CLc. The first layer CLa may be formed of the first conductive layer C1. The second layer CLb may be formed of the second conductive layer C2. The third layer CLc may be formed of the third conductive layer C3. The first layer CLa, the second layer CLb, and the third layer CLc may overlap each other. The first, second, and third layers CLa, CLb, and CLc may be electrically connected to each other through at least one or more contact holes.

The second horizontal power line PL2b may extend in the first direction DR1. The second horizontal power line PL2b may be implemented as a single-layer structure. The second horizontal power line PL2b may be formed of the third conductive layer C3.

The second vertical power line PL2a and the second horizontal power line PL2b may be disposed on different layers and may be electrically connected to each other through a contact hole. The second power line PL2 may have a mesh structure because the second vertical power line PL2a and the second horizontal power line PL2b are electrically connected to each other.

The initialization power line IPL may extend in the second direction DR2. The initialization power line IPL may be the sensing line SENj (or the j-th sensing line) described with reference to FIG. 5. The voltage of the initialization power supply may be applied to the initialization power line IPL. In one or more embodiments, the initialization power line IPL may be formed of the first conductive layer C1. The initialization power line IPL may be electrically connected to the third transistor T3 of each of the first, second, and third pixel circuits SPXC1, SPXC2, and SPXC3 by the third conductive pattern CP3.

The third conductive pattern CP3 may be formed of the third conductive layer C3, and may extend in the second direction DR2. The third conductive pattern CP3 may be disposed to overlap the initialization power line IPL. The third conductive pattern CP3 may be electrically connected with the initialization power line IPL through a contact hole. The third conductive pattern CP3 may be electrically connected to the third transistor T3 of each of the first, second, and third pixel circuits SPXC1, SPXC2, and SPXC3 through the corresponding contact hole.

The first power line PL1, the second power line PL2, the initialization power line IPL, the first connection line CNL1, the second connection line CNL2, the first scan line S1, and the second scan line S2 may be common components provided in common in the first, second, and third pixel circuits SPXC1, SPXC2, and SPXC3.

Each of the first, second, and third pixel circuits SPXC1, SPXC2, and SPXC3 may include a first transistor T1, a second transistor T2, a third transistor T3, and a storage capacitor. For example, the first pixel circuit SPXC1 may include first, second, and third transistors T1, T2, and T3, and a first storage capacitor Cst1. The second pixel circuit SPXC2 may include first, second, and third transistors T1, T2, and T3, and a second storage capacitor Cst2. The third pixel circuit SPXC3 may include first, second, and third transistors T1, T2, and T3, and a third storage capacitor Cst3.

The first pixel circuit SPXC1, the second pixel circuit SPXC2, and the third pixel circuit SPXC3 may have a substantially similar or identical structure. Hereinafter, the first pixel circuit SPXC1 will be described as a representative example, and description of the second and third pixel circuits SPXC2 and SPXC3 will be simplified.

The first pixel circuit SPXC1 may include a first transistor T1, a second transistor T2, a third transistor T3, and a first storage capacitor Cst1.

The first transistor T1 may include a first gate electrode GE1, a first active pattern ACT1, a first source area SE1, and a first drain area DE1.

The first gate electrode GE1 may be electrically connected to a second source area SE2 of the second transistor T2 by the fourth conductive pattern CP4. The first gate electrode GE1 may be formed of the second conductive layer C2.

The fourth conductive pattern CP4 may be formed of the third conductive layer C3. A first end of the fourth conductive pattern CP4 may be electrically connected with the first gate electrode GE1 through a contact hole. A second end of the fourth conductive pattern CP4 may be electrically connected with the second source area SE2 through another contact hole.

The first active pattern ACT1, the first source area SE1, and the first drain area DE1 each may be a semiconductor pattern formed of poly silicon, amorphous silicon, an oxide semiconductor, or the like. Each of the first active pattern ACT1, the first source area SE1, and the first drain area DE1 may be formed of an undoped semiconductor layer or a semiconductor layer doped with an impurity.

The first active pattern ACT1, the first source area SE1, and the first drain area DE1 may be provided and/or formed on the buffer layer BFL.

The first source area SE1 may be connected to (brought into contact with) a first end of the first active pattern ACT1. Furthermore, the first source area SE1 may be electrically connected to a first bottom metal layer BML1 through a contact hole that passes through the buffer layer BFL.

The first bottom metal layer BML1 may be formed of the first conductive layer C1. The first bottom metal layer BML1 may be electrically connected to the first source area SE1 through a contact hole.

The first drain area DE1 may be connected to (or brought into contact with) a second end of the first active pattern ACT1. Furthermore, the first drain area DE1 may be electrically connected to the first conductive pattern CP1 through a contact hole.

The first conductive pattern CP1 may be formed of the third conductive layer C3, and may overlap one area of the first vertical power line PL1a in a plan view. The first conductive pattern CP1 may be electrically connected to the first drain area DE1 through a contact hole that successively passes through the interlayer insulating layer ILD and the gate insulating layer Gl. Furthermore, the first conductive pattern CP1 may be electrically connected with the first vertical power line PL1a through another contact hole that successively passes through the interlayer insulating layer ILD, the gate insulating layer GI, and the buffer layer BFL. Furthermore, the first conductive pattern CP1 may be electrically connected with a first additional conductive pattern ACP1 through another contact hole passing through the interlayer insulating layer ILD.

The first additional conductive pattern ACP1 may be formed of the second conductive layer C2, and may overlap one area of the first vertical power line PL1a. The first additional conductive pattern ACP1 may be electrically connected with the first vertical power line PL1a through a contact hole.

In one or more embodiments, the first vertical power line PL1a may be electrically connected, through a corresponding contact hole, to the first additional conductive pattern ACP1 and the first conductive pattern CP1 that are disposed on different layers, so that a multi-layer structure may be implemented, whereby line resistance may be reduced, and signal distortion may be reduced.

The second transistor T2 may include a second gate electrode GE2, a second active pattern ACT2, a second source area SE2, and a second drain area DE2.

The second gate electrode GE2 may be integrally provided with the first connection line CNL1. In this case, the second gate electrode GE2 may be one area of the first connection line CNL1.

The second active pattern ACT2, the second source area SE2, and the second drain area DE2 each may be a semiconductor pattern formed of poly silicon, amorphous silicon, an oxide semiconductor, or the like. Each of the second active pattern ACT2, the second source area SE2, and the second drain area DE2 may be formed of an undoped semiconductor layer or a semiconductor layer doped with an impurity.

The second active pattern ACT2 may be a channel area of the second transistor T2 as an area overlapping the second gate electrode GE2.

The second source area SE2 may be connected to (brought into contact with) a first end of the second active pattern ACT2. Furthermore, the second source area SE2 may be electrically connected to the first gate electrode GE1 by the fourth conductive pattern CP4.

The second drain area DE2 may be connected to (or brought into contact with) a second end of the second active pattern ACT2. Furthermore, the second drain area DE2 may be electrically connected to the first data line D1 by the second conductive pattern CP2.

The second conductive pattern CP2 may correspond to the third conductive layer C3. A first end of the second conductive pattern CP2 may be electrically connected with the first data line D1 through a contact hole that successively passes through the buffer layer BFL, the gate insulating layer GI, and the interlayer insulating layer ILD. A second end of the second conductive pattern CP2 may be electrically connected to the second drain area DE2 through a contact hole that successively passes through the gate insulating layer GI and the interlayer insulating layer ILD. The second drain area DE2 and the first data line D1 may be electrically connected to each other by the second conductive pattern CP2.

The third transistor T3 may include a third gate electrode GE3, a third active pattern ACT3, a third source area SE3, and a third drain area DE3.

The third gate electrode GE3 may be integrally provided with the second connection line CNL2. In this case, the third gate electrode GE3 may be one area of the second connection line CNL2.

The third active pattern ACT3, the third source area SE3, and the third drain area DE3 each may be a semiconductor pattern formed of poly silicon, amorphous silicon, an oxide semiconductor, or the like. Each of the third active pattern ACT3, the third source area SE3, and the third drain area DE3 may be formed of an undoped semiconductor layer or a semiconductor layer doped with an impurity.

The third active pattern ACT3, the third source area SE3, and the third drain area DE3 may be provided and/or formed on the buffer layer BFL.

The third active pattern ACT3 may correspond to a channel area of the third transistor T3 as an area overlapping the third gate electrode GE3.

The third source area SE3 may be connected to (brought into contact with) a first end of the third active pattern ACT3. Furthermore, the third source area SE3 may be electrically connected with the first upper electrode UE1 of the first storage capacitor Cst1 through a contact hole that passes through the interlayer insulating layer ILD and the gate insulating layer GI.

The third drain area DE3 may be connected to (or brought into contact with) a second end of the third active pattern ACT3. Furthermore, the third drain area DE3 may be electrically connected to the initialization power line IPL by the third conductive pattern CP3.

The first storage capacitor Cst1 may include a first lower electrode LE1 and a first upper electrode UE1. Here, the first storage capacitor Cst1 may be the storage capacitor Cst described with reference to FIG. 5.

The first lower electrode LE1 may be integrally provided with the first gate electrode GE1. In this case, the first lower electrode LE1 may be one area of the first gate electrode GE1. The first lower electrode LE1 may be formed of the second conductive layer C2.

The first upper electrode UE1 may be disposed to overlap the first lower electrode LE1 in a plan view, and have a size(or a surface area) greater than that of the first lower electrode LE1, but embodiments of the present disclosure are not limited thereto. In a plan view, the first upper electrode UE1 may overlap each of the first source area SE1 and the third source area SE3. The first upper electrode UE1 may be formed of the third conductive layer C3.

The first upper electrode UE1 may be electrically connected with the first bottom metal layer BML1 through a contact hole that successively passes through the buffer layer BFL, the gate insulating layer GI, and the interlayer insulating layer ILD. Furthermore, the first upper electrode UE1 may be electrically connected to the third source area SE3 through a corresponding contact hole. The first source area SE1, the third source area SE3, the first bottom metal layer BML1, and the first upper electrode UE1 may be electrically connected to each other.

The second pixel circuit SPXC2 may include a first transistor T1, a second transistor T2, a third transistor T3, and a second storage capacitor Cst2.

The first transistor T1 may include a first gate electrode GE1, a first active pattern ACT1, a first source area SE1, and a first drain area DE1.

The first gate electrode GE1 may be electrically connected to a second source area SE2 of the second transistor T2.

The first active pattern ACT1 may be a channel area of the first transistor T1.

The first source area SE1 may be connected to the first active pattern ACT1. Furthermore, the first source area SE1 may be electrically connected to a second bottom metal layer BML2 through a contact hole that passes through the buffer layer BFL.

The second bottom metal layer BML2 may be formed of the first conductive layer C1. The second bottom metal layer BML2 may be electrically connected to the first source area SE1 through a contact hole. In addition, the second bottom metal layer BML2 may be electrically connected to the second upper electrode UE2 through another contact hole that successively passes through the buffer layer BFL, the gate insulating layer GI, and the interlayer insulating layer ILD.

The first drain area DE1 may be connected to the first active pattern ACT1. Furthermore, the first drain area DE1 may be electrically connected to the eighth conductive pattern CP8 through a contact hole.

The eighth conductive pattern CP8 may be formed of the third conductive layer C3, and may overlap another area of the first vertical power line PL1a in a plan view. The eighth conductive pattern CP8 may be electrically connected to the first drain area DE1 through a contact hole that successively passes through the interlayer insulating layer ILD and the gate insulating layer GI. Furthermore, the eighth conductive pattern CP8 may be electrically connected with the first vertical power line PL1a through another contact hole that successively passes through the interlayer insulating layer ILD, the gate insulating layer GI, and the buffer layer BFL. Furthermore, the eighth conductive pattern CP8 may be electrically connected with a third additional conductive pattern ACP3 through another contact hole passing through the interlayer insulating layer ILD.

The third additional conductive pattern ACP3 may be formed of the second conductive layer C2, and may overlap another area of the first vertical power line PL1a. The third additional conductive pattern ACP3 may be electrically connected with the first vertical power line PL1a through a contact hole.

In one or more embodiments, the first vertical power line PL1a may be electrically connected, through a corresponding contact hole, to the third additional conductive pattern ACP3 and the eighth conductive pattern CP8 that are disposed on different layers, so that a multi-layer structure may be implemented, whereby line resistance may be reduced, and signal distortion may be reduced.

The second transistor T2 may include a second gate electrode GE2, a second active pattern ACT2, a second source area SE2, and a second drain area DE2.

The second gate electrode GE2 may be integrally provided with the first connection line CNL1, and may be electrically connected with the first scan line S1. The second gate electrode GE2 may be formed of the second conductive layer C2.

The second active pattern ACT2 may be a channel area of the second transistor T2.

The second source area SE2 may be connected to the second active pattern ACT2. Furthermore, the second source area SE2 may be electrically connected to the first gate electrode GE1 by the tenth conductive pattern CP10.

The tenth conductive pattern CP10 may be formed of the third conductive layer C3. A first end of the tenth conductive pattern CP10 may be electrically connected to the second source area SE2 through a contact hole that successively passes through the gate insulating layer GI and the interlayer insulating layer ILD. A second end of the tenth conductive pattern CP10 may be electrically connected to the first gate electrode GE1 through a contact hole that passes through the interlayer insulating layer ILD.

The second drain area DE2 may be connected to the second active pattern ACT2. Furthermore, the second drain area DE2 may be electrically connected to the second data line D2 by a ninth conductive pattern CP9.

The ninth conductive pattern CP9 may be formed of the third conductive layer C3. A first end of the ninth conductive pattern CP9 may be electrically connected with the second data line D2 through a contact hole that successively passes through the buffer layer BFL, the gate insulating layer GI, and the interlayer insulating layer ILD. A second end of the ninth conductive pattern CP9 may be electrically connected to the second drain area DE2 through a contact hole that successively passes through the gate insulating layer GI and the interlayer insulating layer ILD.

The third transistor T3 may include a third gate electrode GE3, a third active pattern ACT3, a third source area SE3, and a third drain area DE3.

The third gate electrode GE3 may be integrally provided with the second connection line CNL2, and may be electrically connected with the second scan line S2. The third gate electrode GE3 may be formed of the second conductive layer C2.

The third active pattern ACT3 may be a channel area of the third transistor T3.

The third source area SE3 may be connected to (brought into contact with) a first end of the third active pattern ACT3. The third source area SE3 may be electrically connected with the second upper electrode UE2 of the second storage capacitor Cst2 through a contact hole.

The third drain area DE3 may be connected to (or brought into contact with) a second end of the third active pattern ACT3. The third drain area DE3 may be electrically connected to the initialization power line IPL by the third conductive pattern CP3.

The second storage capacitor Cst2 may include a second lower electrode LE2 and a second upper electrode UE2.

The second lower electrode LE2 may be integrally provided with the first gate electrode GE1. In this case, the second lower electrode LE2 may be one area of the first gate electrode GE1. The second lower electrode LE2 may be formed of the second conductive layer C2.

The second upper electrode UE2 may be disposed to overlap with the second lower electrode LE2 in a plan view, and have a size (or a surface area) greater than that of the second lower electrode LE2, but embodiments of the present disclosure are not limited thereto. In a plan view, the second upper electrode UE2 may overlap each of the first source area SE1 and the third source area SE3. The second upper electrode UE2 may be formed of the third conductive layer C3.

The second upper electrode UE2 may be electrically connected with the second bottom metal layer BML2 through a contact hole that successively passes through the buffer layer BFL, the gate insulating layer GI, and the interlayer insulating layer ILD. Furthermore, the second upper electrode UE2 may be electrically connected to the third source area SE3 through a contact hole that successively passes through the gate insulating layer GI and the interlayer insulating layer ILD. The first source area SE1, the third source area SE3, the second bottom metal layer BML2, and the second upper electrode UE2 may be electrically connected to each other.

The third pixel circuit SPXC3 may include a first transistor T1, a second transistor T2, a third transistor T3, and a third storage capacitor Cst3.

The first transistor T1 may include a first gate electrode GE1, a first active pattern ACT1, a first source area SE1, and a first drain area DE1.

The first gate electrode GE1 may be electrically connected to a second source area SE2 of the second transistor T2.

The first active pattern ACT1 may be a channel area of the first transistor T1.

The first source area SE1 may be connected to the first active pattern ACT1. Furthermore, the first source area SE1 may be electrically connected to a third bottom metal layer BML3 through a contact hole that passes through the buffer layer BFL.

The third bottom metal layer BML3 may be formed of the first conductive layer C1. The third bottom metal layer BML3 may be electrically connected to the first source area SE1 through a contact hole. In addition, the third bottom metal layer BML3 may be electrically connected to the third upper electrode UE3 through another contact hole that successively passes through the buffer layer BFL, the gate insulating layer GI, and the interlayer insulating layer ILD.

The first drain area DE1 may be connected to the first active pattern ACT1. Furthermore, the first drain area DE1 may be electrically connected to the fifth conductive pattern CP5 through a contact hole.

The fifth conductive pattern CP5 may be formed of the third conductive layer C3, and may overlap another area of the first vertical power line PL1a in a plan view. The fifth conductive pattern CP5 may be electrically connected to the first drain area DE1 through a contact hole that successively passes through the interlayer insulating layer ILD and the gate insulating layer GI. Furthermore, the fifth conductive pattern CP5 may be electrically connected with the first vertical power line PL1a through another contact hole that successively passes through the interlayer insulating layer ILD, the gate insulating layer GI, and the buffer layer BFL. Furthermore, the fifth conductive pattern CP5 may be electrically connected with a second additional conductive pattern ACP2 through another contact hole passing through the interlayer insulating layer ILD.

The second additional conductive pattern ACP2 may be formed of the second conductive layer C2, and may overlap another area of the first vertical power line PL1a. The second additional conductive pattern ACP2 may be electrically connected with the first vertical power line PL1a through a contact hole.

In one or more embodiments, the first vertical power line PL1a may be electrically connected, through a corresponding contact hole, to the second additional conductive pattern ACP2 and the fifth conductive pattern CP5 that are disposed on different layers, so that a multi-layer structure may be implemented, whereby line resistance may be reduced, and signal distortion may be reduced.

The second transistor T2 may include a second gate electrode GE2, a second active pattern ACT2, a second source area SE2, and a second drain area DE2.

The second gate electrode GE2 may be integrally provided with the first connection line CNL1, and may be electrically connected with the first scan line S1. The second gate electrode GE2 may be formed of the second conductive layer C2.

The second active pattern ACT2 may be a channel area of the second transistor T2.

The second source area SE2 may be connected to the second active pattern ACT2. Furthermore, the second source area SE2 may be coupled to the first gate electrode GE1 through the seventh conductive pattern CP7.

The seventh conductive pattern CP7 may be formed of the third conductive layer C3. A first end of the seventh conductive pattern CP7 may be electrically connected to the second source area SE2 through a contact hole that successively passes through the gate insulating layer GI and the interlayer insulating layer ILD. A second end of the seventh conductive pattern CP7 may be electrically connected to the first gate electrode GE1 through a contact hole that passes through the interlayer insulating layer ILD.

The second drain area DE2 may be connected to the second active pattern ACT2. Furthermore, the second drain area DE2 may be electrically connected to the second data line D2 by the sixth conductive pattern CP6.

The sixth conductive pattern CP6 may be formed of the third conductive layer C3. A first end of the sixth conductive pattern CP6 may be electrically connected with the second data line D2 through a contact hole that successively passes through the buffer layer BFL, the gate insulating layer GI, and the interlayer insulating layer ILD. A second end of the sixth conductive pattern CP6 may be electrically connected to the second drain area DE2 through a contact hole that successively passes through the gate insulating layer GI and the interlayer insulating layer ILD.

The third transistor T3 may include a third gate electrode GE3, a third active pattern ACT3, a third source area SE3, and a third drain area DE3.

The third gate electrode GE3 may be integrally provided with the second connection line CNL2, and may be electrically connected with the second scan line S2. The third gate electrode GE3 may be formed of the second conductive layer C2.

The third active pattern ACT3 may be a channel area of the third transistor T3.

The third source area SE3 may be connected to (brought into contact with) a first end of the third active pattern ACT3. The third source area SE3 may be electrically connected with the third upper electrode UE3 of the third storage capacitor Cst3 through a contact hole.

The third drain area DE3 may be connected to (or brought into contact with) a second end of the third active pattern ACT3. The third drain area DE3 may be electrically connected to the initialization power line IPL by the third conductive pattern CP3.

The third storage capacitor Cst3 may include a third lower electrode LE3 and a third upper electrode UE3.

The third lower electrode LE3 may be integrally provided with the first gate electrode GE1. In this case, the third lower electrode LE3 may be one area of the first gate electrode GE1. The third lower electrode LE3 may be formed of the second conductive layer C2.

The third upper electrode UE3 may be disposed to overlap with the third lower electrode LE3 in a plan view, and have a size (or a surface area) greater than that of the third lower electrode LE3, but embodiments of the present disclosure are not limited thereto. In a plan view, the third upper electrode UE3 may overlap each of the first source area SE1 and the third source area SE3. The third upper electrode UE3 may be formed of the third conductive layer C3.

The third upper electrode UE3 may be electrically connected with the third bottom metal layer BML3 through a contact hole that successively passes through the buffer layer BFL, the gate insulating layer GI, and the interlayer insulating layer ILD. Furthermore, the third upper electrode UE3 may be electrically connected to the third source area SE3 through a contact hole that successively passes through the gate insulating layer GI and the interlayer insulating layer ILD. The first source area SE1, the third source area SE3, the third bottom metal layer BML3, and the third upper electrode UE3 may be electrically connected to each other.

In one or more embodiments, the third upper electrode UE3 may be electrically connected with a third connection line CNL3 through another contact hole that successively passes through the buffer layer BFL, the gate insulating layer GI, and the interlayer insulating layer ILD.

The third connection line CNL3 may extend in the second direction DR2, and may be formed of a first conductive layer C1. The third connection line CNL3 may be electrically connected with the third upper electrode UE3 through a contact hole CH. In addition, the third connection line CNL3 may be electrically connected to the third contact electrode CNE3 through another contact hole that successively passes through the buffer layer BFL, the gate insulating layer GI, and the interlayer insulating layer ILD.

The first, second, and third pixel circuits SPXC1, SPXC2, and SPXC3 may be covered with the passivation layer PSV and the via layer VIA. The passivation layer PSV and the via layer VIA may include a plurality of via holes located in the pixel area PXA in which each pixel PXL is disposed. For example, the passivation layer PSV and the via layer VIA may include a first via hole VIH1 and a second via hole VIH2.

The first via hole VIH1 may be located in each of the first, second, and third pixel circuit areas SPXCA1, SPXCA2, and SPXCA3, and may expose one area of the first vertical power line PL1a in the corresponding pixel circuit area PXCA. The first vertical power line PL1a may be electrically connected to an alignment electrode ALE of a corresponding emission component EMU through the first via hole VIH1. For example, the first vertical power line PL1a may be electrically connected to the first alignment electrode ALE1 described with reference to FIG. 8 through the first via hole VIH1.

The second via hole VIH2 may be located in each of the first, second, and third pixel circuit areas SPXCA1, SPXCA2, and SPXCA3, and may expose one area of the second horizontal power line PL2b in the corresponding pixel circuit area PXCA. The second horizontal power line PL2b may be electrically connected to an alignment electrode ALE of a corresponding emission component EMU through the second via hole VIH2. For example, the second horizontal power line PL2b may be electrically connected to the second alignment electrode ALE2 described with reference to FIG. 8 through the second via hole VIH2.

The pixel circuit PXC may be electrically connected to the emission component EMU of the corresponding pixel PXL through the contactor CNT.

The first pixel circuit SPXC1 may be electrically connected to the corresponding emission component EMU through the first contactor CNT1. For example, the first pixel circuit SPXC1 may be electrically connected to the first emission component EMU1 described with reference to FIG. 8 through the first contactor CNT1. The first emission component EMU1 may be electrically connected to the first contact electrode CNE1 through the first contactor CNT1, and may be electrically connected to the first upper electrode UE1 of the first storage capacitor Cst1 by the first contact electrode CNE1. For example, the first electrode (refer to "ELT1" of FIG. 8 or the first pixel electrode) of the first emission component EMU1 may be electrically connected to the first contact electrode CNE1 through the first contactor CNT1.

The second pixel circuit SPXC2 may be electrically connected to the corresponding emission component EMU through the second contactor CNT2. For example, the second pixel circuit SPXC2 may be electrically connected to the second emission component EMU2 described with reference to FIG. 8 through the second contactor CNT2. The second emission component EMU2 may be electrically connected to the second contact electrode CNE2 through the second contactor CNT2, and may be electrically connected to the second upper electrode UE2 of the second storage capacitor Cst2 by the second contact electrode CNE2. For example, the first electrode ELT1 (or the first pixel electrode) of the second emission component EMU2 may be electrically connected to the second contact electrode CNE2, as illustrated in FIG. 23.

The third pixel circuit SPXC3 may be electrically connected to the corresponding emission component EMU through the third contactor CNT3. For example, the third pixel circuit SPXC3 may be electrically connected to the third emission component EMU3 described with reference to FIG. 8 through the third contactor CNT3. The third emission component EMU3 may be electrically connected to the third contact electrode CNE3 through the third contactor CNT3, and may be electrically connected to the third connection line CNL3 through the third contact electrode CNE3. As described above, because the third connection line CNL3 is electrically connected to the third upper electrode UE3 of the third storage capacitor Cst3, the third emission component EMU3 may be electrically connected to the third upper electrode UE3.

In one or more embodiments, the first, second, and third contact electrodes CNE1, CNE2, and CNE3 each may be formed of the third conductive layer C3, and may be disposed on the interlayer insulating layer ILD. The first, second, and third contact electrodes CNE1, CNE2, and CNE3 each may have a multi-layer structure formed by successively or repeatedly stacking, e.g., titanium (Ti), copper (Cu), and/or indium tin oxide (ITO). In this case, because contact resistance attributable to an oxide layer (e.g., an aluminum oxide layer) may be improved, an issue of heat generation from the contactor CNT and a reduction in luminance of the display device DD (or the display panel DP) may be mitigated.

The first contact electrode CNE1 may overlap the first bottom metal layer BML1, in a plan view, and may be electrically connected to the first bottom metal layer BML1 through a contact hole that successively passes through the buffer layer BFL, the gate insulating layer GI, and the interlayer insulating layer ILD. As described above, because the first bottom metal layer BML1 is electrically connected to the first upper electrode UE1 of the first storage capacitor Cst1, the first contact electrode CNE1 and the first upper electrode UE1 may be electrically connected to each other.

The second contact electrode CNE2 may overlap the second bottom metal layer BML2, in a plan view, and may be electrically connected to the second bottom metal layer BML2 through a contact hole that successively passes through the buffer layer BFL, the gate insulating layer GI, and the interlayer insulating layer ILD. As described above, because the second bottom metal layer BML2 is electrically connected to the second upper electrode UE2 of the second storage capacitor Cst2, the second contact electrode CNE2 and the second upper electrode UE2 may be electrically connected to each other.

The third contact electrode CNE3 may overlap the third connection line CNL3, in a plan view, and may be electrically connected to the third connection line CNL3 through a contact hole that successively passes through the buffer layer BFL, the gate insulating layer GI, and the interlayer insulating layer ILD. As described above, because the third bottom metal layer BML3 is electrically connected to the third upper electrode UE3 of the third storage capacitor Cst3, the third contact electrode CNE3 and the third upper electrode UE3 may be electrically connected to each other.

The first, second, and third contactors CNT1, CNT2, and CNT3 may have a substantially similar or identical structure. Hereinafter, the second contactor CNT2 from among the first, second, and third contactors CNT1, CNT2, and CNT3 will be described as a representative example, and the description of the first and third contactors CNT1 and CNT3 will be simplified.

The second contact electrode CNE2 may be disposed on the interlayer insulating layer ILD, and the passivation layer PSV may be disposed on the second contact electrode CNE2. The passivation layer PSV may be partially open to include the second contactor CNT2 that exposes one area of the second contact electrode CNE2. The via layer VIA may be disposed on the passivation layer PSV. The via layer VIA may be partially open to expose one area of the second contact electrode CNE2 that is exposed through the second contactor CNT2 of the passivation layer PSV. The first insulating layer INS1 may be disposed on the via layer VIA. The first insulating layer INS1 may be partially open to expose one area of the second contact electrode CNE2. The second insulating layer INS2 may be disposed on the first insulating layer INS1. The second insulating layer INS2 may be partially open to expose one area of the second contact electrode CNE2.

The first electrode ELT1 may be disposed on the second insulating layer INS2. The first electrode ELT1 may directly contact the second contact electrode CNE2 exposed through the second contactor CNT2. In the case where the second contact electrode CNE2 of the second pixel circuit SPXC2 (or the pixel circuit layer PCL) formed of the third conductive layer C3 (or a source-drain conductive layer) directly contacts the first electrode ELT1 of the second emission component EMU2 (or the display element layer DPL) formed of the fifth conductive layer C5, the contact resistance may be reduced or minimized, so that a heat generation issue and a luminance reduction problem of the display device DD (or the display panel DP) may be mitigated.

As discussed, embodiments can provide display device comprising: a first sub-pixel, a second sub-pixel, and a third sub-pixel adjacent to each other, each of the first, second, and third sub-pixels including an emission area and a non-emission area, wherein each of the first, second, and third sub-pixels comprises: a first alignment electrode and a second alignment electrode spaced from each other; a first insulating layer on the first alignment electrode and the second alignment electrode; light emitting elements on the first insulating layer and disposed between the first alignment electrode and the second alignment electrode in the emission area; a second insulating layer on the first insulating layer and the light emitting elements; and a third insulating layer on the second insulating layer, wherein the second and the third insulating layers are not on at least one area of the first alignment electrode in at least the non-emission area.

The display may include a pixel circuit layer, a display element layer, and an optical layer that are placed on a substrate. The sub-pixels may form part of the display element layer.

The light emitting elements may have a small size ranging from the nano scale (or the nanometer scale) to the micro scale (the micrometer scale) and may be connected in parallel to light emitting elements disposed adjacent thereto.

First, second, and third pixel circuits may be disposed on the pixel circuit layer of each sub-pixel.

The pixel circuit layer may include, for example, a buffer layer, a gate insulating layer, an interlayer insulating layer, a passivation layer, and a via layer that are successively provided on the substrate.

The first insulating layer may be provided and/or formed on the overall surface of the pixel circuit layer. The first insulating layer may be formed of a single layer or multiple layers, and include various inorganic materials including silicon oxide (SiOx), silicon nitride (SiNx), silicon oxynitride (SiOxNy), aluminum nitride (AlNx), aluminum oxide (AlOx), zirconium oxide (ZrOx), hafnium oxide (HfOx), and titanium oxide (TiOx).

The second insulating layer may be provided and/or formed on the first insulating layer. The second insulating layer may include the same material as that of the first insulating layer, or may include one or more suitable (or selected) materials from among materials exemplified as the constituent material of the first insulating layer.

The third insulating layer may be provided and/or formed on the second insulating layer. The third insulating layer may include the same material as that of the first insulating layer, or may include one or more suitable (or selected) materials from among materials exemplified as the constituent material of the first insulating layer.

Each of the first, second, and third sub-pixels may further comprise: a contact electrode on a substrate; an interlayer insulating layer on the contact electrode, and comprising a contactor to expose the contact electrode; a passivation layer on the interlayer insulating layer and partially open to correspond to the contactor; the first and the second alignment electrodes on the passivation layer; and electrodes on the second insulating layer and electrically connected to the light emitting elements, wherein at least one of the electrodes is electrically connected to the contact electrode through the contactor. The first insulating layer may be partially open to expose one area of the contact electrode. The second insulating layer may be disposed on the first insulating layer. The second insulating layer may be partially open to expose one area of the first contact electrode.

The first insulating layer may be disposed on the first and second alignment electrodes.

The first insulating layer may be provided and/or formed on overall surfaces of the first and second alignment electrodes.

The first insulating layer may be partially open in at least the non-emission area so that components disposed thereunder may be exposed. For example, the first insulating layer may be partially open to include, in at least the non-emission area, openings each of which exposes one area of the first alignment electrode.

A bank may be disposed on the first insulating layer. The bank may be provided and/or formed on the first insulating layer in the non-emission area. The bank may enclose the first emission area of the first sub-pixel.

The light emitting elements may be disposed on the first insulating layer. The light emitting elements may be disposed on the first insulating layer between the alignment electrodes.

The second insulating layer may include an inorganic insulating layer including inorganic material, or an organic insulating layer. For example, the second insulating layer may include an inorganic insulating layer suitable for protecting the active layer of each of first, second, third, and fourth light emitting elements from external oxygen, water, or the like. The second insulating layer may be formed of an organic insulating layer including organic material, depending on design conditions and the like of the display device to which the light emitting elements are applied. The second insulating layer may be formed of a single layer or multiple layers.

The second insulating layer may be provided and/or formed on the first insulating layer in the non-emission area. The second insulating layer may be partially open in at least the non-emission area so that components disposed thereunder may be exposed. For example, the second insulating layer may be partially open to include a plurality of through holes corresponding to the openings of the first insulating layer.

Electrodes may be formed on the opposite ends of the light emitting elements, i.e., the first and second ends and, which are not covered with the second insulating layer.

The light emitting elements may comprise first, second, third, and fourth light emitting elements. A first electrode may be directly disposed on the first ends of the first light emitting elements, and may contact the first ends of the first light emitting elements. A second electrode may be directly disposed on the second ends of the first light emitting elements, and may contact the second ends of the first light emitting elements. Furthermore, the second electrode may be directly disposed on the first ends of the second light emitting elements, and may contact the first ends of the second light emitting elements. In other words, the second electrode may electrically connect the second ends of the first light emitting elements with the first ends of the second light emitting elements.

A third electrode may be directly disposed on the second ends of the second light emitting elements, and may contact the second ends of the second light emitting elements. Furthermore, the third electrode may be directly disposed on the first ends of the third light emitting elements, and may contact the first ends of the third light emitting elements. In other words, the third electrode may electrically connect the second ends of the second light emitting elements with the first ends of the third light emitting elements.

A fourth electrode may be directly disposed on the second ends of the third light emitting elements, and may contact the second ends of the third light emitting elements. Furthermore, the fourth connection electrode may be directly disposed on the first ends of the fourth light emitting elements, and may contact the first ends of the fourth light emitting elements. In other words, the fourth electrode may electrically connect the second ends of the third light emitting elements with the first ends of the fourth light emitting elements.

A fifth electrode may be directly disposed on the second ends of the fourth light emitting elements, and may contact the second ends of the fourth light emitting elements and thus may be electrically connected to the second ends of the fourth light emitting elements.

The first electrode, the third electrode, and/or the fifth electrode may be formed of a conductive layer disposed on the second insulating layer. The first electrode, the third electrode, and/or the fifth electrode may be concurrently (e.g., simultaneously) formed through the same process.

The second electrode and/or the fourth electrode may be formed of a conductive layer disposed on the third insulating layer. The second electrode and/or the fourth electrode may be concurrently (e.g., simultaneously) formed through the same process. The third insulating layer may be disposed on the first electrode, the third electrode, and/or the fifth electrode. The second electrode and/or the fourth connection electrode may be disposed on the third insulating layer.

The third insulating layer may be disposed on the second insulating layer in the non-emission area. The third insulating layer may be partially open in at least the non-emission area so that components disposed thereunder may be exposed. For example, the third insulating layer may be partially open to include a plurality of contact holes corresponding to the openings of the first insulating layer and the through holes of the second insulating layer.

Embodiments may provide a display device comprising: a first sub-pixel, a second sub-pixel, and a third sub-pixel adjacent to each other, each of the first, second, and third sub-pixels including an emission area and a non-emission area; light emitting elements in the emission area of each of the first to the third sub-pixels; a first insulating layer under the light emitting elements; a bank on the first insulating layer in the non-emission area; a second insulating layer on the light emitting elements in at least the emission area, and including, in at least the non-emission area, through holes to expose one area of the bank; electrodes on the second insulating layer and electrically connected to the light emitting elements; sub-electrodes spaced from the electrodes; an intermediate electrode electrically connecting at least one of the sub-electrodes of the first sub-pixel with at least one of the sub-electrodes of the second sub-pixel; and a third insulating layer on the second insulating layer, and including, in at least the non-emission area, a first contact hole to expose one area of the intermediate electrode, and a second contact hole to expose at least one of the electrodes.

Embodiments may provide a method of repairing a display device, wherein the display device comprises a first sub-pixel, a second sub-pixel, and a third sub-pixel adjacent to each other, each of the first to third sub-pixels including an emission area and a non-emission area, wherein each of the first, second, and third sub-pixels comprises: a first alignment electrode and a second alignment electrode spaced from each other; a first insulating layer on the first and second alignment electrodes in at least the emission area, and including, in at least the non-emission area, a plurality of openings to expose one area of the first alignment electrode; light emitting elements on the first insulating layer on the first alignment electrode and the second alignment electrode in the emission area; a second insulating layer on the first insulating layer and the light emitting elements, and including a through hole corresponding to each of the openings in at least the non-emission area; and a third insulating layer on the second insulating layer, and including a contact hole corresponding to the through hole in the at least non-emission area, and wherein one area of the first alignment electrode is exposed to an outside in at least the non-emission area, the method comprising separating one area of the first alignment electrode that is exposed to the outside into parts.

In a display device and a method of repairing the display device in accordance with one or more embodiments, even if a bright spot defect occurs in a sub-pixel (or a pixel), the bright spot defect may be easily repaired, so that the reliability of the display device may be improved.

Furthermore, in one or more embodiments, a contact electrode of a pixel circuit layer and a pixel electrode of a display element layer may be directly connected to each other through a contactor, so that an electrode separation area for separating alignment lines provided in common in adjacent pixels may be omitted. Hence, the surface area of an emission area of each sub-pixel may be increased.

The effects, aspects, and features of embodiments of the present disclosure are not limited by the foregoing, and other various effects, aspects, and features are anticipated herein.

While various embodiments have been described above, those skilled in the art will appreciate that various modifications, additions, and substitutions are possible, without departing from the scope of the present disclosure.

Therefore, the embodiments disclosed in this specification are only for illustrative purposes rather than limiting the technical scope of the present disclosure. The scope of the present disclosure may be defined by the accompanying claims and their equivalents.

## Claims

1. A display device comprising:
a first sub-pixel, a second sub-pixel, and a third sub-pixel adjacent to each other, each of the first, second, and third sub-pixels including an emission area and a non-emission area,
wherein each of the first, second, and third sub-pixels comprises:
a first alignment electrode and a second alignment electrode spaced from each other;
a first insulating layer on the first alignment electrode and the second alignment electrode;
light emitting elements on the first insulating layer and disposed between the first alignment electrode and the second alignment electrode in the emission area;
a second insulating layer on the first insulating layer and the light emitting elements; and
a third insulating layer on the second insulating layer,
wherein the second and the third insulating layers are not on at least one area of the first alignment electrode in at least the non-emission area.

2. The display device according to claim 1,
wherein the first insulating layer includes, in at least the non-emission area, a plurality of openings, each of the plurality of openings exposing one area of the first alignment electrode,
wherein the second insulating layer includes a through hole corresponding to each of the plurality of openings in at least the non-emission area, and
wherein the third insulating layer includes a contact hole corresponding to the through hole in at least the non-emission area.

3. The display device according to claim 2,
wherein the first alignment electrode is configured to receive a voltage of a first power supply,
wherein the second alignment electrode is configured to receive a voltage of a second power supply, and
wherein the first power supply is a high-potential driving power supply, and the second power supply is a low-potential driving power supply.

4. The display device according to claim 3,
wherein each of the first, second, and third sub-pixels further comprises:
a contact electrode on a substrate;
an interlayer insulating layer on the contact electrode, and comprising a contactor to expose the contact electrode;
a passivation layer on the interlayer insulating layer and partially open to correspond to the contactor;
the first and the second alignment electrodes on the passivation layer; and
electrodes on the second insulating layer and electrically connected to the light emitting elements,
wherein at least one of the electrodes is electrically connected to the contact electrode through the contactor.

5. The display device according to claim 4,
wherein the electrodes comprise a first electrode, a second electrode, a third electrode, a fourth electrode, and a fifth electrode that are spaced from each other, and
wherein the first electrode is electrically connected to the contact electrode through the contactor, and the fifth electrode is electrically connected to the second alignment electrode.

6. The display device according to claim 5,
wherein each of the first, second, and third sub-pixels comprises:
a first sub-electrode at a layer identical to the second electrode and electrically connected to the second electrode;
a second sub-electrode at a layer identical to the third electrode and electrically connected to the third electrode;
a third sub-electrode at a layer identical to the fourth electrode and electrically connected to the fourth electrode; and
a fourth sub-electrode at a layer identical to the fifth electrode and electrically connected to the fifth electrode,
wherein one of the first, second, third, and fourth sub-electrodes of the first sub-pixel is electrically connected to one of the first, second, third, and fourth sub-electrodes of the second sub-pixel.

7. The display device according to claim 6, further comprising a bridge line in the non-emission area, and electrically connected to the fifth electrode of each of the first, second, and third sub-pixels,
wherein the bridge line is at a layer identical to the first, third, and fifth electrodes of each of the first, second, the third sub-pixels, and
wherein the second and fourth electrodes of each of the first, the second, and the third sub-pixels are on the bridge line.

8. The display device according to claim 7, wherein a portion of the bridge line is directly on one area of the first alignment electrode that is exposed through at least one opening from among the plurality of openings;
optionally wherein a dummy pattern is on a portion of the bridge line;
further optionally wherein the dummy pattern is at a layer that is identical to the second and fourth electrodes of each of the first, second, and third sub-pixels.

9. The display device according to any one of claims 6 to 8, further comprising a bank in the non-emission area of each of the first to the third sub-pixels,
wherein the first, second, third, and fourth sub-electrodes overlap the bank;
optionally further comprising an intermediate electrode electrically connecting the fourth sub-electrode of the first sub-pixel with the fourth sub-electrode of the second sub-pixel, wherein the intermediate electrode is integrally formed with the fourth sub-electrode of the first sub-pixel and the fourth sub-electrode of the second sub-pixel.

10. The display device according to any one of claims 3 to 9,
wherein each of the first, second, and third sub-pixels further comprises:
an interlayer insulating layer on the substrate;
a contact electrode on the interlayer insulating layer;
a passivation layer on the contact electrode, and including a contactor to expose the contact electrode;
the first and the second alignment electrodes on the passivation layer; and
electrodes on the second insulating layer and electrically connected to the light emitting elements, and
wherein at least one of the electrodes is electrically connected to the contact electrode through the contactor.

11. The display device according to any one of claims 1 to 10, further comprising:
a first color conversion layer in the first sub-pixel, and a first color filter on the first color conversion layer;
a second color conversion layer in the second sub-pixel, and a second color filter on the second color conversion layer; and
a light scattering layer in the third sub-pixel and a third color filter on the light scattering layer.

12. A display device comprising:
a first sub-pixel, a second sub-pixel, and a third sub-pixel adjacent to each other, each of the first, second, and third sub-pixels including an emission area and a non-emission area;
light emitting elements in the emission area of each of the first to the third sub-pixels;
a first insulating layer under the light emitting elements;
a bank on the first insulating layer in the non-emission area;
a second insulating layer on the light emitting elements in at least the emission area, and including, in at least the non-emission area, through holes to expose one area of the bank;
electrodes on the second insulating layer and electrically connected to the light emitting elements;
sub-electrodes spaced from the electrodes;
an intermediate electrode electrically connecting at least one of the sub-electrodes of the first sub-pixel with at least one of the sub-electrodes of the second sub-pixel; and
a third insulating layer on the second insulating layer, and including, in at least the non-emission area, a first contact hole to expose one area of the intermediate electrode, and a second contact hole to expose at least one of the electrodes.

13. The display device according to claim 12,
wherein the through holes of the second insulating layer includes a first through hole corresponding to the first contact hole, and a second through hole corresponding to the second contact hole, and
wherein one area of the intermediate electrode is exposed to an outside through the first contact hole and the first through hole, and at least one of the electrodes is exposed to the outside through the second contact hole and the second through hole.

14. The display device according to claim 13, further comprising:
a first dummy pattern directly on the one area of the intermediate electrode that is exposed to the outside, and covering the one area of the intermediate electrode; and
a second dummy pattern directly on the at least one of the electrodes that is exposed to the outside, and covering the at least one of the electrodes;
optionally wherein the electrodes comprise a first electrode, a second electrode, a third electrode, a fourth electrode, and a fifth electrode that are spaced from each other, and wherein the first electrode comprises an anode electrode of each of the first, second, and third sub-pixels, and the fifth electrode comprises a cathode electrode of each of the first, second, and third sub-pixels, and wherein the at least one of the electrodes comprises the fifth electrode;
further optionally wherein the second and fourth electrodes are on the first, third, and fifth electrodes with the third insulating layer interposed between the second and fourth electrodes, wherein the intermediate electrode is at a layer identical to the first, third, and fifth electrodes, and wherein the first and second dummy patterns are at a layer identical to the second and fourth electrodes.

15. A method of repairing a display device,
wherein the display device comprises a first sub-pixel, a second sub-pixel, and a third sub-pixel adjacent to each other, each of the first to third sub-pixels including an emission area and a non-emission area,
wherein each of the first, second, and third sub-pixels comprises:
a first alignment electrode and a second alignment electrode spaced from each other;
a first insulating layer on the first and second alignment electrodes in at least the emission area, and including, in at least the non-emission area, a plurality of openings to expose one area of the first alignment electrode;
light emitting elements on the first insulating layer on the first alignment electrode and the second alignment electrode in the emission area;
a second insulating layer on the first insulating layer and the light emitting elements, and including a through hole corresponding to each of the openings in at least the non-emission area; and
a third insulating layer on the second insulating layer, and including a contact hole corresponding to the through hole in the at least non-emission area, and
wherein one area of the first alignment electrode is exposed to an outside in at least the non-emission area,
the method comprising separating one area of the first alignment electrode that is exposed to the outside into parts.
